# EUROPEAN PATENT APPLICATION

(11) **EP 4 429 432 A1**
(43) Date of publication of application: **11.09.2024**
(21) Application number: 23213538.4
(22) Date of filing: 30.11.2023
(51) Int. Cl.: H10B 12/00

(54) **SEMICONDUCTOR DEVICE AND METHOD OF FABRICATING THE SAME**

(30) Priority: 06.03.2023 KR 20230029420
(71) Applicant: Samsung Electronics Co., Ltd., Suwon-si, Gyeonggi-do 16677 (KR)
(72) Inventor: KIM, Jongmin, 16677 Suwon-si (KR); LEE, Kiseok, 16677 Suwon-si (KR); KO, Seung-Bo, 16677 Suwon-si (KR); YOON, Chan-sic, 16677 Suwon-si (KR); LEE, Myeong-Dong, 16677 Suwon-si (KR)
(74) Representative: Marks & Clerk LLP

(57) **Abstract**

A semiconductor device including a first active pattern and a second active pattern each extending along a first direction and arranged along a second direction intersecting the first direction each of the first and second active patterns including a central part, a first edge part, and a second edge part, a storage node pad on the first edge part of the first active pattern, and a bit-line node contact on the central part of the first active pattern, wherein a top surface of the bit-line node contact is located at a higher level than a top surface of the storage node pad may be provided.

## Description

### BACKGROUND

The present inventive concepts relate to a semiconductor, and more particularly, to semiconductor devices and/or methods of fabricating the same.

Semiconductor devices have an important role in the electronic industry because of their small size, multi-functionality, and/or low fabrication cost. Semiconductor devices may be categorized as any one of semiconductor memory devices storing logic data, semiconductor logic devices performing processing operations on logic data, and hybrid semiconductor devices having both memory and logic elements.

Recently, high speed and low consumption of electronic products require that semiconductor devices embedded in the electronic products should have high operating speed and/or lower operating voltage. For satisfying the above demands, semiconductor devices have been more highly integrated. Therefore, various researches have been conducted for enhancing reliability of semiconductor devices.

### SUMMARY

Some example embodiments of the present inventive concepts provide semiconductor devices that are easy to fabricate and have an improved degree of integration and/or methods of fabricating the same.

Some example embodiments of the present inventive concepts provide semiconductor devices with improved electrical properties and increased reliability and/or methods of fabricating the same.

Example embodiments of the present inventive concepts are not limited to the example embodiments described herein, and other example embodiments, which have not been mentioned in this disclosure, will be clearly understood to those skilled in the art based on the following description.

According to an example embodiment of the present inventive concepts, a semiconductor device includes a first active pattern and a second active pattern each extending along a first direction, the first active pattern and the second active pattern arranged along a second direction intersecting the first direction (e.g. wherein the second direction is different to the first direction), each of the first and second active patterns including a central part, a first edge part, and a second edge part, the first and second edge parts being spaced apart from each other across the central part, a storage node pad on the first edge part of the first active pattern, and a bit-line node contact on the central part of the first active pattern, wherein a top surface of the bit-line node contact is at a higher level than a top surface of the storage node pad.

According to an example embodiment of the present inventive concepts, a semiconductor device includes a first active pattern and a second active pattern each extending along a first direction, the first active pattern and the second active pattern arranged along a second direction that intersects the first direction (e.g. wherein the second direction is different to the first direction), each of the first and second active patterns including a central part, a first edge part, and a second edge part, the first and second edge parts being spaced apart from each other across the central part, a storage node pad on the first edge part of the first active pattern, a storage node contact on the storage node pad and vertically overlapping a portion of the storage node pad, and a bit-line node contact on the central part of the first active pattern, wherein a bottom surface of the storage node contact is at a lower level than a top surface of the bit-line node contact.

According to an example embodiment of the present inventive concepts, a semiconductor device includes a first active pattern and a second active pattern each extending along a first direction, the first active pattern and the second active pattern arranged along a second direction that intersects the first direction (e.g. wherein the second direction is different to the first direction), each of the first and second active patterns including a central part, a first edge part, and a second edge part, the first and second edge parts being spaced apart from each other across the central part, a pair of word lines running across the first active pattern and the second active pattern along the second direction, a storage node pad on the first edge part of the first active pattern, a storage node contact on the storage node pad and vertically overlapping a portion of the storage node pad, a first bit line extending along a third direction on the central part of the first active pattern, the third direction intersecting the first and second directions (e.g. wherein the third direction is different to the first and second directions), a bit-line node contact between the first bit line and the central part of the first active pattern, a landing pad on the storage node contact, and a data storage pattern on the landing pad, wherein a top surface of the bit-line node contact is at a higher level than a top surface of the storage node pad.

At least some of the above and other features of the invention are set out in the claims.

### BRIEF DESCRIPTION OF DRAWINGS

FIG. 1 illustrates a plan view showing a semiconductor device according to an example embodiment of the present inventive concepts.
FIG. 2 illustrates an enlarged view showing a portion of components in FIG. 1.
FIGS. 3A, 3B, 3C, and 3D illustrate cross-sectional views taken along lines A-A', B-B', C-C', and D-D' of FIG. 1, respectively, , according to an example embodiment.
FIG. 4 illustrates a cross-sectional view taken along line D-D' of FIG. 1, according to an example embodiment.
FIG. 5 illustrates a cross-sectional view taken along line D-D' of FIG. 1, according to an example embodiment.
FIGS. 6A and 6B illustrate cross-sectional views taken along lines C-C' and D-D' of FIG. 1, respectively, according to an example embodiment.
FIGS. 7A, 7B, 7C, and 7D illustrate cross-sectional views taken along lines A-A', B-B', C-C', and D-D' of FIG. 1, respectively, according to an example embodiment.
FIGS. 8A and 8B illustrate cross-sectional views taken along lines B-B' and C-C' of FIG. 1, respectively, according to an example embodiment.
FIGS. 9, 10A to 10D, 11, 12A to 12D, 13, 14A to 14D, 15, 16A to 16D, 17, and 18A to 18D illustrate diagrams showing a method of fabricating a semiconductor device discussed with reference to FIGS. 1, 2 and 3A to 3D, according to an example embodiment.
FIG. 19 illustrates a diagram showing a method of fabricating a semiconductor device discussed with reference to FIG. 4, according to an example embodiment.
FIGS. 20, 21A to 21D, 22, and 23A to 23D illustrate diagrams showing a method of fabricating a semiconductor device discussed with reference to FIGS. 1, 2 and 3A to 3D, according to an example embodiment.
FIGS. 24 and 25A to 25D illustrate diagrams showing a method of fabricating a semiconductor device discussed with reference to FIGS. 1, 2 and 3A to 3D, according to an example embodiment.
FIGS. 26, 27A to 27D, 28, 29A to 29D, 30, 31A to 31D, 32 and 33A to 33D illustrate diagrams showing a method of fabricating a semiconductor device discussed with reference to FIG. 5, according to an example embodiment.
FIGS. 34, 35A to 35D, 36, and 37A to 37D illustrate diagrams showing a method of fabricating a semiconductor device discussed with reference to FIGS. 6A and 6B, according to an example embodiment.
FIGS. 38, 39A to 39D, 40, 41A to 41D, 42 and 43A to 43D illustrate diagrams showing a method of fabricating a semiconductor device discussed with reference to FIGS. 7A to 7D or FIGS. 8A and 8B, according to an example embodiment.

### DETAILED DESCRIPTION OF EMBODIMENTS

Some example embodiments of the present inventive concepts will now be described in detail with reference to the accompanying drawings to aid in clearly explaining the present inventive concepts.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the terms "about" or "substantially" are used in this specification in connection with a numerical value, it is intended that the associated numerical value includes a manufacturing or operational tolerance (e.g., ±10%) around the stated numerical value. Moreover, when the words "about" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

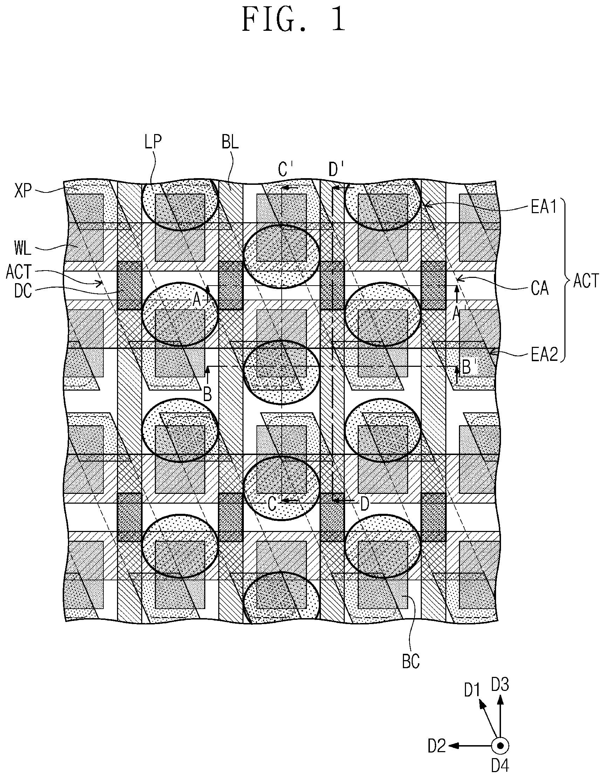

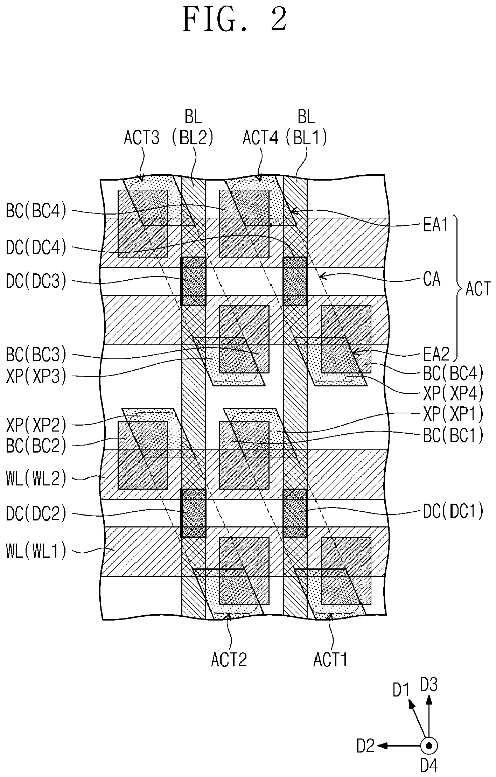

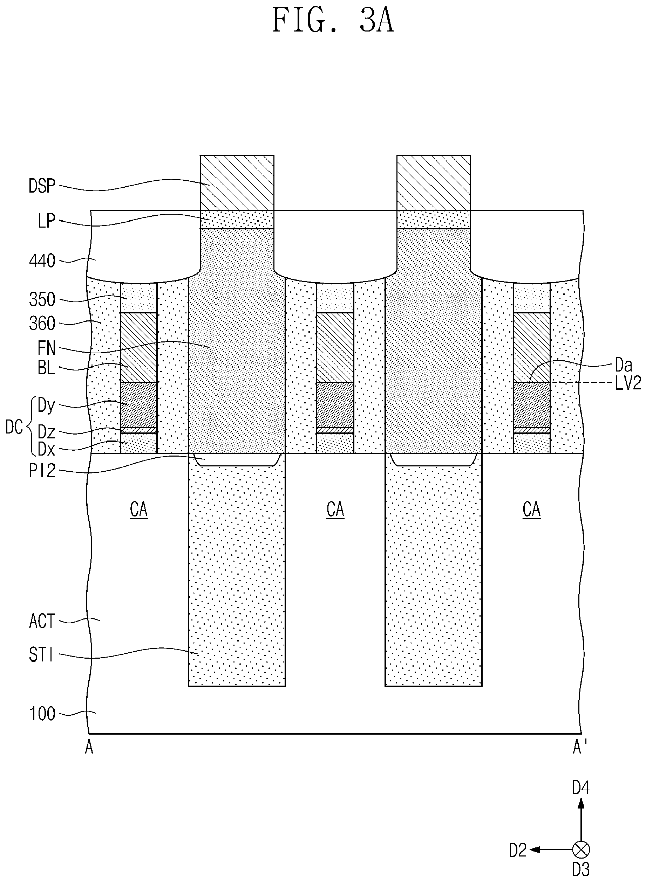

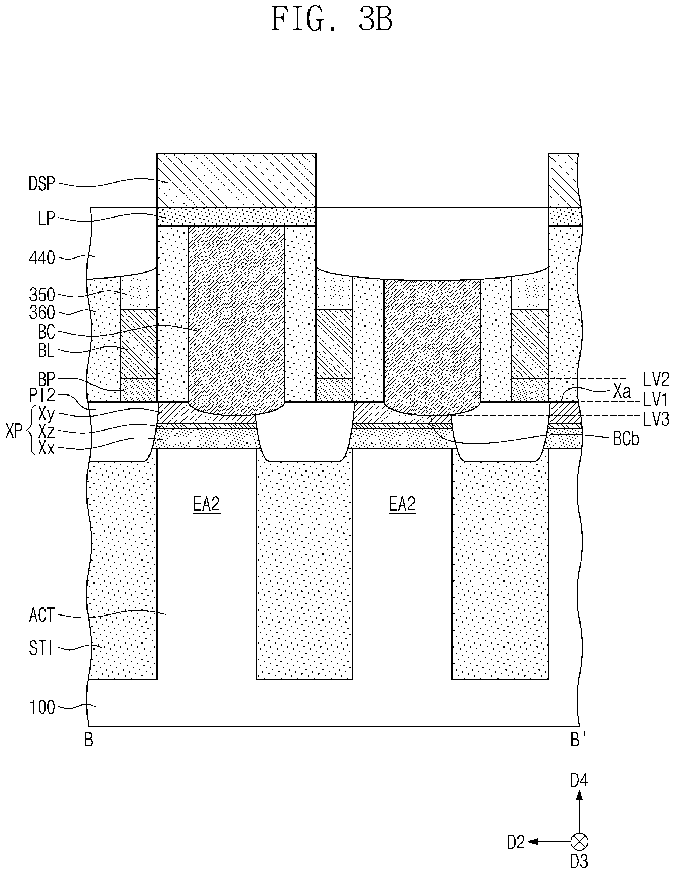

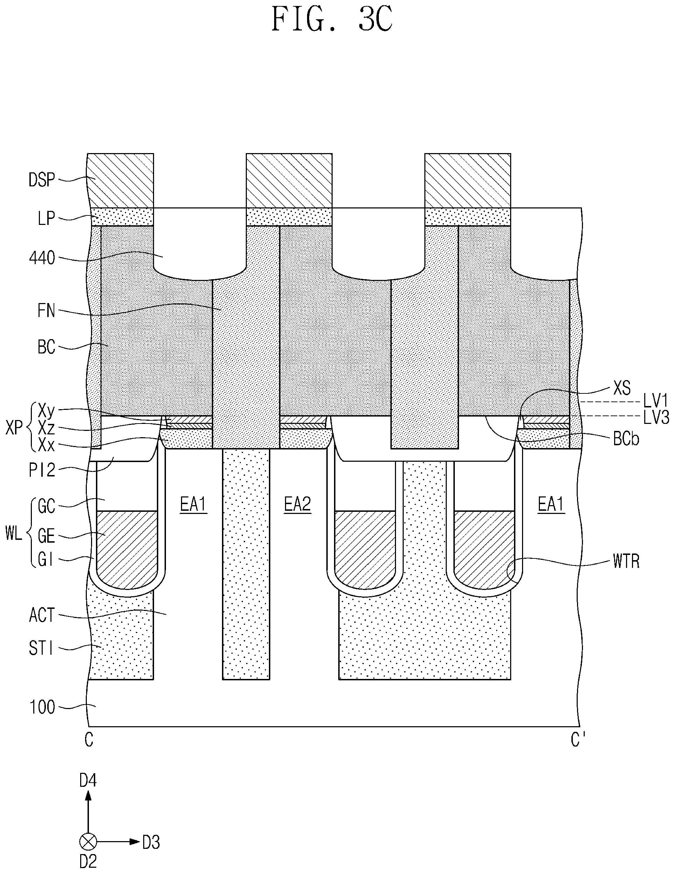

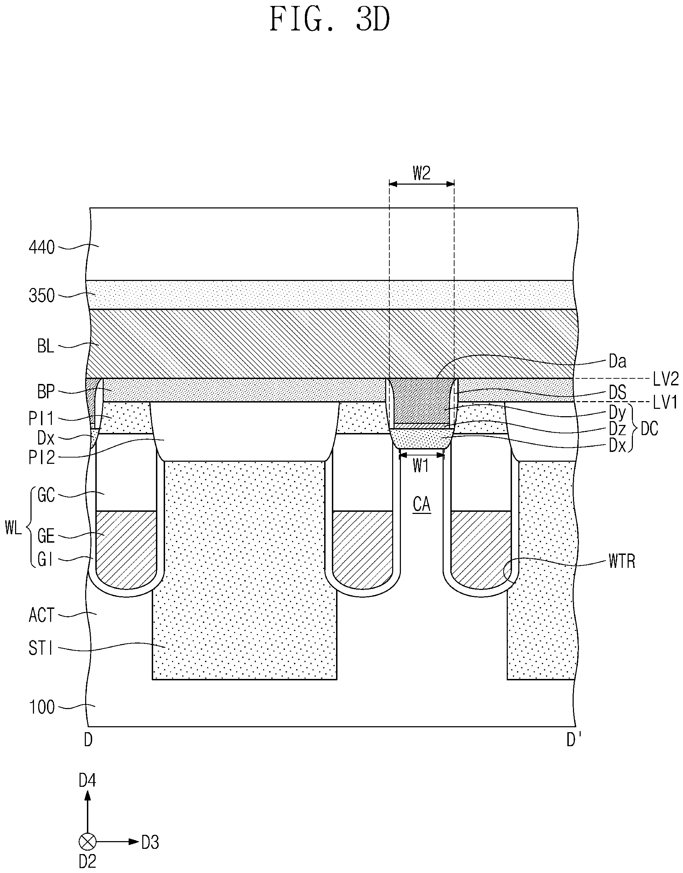

FIG. 1 illustrates a plan view showing a semiconductor device according to an example embodiment of the present inventive concepts. FIG. 2 illustrates an enlarged view showing a portion of components in FIG. 1. FIGS. 3A, 3B, 3C, and 3D illustrate cross-sectional views taken along lines A-A', B-B', C-C', and D-D' of FIG. 1, respectively, according to an example embodiment.

Referring to FIGS. 1, 2 and 3A to 3D, a substrate 100 may be provided. The substrate 100 may be a semiconductor substrate, for example, a silicon substrate, a germanium substrate, or a silicon-germanium substrate.

The substrate 100 may be provided therein with a device isolation pattern STI that defines an active pattern ACT. The active pattern ACT may be provided in plural. For example, the active patterns ACT may include portions of the substrate 100 that are surrounded by the device isolation pattern STI. For convenience of description, unless otherwise specifically stated in this disclosure, the active patterns ACT of the substrate 100 may refer to portions other than the portion of the substrate 100 that is occupied by the device isolation pattern STI.

Each of the active patterns ACT may have a shape that extends in a first direction D1 parallel to a bottom surface of the substrate 100. The active patterns ACT may be parallel to the bottom surface of the substrate 100 and may be spaced apart from each other in a second direction D2 and a third direction D3 that intersect each other (e.g. wherein the second and third directions D2 and D3 are different). The first, second, and third directions D1, D2, and D3 may intersect each other (e.g. the first, second and third directions D1, D2 and D3 may be different). The active patterns ACT may have a shape that protrudes in a fourth direction D4 perpendicular to the bottom surface of the substrate 100. For example, the active pattern ACT may include silicon, for example, monocrystalline silicon.

The active pattern ACT may include a first edge part EA1, a second edge part EA2 that is spaced in the first direction D1 from the first edge part EA1, and a central part CA between the first edge part EA1 and the second edge part EA2. The first edge part EA1 and the second edge part EA2 may be opposite ends in the first direction D1 of the active pattern ACT. The central part CA may be interposed between a pair of word lines WL that run across the active pattern ACT. The central parts CA of the active patterns ACT may be spaced apart from each other along the second and third directions D2 and D3. The first and second edge parts EA1 and EA2 and the central part CA may be provided therein with impurities (e.g., n-type or p-type impurities).

Neighboring active patterns ACT may be disposed side by side (or arranged) along the first direction D1 (or its reverse direction), the second direction D2 (or its reverse direction), or the third direction D3 (or its reverse direction). In this disclosure, the phrase "neighboring active patterns ACT are disposed side by side (or arranged) along a certain direction" may include "the central parts CA of neighboring active patterns ACT are disposed along the certain direction." For example, as shown in FIG. 2, a first active pattern ACT1, a second active pattern ACT2, a third active pattern ACT3, and a fourth active pattern ACT4 may be disposed along a clockwise direction. The first active pattern ACT 1 and its immediately neighboring second active pattern ACT2 may be disposed side by side (or arranged) along the second direction D2. The first active pattern ACT1 and its immediately neighboring third active pattern ACT3 may be disposed side by side (or arranged) along the first direction D1. In other words, the first active pattern ACT1 and its immediately neighboring third active pattern ACT3 may be co-linearly arranged along the first direction D1. The first active pattern ACT1 and its immediately neighboring fourth active pattern ACT4 may be disposed side by side (or arranged) along the third direction D3.

The first edge part EA1 of the first active pattern ACT1 and the first edge part EA1 of the second active pattern ACT2 may neighbor each other in the second direction D2. The first edge part EA1 of the first active pattern ACT1 and the second edge part EA2 of the second active pattern ACT2 may neighbor each other in the third direction D3. The first edge part EA1 of the first active pattern ACT1 and the second edge part EA2 of the third active pattern ACT3 may neighbor each other in the first direction D1.

According to some example embodiments of the present inventive concepts, the active patterns ACT may be disposed side by side (or arranged) along the first direction D1 (or its reverse direction), the second direction D2 (or its reverse direction), or the third direction D3 (or its reverse direction), and thus a semiconductor device may have a simplified arrangement of components therein. Accordingly, it may be possible to reduce difficulty of patterning for forming the semiconductor device and to easily fabricate the semiconductor device. In addition, components may be relatively simply disposed to increase integration of the semiconductor device.

The device isolation pattern STI may include a dielectric material, for example, at least one of silicon oxide and silicon nitride. The device isolation pattern STI may be a single layer formed of a single material or a composite layer including two or more materials. In this disclosure, each of the languages "at least one of A and B", "at least one of A or B", " "at least one of A, B, and C", and "at least one A, B, or C" may include one or any possible combination of elements listed in a corresponding expression.

A word line WL may run across the active patterns ACT and the device isolation pattern STI. The word line WL may be provided in plural. The word lines WL may extend along the second direction D2, and may be spaced apart from each other in the third direction D3. A pair of word lines WL that are spaced apart from each other in the third direction D3 may run across the active patterns ACT that neighbor each other in the second direction D2. For example, as shown in FIG. 2, a first word line WL1 and a second word line WL2 may be spaced apart from each other in the third direction D3, and may run across the first and second active patterns ACT1 and ACT 2 that neighbor each other in the second direction D2.

Each of the word lines WL may include a gate electrode GE, a gate dielectric pattern GI, and a gate capping pattern GC. The gate electrode GE may penetrate in the second direction D2 through the active patterns ACT and the device isolation pattern STI. The gate dielectric pattern GI may be interposed between the gate electrode GE and the active patterns ACT and between the gate electrode GE and the device isolation pattern STI. The gate electrode GE may be provided thereon with the gate capping pattern GC that covers a top surface thereof. The gate electrode GE may include a conductive material. The gate dielectric pattern GI may include at least one of silicon oxide and high-k dielectric materials. In this disclosure, the high-k dielectric material may be defined to indicate a material whose dielectric constant is greater than that of silicon oxide. The gate capping pattern GC may include silicon nitride.

Storage node pads XP may be provided on the first and second edge parts EA1 and EA2 of the active patterns ACT. For example, each of the storage node pads XP may be provided on a corresponding one of the first and second edge parts EA1 and EA2 of the active patterns ACT. The storage node pads XP may be spaced apart from each other in the first direction D1 and the second direction D2. Each of the storage node pads XP may be electrically connected to a corresponding one of the first and second edge parts EA1 and EA2.

As shown in FIG. 2, a first storage node pad XP1 may be connected to the first edge part EA1 of the first active pattern ACT1. A second storage node pad XP2 may be connected to the first edge part EA1 of the second active pattern ACT2. A third storage node pad XP3 may be connected to the second edge part EA2 of the third active pattern ACT3. A fourth storage node pad XP4 may be connected to the second edge part EA2 of the fourth active pattern ACT4. The first storage node pad XP1 and the second storage node pad XP2 may neighbor each other in the second direction D2. The third storage node pad XP3 and the fourth storage node pad XP4 may neighbor each other in the second direction D2. The first storage node pad XP1 and the third storage node pad XP3 may neighbor each other in the first direction D1.

When viewed in plan, the storage node pad XP may have a parallelogram shape. The storage node pad XP may have two sides that extend in the first direction D1 and face each other and another two sides that extend in the second direction D2 and face each other. The present inventive concepts, however, are not limited thereto, and even when a corner of the storage node pad XP is slightly rounded, it should be interpreted that the storage node pad XP has a parallelogram shape. Thus, in some example embodiments, the storage node pad XP may have two sides that extend in the first direction D1 and face each other and another two sides that extend in the second direction D2 and face each other, and further may have rounded corners.

The storage node pad XP may have a width that is changed in accordance with direction and level. For example, a width in the third direction D3 of the storage node pad XP may decrease as a level is lowered (see FIG. 3C). For another example, a width in the second direction D2 of the storage node pad XP may increase as a level is lowered (see FIG. 3B). The present inventive concepts, however, are not limited thereto.

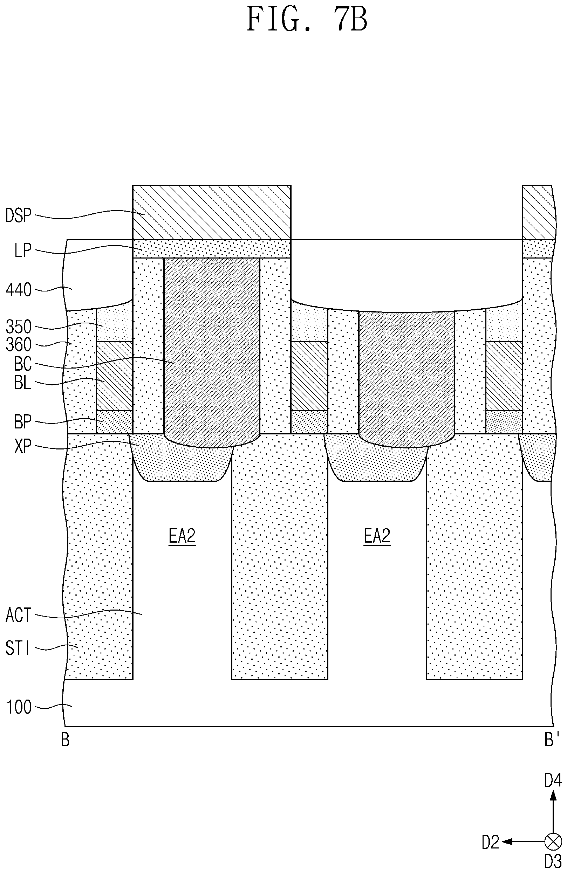

The storage node pad XP may include at least one of silicon (e.g., impurity doped polysilicon) and a metallic material (e.g., Ti, Mo, W, Cu, Al, Ta, Ru, or Ir). As shown in FIG. 3B, the storage node pad XP may be a composite layer including two or more materials, and may include a lower pad Xx and an upper pad Xy on the lower pad Xx. The lower pad Xx and the upper pad Xy may include different materials from each other. For example, the lower pad Xx may include silicon (e.g., impurity doped polysilicon), and the upper pad Xy may include a metallic material (e.g., Ti, Mo, W, Cu, Al, Ta, Ru, and Ir). The storage node pad XP may further include an ohmic pad Xz between the lower pad Xx and the upper pad Xy. The ohmic pad Xz may improve a contact resistance between the lower pad Xx and the upper pad Xy. As shown in FIG. 7B, which will be discussed below, the storage node pad XP may be a single layer formed of a single material.

As shown, for example in FIG. 3C, a pad spacer XS may be provided on a lateral surface of the storage node pad XP. The pad spacer XS may cover a lateral surface of the upper pad Xy of the storage node pad XP. A pair of pad spacers XS may cover lateral surfaces of the storage node pad XP that are arranged along the third direction D3 and its reverse direction. The pad spacer XS may include silicon nitride, but the present inventive concepts are not limited thereto.

Bit-line node contacts DC may be provided on the active patterns ACT. For example, the bit-line node contacts DC may be correspondingly provided on the central parts CA of the active patterns ACT. The bit-line node contact DC may be electrically connected to the central part CA of a corresponding one of the active patterns ACT. The bit-line node contacts DC may be spaced apart from each other in the second and third directions D2 and D3. The bit-line node contacts DC may be correspondingly interposed between the active patterns ACT and bit lines BL which will be discussed below. The bit-line node contacts DC may correspondingly electrically connect the bit lines BL to the central part CA of the active patterns ACT.

The bit-line node contact DC may include at least one of silicon (e.g., impurity doped polysilicon) and a metallic material (e.g., Ti, Mo, W, Cu, Al, Ta, Ru, or Ir). As shown in FIG. 3A, the bit-line node contact DC may be a composite layer including two or more materials, and may include a lower contact Dx and an upper contact Dy on the lower contact Dx. The lower and upper contacts Dx and Dy of the bit-line node contact DC may include different materials from each other. The lower contact Dx may include silicon (e.g., impurity doped polysilicon), and the upper contact Dy may include a metallic material (e.g., Ti, Mo, W, Cu, Al, Ta, Ru, and Ir). The bit-line node contact DC may further include an ohmic contact Dz between the lower contact Dx and the upper contact Dy. The ohmic contact Dz may improve a contact resistance between the lower contact Dx and the upper contact Dy. In some example embodiments, although not shown, the bit-line node contact DC may be a single layer formed of a single material. For example, as shown in FIG. 3D, when viewed in the third direction D3, a width W1 at a bottom surface of the lower contact Dx may be less than a width W2 at a top surface of the lower contact Dx, but the present inventive concepts are not limited thereto.

As shown in FIGS. 3B and 3D, the storage node pad XP may have a top surface Xa (e.g., uppermost surface) located at a first level LV1. The bit-line node contact DC may have a top surface Da (e.g., uppermost surface) located at a second level LV2. The second level LV2 may be higher than the first level LV1. In such case, the top surface Da of the bit-line node contact DC may be located at a higher level than that of the top surface Xa of the storage node pad XP. The storage node pad XP may have a bottom surface located at substantially the same level as a bottom surface of the bit-line node contact DC, but the present inventive concepts are not limited thereto.

A first pad dielectric pattern PI1 and a second pad dielectric pad PI2 may surround lateral surfaces of the storage node pads XP and lateral surfaces of the bit-line node contacts DC. The first pad dielectric pattern PI1 and the second pad dielectric pad PI2 may insulate the storage node pads XP from the bit-line node contacts DC. The first pad dielectric pattern PI1 and the second pad dielectric pad PI2 may insulate neighboring storage node pads XP from each other. The first pad dielectric pattern PI1 and the second pad dielectric pad PI2 may separate neighboring storage node pads XP from each other. The first pad dielectric pattern PI1 may further be provided between the device isolation pattern STI and a fence pattern FN which will be discussed below, but the present inventive concepts are not limited thereto. Each of the first pad dielectric pattern PI1 and the second pad dielectric pattern PI2 may include a dielectric material.

A bit line BL may be provided on the bit-line node contact DC. The bit line BL may extend along the third direction D3. The bit line BL may be provided in plural. The bit line BL may be spaced apart from each other in the second direction D2. The bit line BL may include a metallic material. For example, the bit line BL may include a metallic material, such as Ti, Mo, W, Cu, Al, Ta, Ru, or Ir. For another example, the bit line BL may further include metal silicide or metal nitride.

The bit line BL may be disposed on the central parts CA of a series of active patterns ACT that are disposed side by side (or arranged) along the third direction D3, and may be electrically connected through the bit-line node contacts DC to the series of active patterns ACT. As shown in FIG. 2, a first bit line BL1 may be disposed on and electrically connected to the central parts CA of the first active pattern ACT 1 and the fourth active pattern ACT4 that are disposed side by side (or arranged) along the third direction D3. A second bit line BL2 may be disposed on and electrically connected to the central parts CA of the second active pattern ACT2 and the third active pattern ACT3 that are disposed side by side (or arranged) along the third direction D3.

A buffer pattern BP may cover the substrate 100 below the bit line BL. The buffer pattern BP may be interposed between the bit line BL and the first pad dielectric pattern PI1 and between the bit line BL and the second pad dielectric pattern PI2. The buffer pattern BP may include at least one of silicon oxide, silicon nitride, silicon oxynitride, and high-k dielectric materials. The buffer pattern BP may be a single layer formed of a single material or a composite layer including two or more materials. The buffer pattern BP may be a composite layer including a lower buffer pattern and an upper buffer pattern.

The buffer pattern BP may be provided on a lateral surface of an upper portion of the bit-line node contact DC. For example, the buffer pattern BP may be provided on and cover a lateral surface of an upper portion of the upper contact Dy. A top surface of the buffer pattern BP may be located at a second level LV2 and coplanar with the top surface Da of the bit-line node contact DC. The buffer pattern BP may be interposed between the bit-line node contacts DC that neighbor each other in the third direction D3. The buffer pattern BP may be located at a higher level than that of the storage node pad XP.

As shown for example in FIG. 3D, a bit-line node spacer DS may be provided on the lateral surface of the bit-line node contact DC. The bit-line node spacer DS may cover a lateral surface of the upper contact Dy of the bit-line node contact DC. For example, a pair of bit-line node spacers DS may cover the lateral surfaces of the bit-line node contact DC that are provided in the third direction D3 and its reverse direction, respectively. The bit-line node spacer DS may be interposed between the bit-line node contact DC and the first pad dielectric pattern PI1 that is adjacent in the third direction D3 to the bit-line node contact DC. The bit-line node spacer DS may be interposed between the first pad dielectric pattern PI1 and the upper contact Dy of the bit-line node contact DC, and may extend between the upper contact Dy and the buffer pattern BP. The bit-line node spacer DS may be located at a higher level than that of the lower contact Dx of the bit-line node contact DC. The bit-line node spacer DS may include silicon nitride, but the present inventive concepts are not limited thereto.

A bit-line capping pattern 350 may be provided on a top surface of the bit line BL. The bit-line capping pattern 350 together with the bit line BL may extend along the third direction D3. The bit-line capping pattern 350 may be provided in plural. The plurality of bit-line capping patterns 350 may be spaced apart from each other in the second direction D2. The bit-line capping pattern 350 may vertically overlap the bit line BL. The bit-line capping pattern 350 may be formed of a single or multiple layer. For example, the bit-line capping pattern 350 may include a first capping pattern, a second capping pattern, and a third capping pattern that are sequentially stacked. Each of the first to third capping patterns may include silicon nitride. In some example embodiments, the bit-line capping pattern 350 may include four or more capping patterns that are stacked.

A bit-line spacer 360 may be provided on a lateral surface of the bit line BL and a lateral surface of the bit-line capping pattern 350. The bit-line spacer 360 may cover the lateral surface of the bit line BL and the lateral surface of the bit-line capping pattern 350. The bit-line spacer 360 may extend along the third direction D3 on the lateral surface of the bit line BL. The bit-line spacer 360 may include, for example, at least one of silicon oxide (SiO₂), silicon nitride (SiN), silicon carbonitride (SiOC), and silicon oxycarbonitride (SiOCN). The bit-line spacer 360 may further include an air gap therein. The bit-line spacer 360 may be a single layer formed of a single material or a composite layer including two or more materials. The bit-line spacer 360 may include a plurality of sub-spacers (not shown) that are sequentially provided on the lateral surface of the bit line BL.

A storage node contact BC may be provided between neighboring bit lines BL. For example, the storage node contact BC may be interposed between neighboring bit-line spacers 360. The storage node contact BC may be provided in plural. The plurality of storage node contacts BC may be spaced apart from each other in the second and third directions D2 and D3. Neighboring storage node contacts BC may be disposed along the second direction D2 or the third direction D3. The storage node contacts BC may be provided on the storage node pads XP. The storage node contacts BC may be electrically connected through the storage node pads XP to the first and second edge parts EA1 and EA2. For example, the storage node contact BC may include at least one of silicon (e.g., impurity doped polysilicon) and metallic materials (e.g., Ti, Mo, W, Cu, Al, Ta, Ru, or Ir).

The storage node contact BC may have a bottom surface BCb (e.g., lowermost surface) located at a third level LV3. The third level LV3 may be lower than the first level LV1 and the second level LV2. In such case, the bottom surface BCb of the storage node contact BC may be located at a lower level than that of the top surface Xa of the storage node pad XP and that of the top surface Da of the bit-line node contact DC.

As shown in FIG. 2, each of the storage node contacts BC may be electrically connected through a corresponding storage node pad XP to a corresponding one of the first and second edge parts EA1 and EA2. A first storage node contact BC1 may be connected through the first storage node pad XP1 to the first edge part EA1 of the first active pattern ACT1. A second storage node contact BC2 may be connected through the second storage node pad XP2 to the first edge part EA1 of the second active pattern ACT2. A third storage node contact BC3 may be connected through the third storage node pad XP3 to the second edge part EA2 of the third active pattern ACT3. A fourth storage node contact BC4 may be connected through the fourth storage node pad XP4 to the second edge part EA2 of the fourth active pattern ACT4. The first storage node contact BC1 and the third storage node contact BC3 may neighbor each other in the third direction D3.

As the storage node pads XP are provided, the storage node contact BC may be electrically connected to a corresponding one of the first and second edge parts EA1 and EA2. For example, although the storage node contact BC is misaligned and does not vertically overlap a corresponding edge part, the storage node contact BC may be electrically connected through the storage node pad XP to the corresponding edge part. For another example, when the storage node contact BC is in direct contact with and connected to the corresponding edge part, a misalignment may cause a reduction in contact area and an increase in contact resistance. In this case, as the storage node pad XP is provided, an increase in contact resistance may be mitigated or prevented between the storage node contact BC and the corresponding edge part. Thus, a semiconductor device may have improved electrical properties and increased reliability.

A fence pattern FN may be provided between neighboring bit lines BL and between the storage node contacts BC that neighbor each other in the third direction D3. The fence pattern FN may separate from each other the storage node contacts BC that neighbor each other in the third direction D3. The fence pattern FN may be provided in plural, and the plurality of fence patterns FN may be spaced apart from each other in the third direction D3. The fence pattern FN may include, for example, at least one of silicon oxide (SiO₂), silicon nitride (SiN), silicon carbonitride (SiOC), and silicon oxycarbonitride (SiOCN).

Although not shown, a closed spacer may surround the storage node contact BC. The closed spacer may surround a lateral surface of the storage node contact BC. The closed spacer may separate the storage node contact BC from the fence pattern FN and the bit-line spacer 360. The present inventive concepts, however, are not limited thereto, and the closed spacer may not be provided.

A landing pad LP may be disposed on the storage node contact BC. The landing pad LP may be provided in plural. The plurality of landing pads LP may be spaced apart from each other in the second and third directions D2 and D3. The landing pad LP may be electrically connected through a corresponding storage node contact BC and a corresponding storage node pad XP to a corresponding one of the first edge parts EA1 and the second edge parts EA2. For example, the landing pad LP may include at least one metallic material (e.g., Ti, Mo, W, Cu, Al, Ta, Ru, or Ir).

Each of the landing pads LP may be shifted in the third direction D3 (or its reverse direction) from a corresponding storage node contact BC. A portion of the landing pad LP may vertically overlap a corresponding storage node contact BC, and another portion of the landing pad LP may not vertically overlap the corresponding storage node contact BC. The landing pad LP may be located at a level the same as or higher than that of a top surface of the fence pattern FN.

Alternatively, although not shown, the landing pad LP may include a lower part and an upper part. The lower part of the landing pad LP may vertically overlap the storage node contact BC, and the upper part of the landing pad LP may vertically overlap a portion of the storage node contact BC. The lower part of the landing pad LP may be defined at a lower level than that of the top surface of the fence pattern FN. The upper part of the landing pad LP may be shifted in the third direction D3 (or its reverse direction) from the lower part of the landing pad LP.

A filling pattern 440 may surround the landing pad LP. The filling pattern 440 may be interposed between neighboring landing pads LP. When viewed in plan, the filling pattern 440 may have a mesh shape including holes, and the landing pads LP may fill the holes. The landing pads LP may penetrate the filling pattern 440. The filling pattern 440 may include, for example, at least one of silicon nitride, silicon oxide, silicon oxynitride, and a combination thereof. In some example embodiments, the filling pattern 440 may include an empty space (or air gap) including an air layer.

A data storage pattern DSP may be provided on the landing pad LP. The data storage pattern DSP may be provided in plural. The plurality of data storage patterns DSP may be spaced apart from each other in the second and third directions D2 and D3. Each of the data storage patterns DSP may be electrically connected through a corresponding landing pad LP, a corresponding storage node contact BC, and a corresponding storage node pad XP to one of a corresponding one of the first edge parts EA1 and the second edge parts EA2.

The data storage pattern DSP may be, for example, a capacitor including a bottom electrode, a dielectric layer, and a top electrode. In this case, a semiconductor memory device according to some example embodiments of the present inventive concepts may be a dynamic random access memory (DRAM). For another example, the data storage pattern DSP may include a magnetic tunnel junction pattern. In this case, a semiconductor memory device according to some example embodiments of the present inventive concepts may be a magnetic random access memory (MRAM). For another example, the data storage pattern DSP may include a phase change material or a variable resistance material. In this case, a semiconductor memory device according to some example embodiments of the present inventive concepts may be a phase change random access memory (PRAM) or a resistive random access memory (ReRAM). These are, however, merely examples, and the present inventive concepts are not limited thereto. The data storage pattern DSP may include various structures and/or materials capable of storing data.

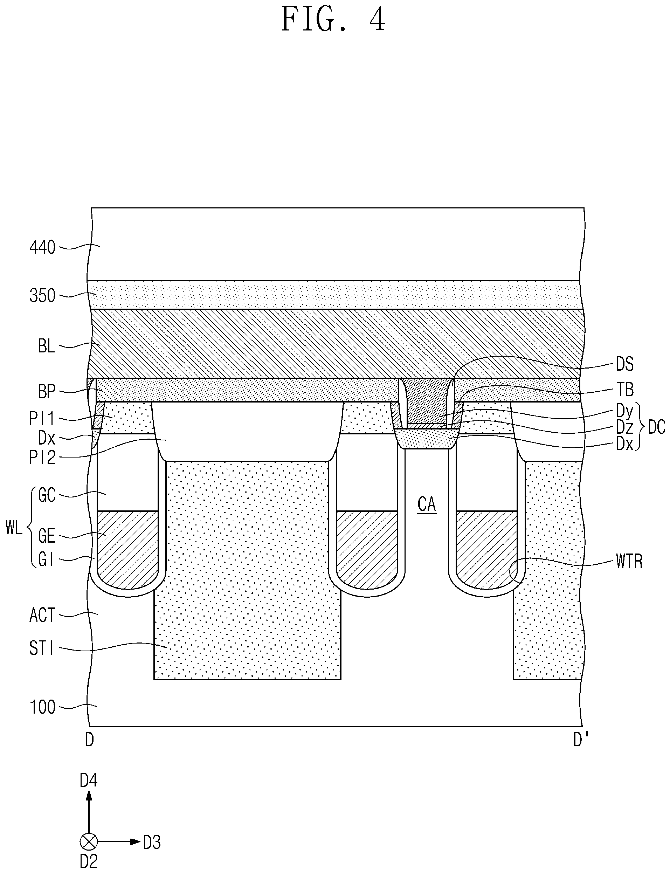

Some example embodiments of the present inventive concepts will be discussed below with reference to FIGS. 4, 5, 6A, 6B, 7A to 7D, and 8A to 8B. For brevity of description, an explanation of components repetitive to those discussed above will be omitted, and a difference thereof will be discussed in detail.

FIG. 4 illustrates a cross-sectional view taken along line D-D' of FIG. 1, according to an example embodiment.

Referring to FIGS. 1 and 4, a trench buried pattern TB may be provided on a lateral surface of the bit-line node spacer DS. The trench buried pattern TB may cover the lateral surface of the bit-line node spacer DS. The trench buried pattern TB may be interposed between the bit-line node spacer DS and the first pad dielectric pattern PI1. The trench buried pattern TB may be located at a level higher than that of the lower contact Dx of the bit-line node contact DC and lower than that of the buffer pattern BP. The trench buried pattern TB may be interposed between the lower contact Dx and the buffer pattern BP. In other words, the trench buried pattern TB may be interposed between the lower contact Dx and the buffer pattern BP in the fourth direction D4. The trench buried pattern TB may include silicon nitride, but the present inventive concepts are not limited thereto.

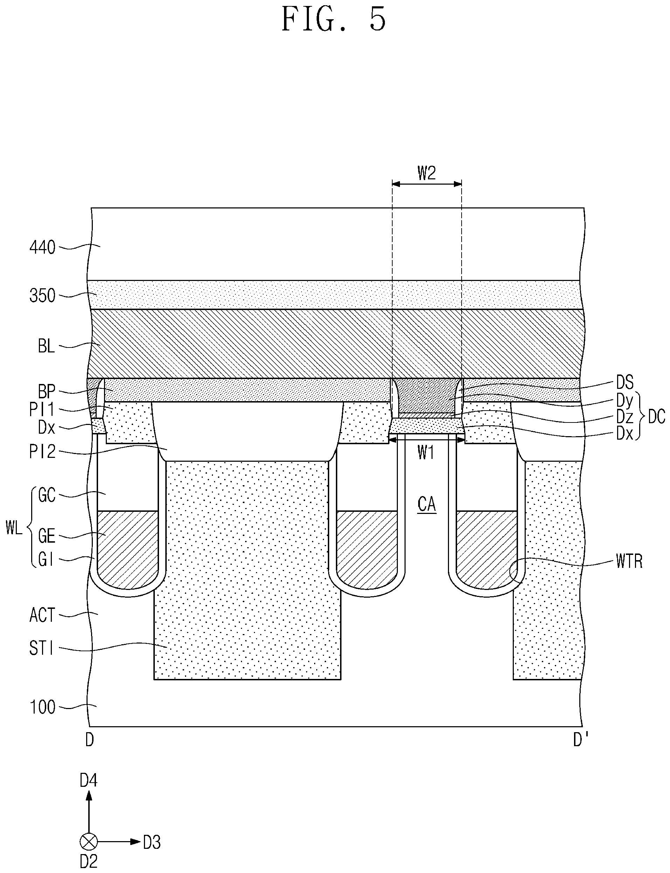

FIG. 5 illustrates a cross-sectional view taken along line D-D' of FIG. 1, according to an example embodiment.

Referring to FIGS. 1 and 5, the lower contact Dx of the bit-line node contact DC may have a width that is changed in accordance with level. When viewed in the third direction D3, a width of the lower contact Dx may increase as a level is lowered. When viewed in the third direction D3, a width W1 at the bottom surface of the lower contact Dx may be greater than a width W2 at the top surface of the lower contact Dx.

The lower contact Dx of the bit-line node contact DC may vertically overlap a portion of the word line WL, and may not vertically overlap another portion of the word line WL. An upper portion of the word line WL may have a recess on another portion of the word line WL, but the present inventive concepts are not limited thereto. The first pad dielectric pattern PI1 may fill the recess on the upper portion of the word line WL.

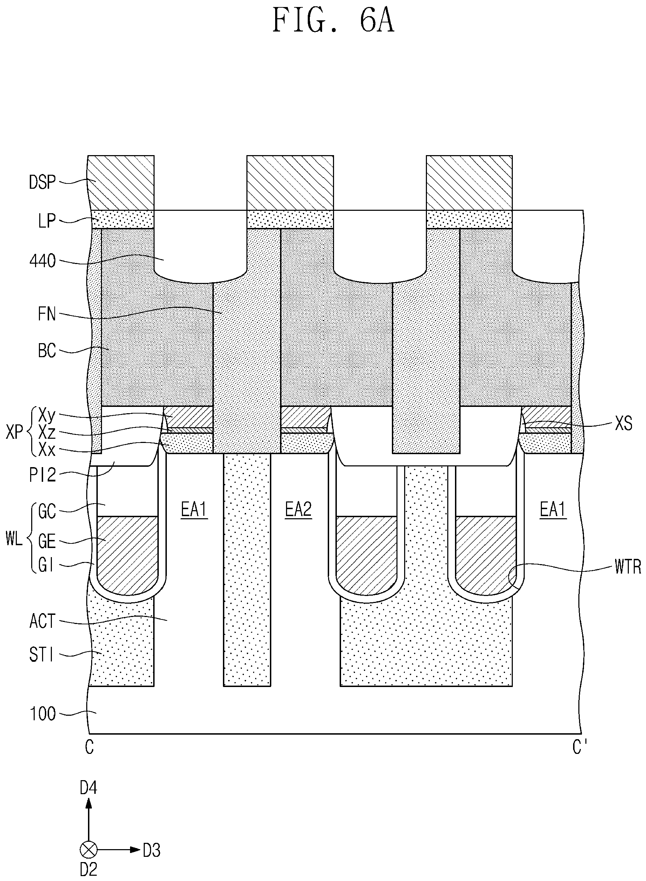

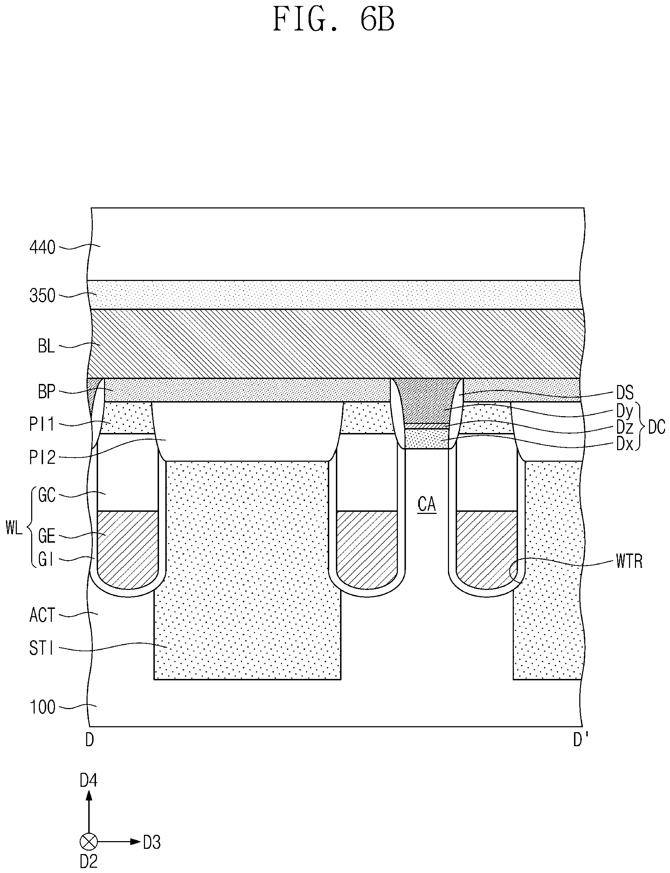

FIGS. 6A and 6B illustrate cross-sectional views taken along lines C-C' and D-D' of FIG. 1, respectively, according to an example embodiment.

Referring to FIGS. 1, 6A, and 6B, the bit-line node spacer DS may be provided on the lateral surface of the bit-line node contact DC. The bit-line node spacer DS may be provided on a lateral surface of the lower contact Dx of the bit-line node contact DC. The bit-line node spacer DS may cover the lateral surface of the upper contact Dy of the bit-line node contact DC, and may extend onto a lateral surface of the ohmic contact Dz and the lateral surface of the lower contact Dx. The bit-line node spacer DS may be interposed between the bit-line node contact DC and the word line WL. A bottom end of the bit-line node spacer DS may be located at a lower level than that of the top surface of the lower contact Dx.

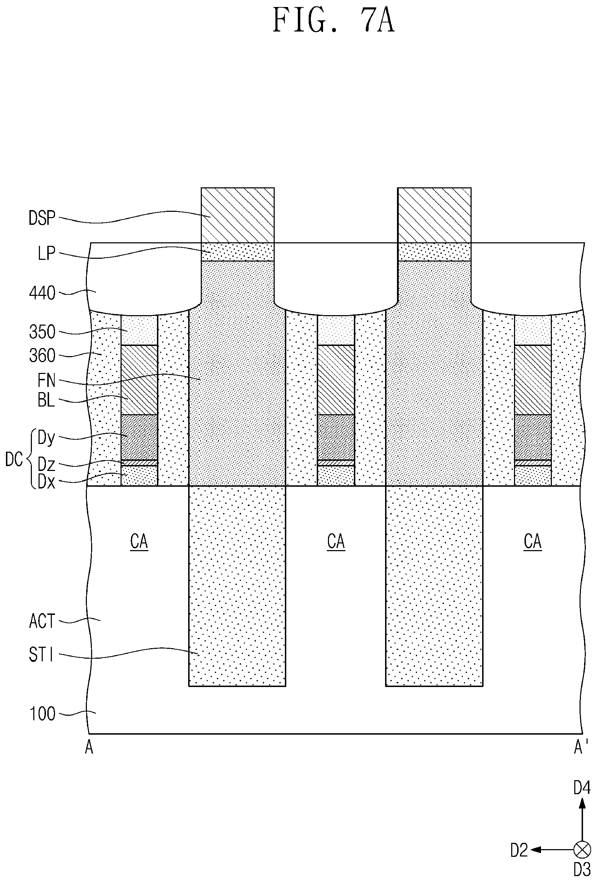

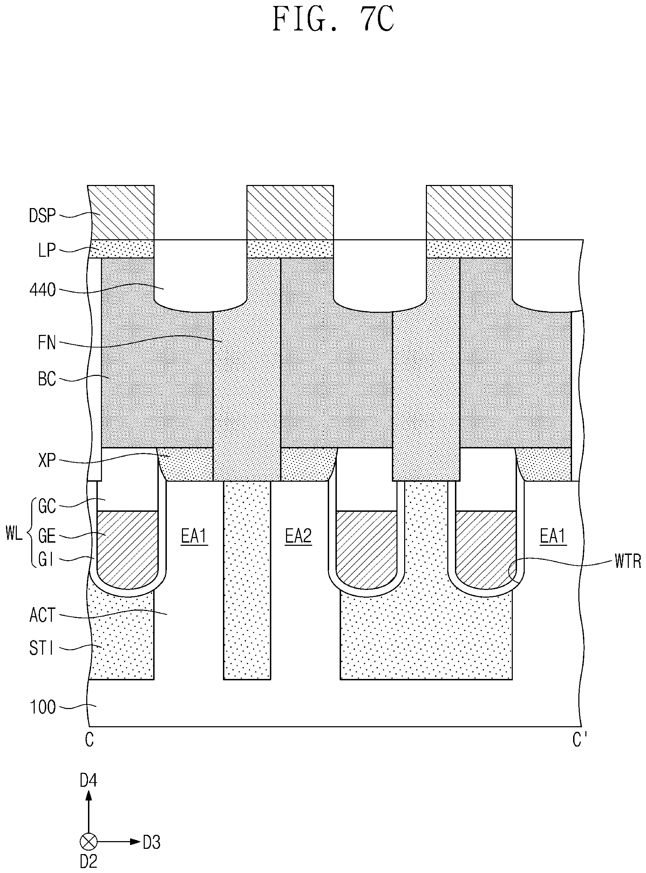

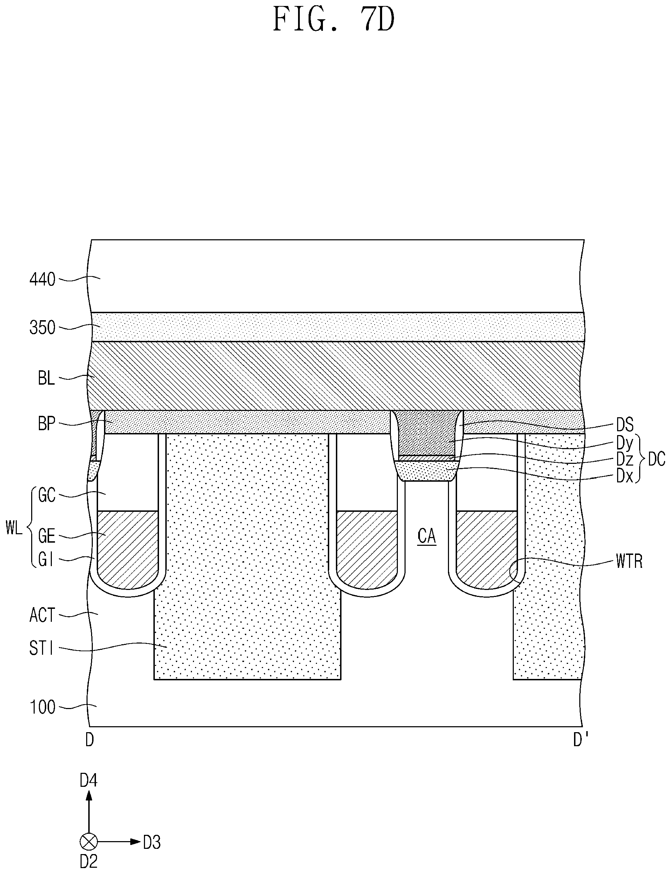

FIGS. 7A, 7B, 7C, and 7D illustrate cross-sectional views taken along lines A-A', B-B', C-C', and D-D' of FIG. 1, respectively, according to an example embodiment.

Referring to FIGS. 1 and 7A to 7D, the device isolation pattern STI may cover the lateral surface of the storage node pad XP. For example, there may be no component such as the first pad dielectric pattern PI1 or the second pad dielectric pattern PI2 of FIG. 3D, and the device isolation pattern STI may cover the lateral surface of the storage node pad XP. In a variant (not shown) of the semiconductor device shown in FIGS. 1 and 7A to 7D, the device isolation pattern STI may cover the lateral surface of the storage node pad XP and the lateral surface of the of the bit-line node contact DC. For example, there may be no component such as the first pad dielectric pattern PI1 or the second pad dielectric pattern PI2 of FIG. 3D, and the device isolation pattern STI may cover the lateral surface of the storage node pad XP and the lateral surface of the of the bit-line node contact DC.

The device isolation pattern STI may be interposed between neighboring storage node pads XP. For example, the device isolation pattern STI may be interposed between the storage node pads XP that neighbor each other in the second direction D2. The device isolation pattern STI may separate the neighboring storage node pads XP from each other. For example, the device isolation pattern STI may separate from each other the storage node pads XP that neighbor each other in the second direction D2. The device isolation pattern STI may insulate neighboring storage node pads XP from each other. For example, the device isolation pattern STI may insulate from each other the storage node pads XP that neighbor each other in the second direction D2.

Each of the storage node pads XP may include silicon (e.g., impurity doped polysilicon). Each of the storage node pads XP may be a single layer formed of a single material, for example, silicon.

The buffer pattern BP may be in contact with a top surface of the word line WL. For example, any of components such as the first pad dielectric pattern PI1 and the second pad dielectric pattern PI2 of FIG. 3D may not be provided between the buffer pattern BP and the top surface of the word line WL.

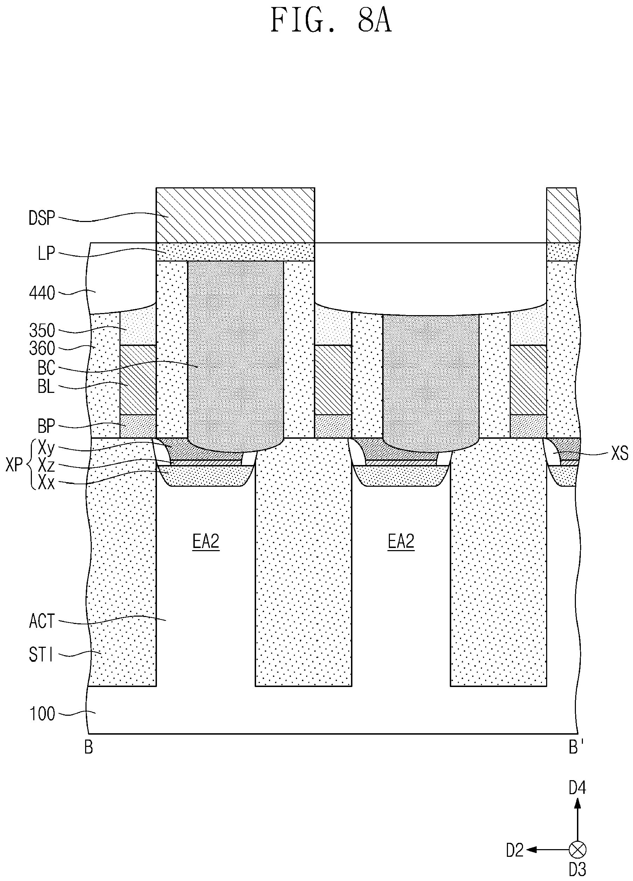

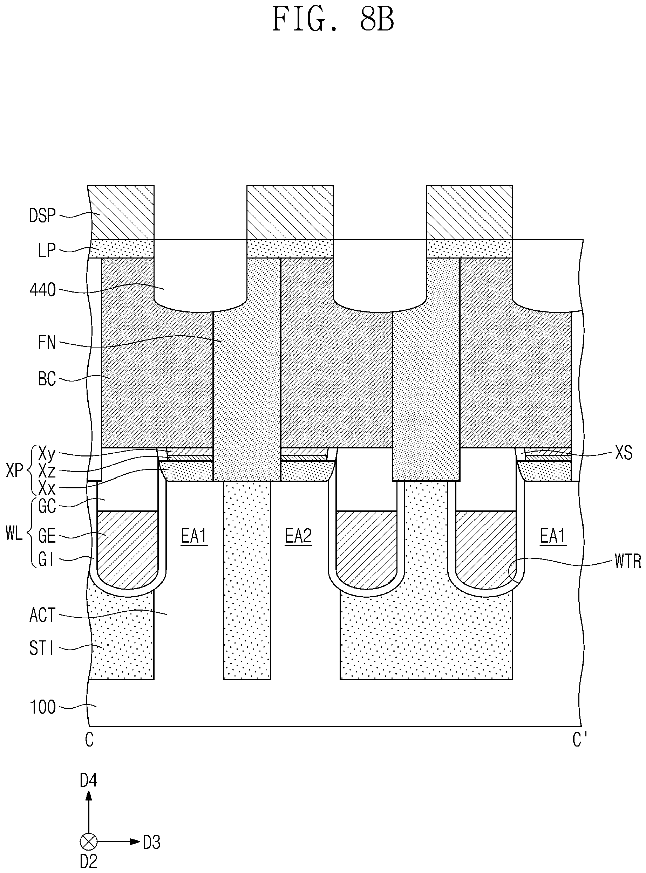

FIGS. 8A and 8B illustrate cross-sectional views taken along lines B-B' and C-C' of FIG. 1 respectively, according to an example embodiment.

Referring to FIGS. 1, 8A, and 8B, as discussed with reference to FIGS. 7A and 7B, the device isolation pattern STI may cover the lateral surface of the storage node pad XP. For example, there may be no component such as the first pad dielectric pattern PI1 or the second pad dielectric pattern PI2 of FIG. 3D, and the device isolation pattern STI may cover the lateral surface of the storage node pad XP. In a variant (not shown) of the semiconductor device shown in FIGS. 1 and 8A to 8B, the device isolation pattern STI may cover the lateral surface of the storage node pad XP and the lateral surface of the bit-line node contact DC. For example, there may be no component such as the first pad dielectric pattern PI1 or the second pad dielectric pattern PI2 of FIG. 3D, and the device isolation pattern STI may cover the lateral surface of the storage node pad XP and the lateral surface of the bit-line node contact DC.

Different from that discussed with reference to FIGS. 7A and 7B, each of the storage node pads XP may be a composite layer including two or more materials. For example, each of the storage node pads XP may include a lower pad Xx, an upper pad Xy on the lower pad Xx, and an ohmic pad Xz between the lower pad Xx and the upper pad Xy. Each of the storage node pads XP may include at least one of silicon (e.g., impurity doped polysilicon) and metallic materials (e.g., Ti, Mo, W, Cu, Al, Ta, Ru, or Ir). For example, the lower pad Xx may include silicon (e.g., impurity doped polysilicon), and the upper pad Xy may include a metallic material (e.g., Ti, Mo, W, Cu, Al, Ta, Ru, or Ir).

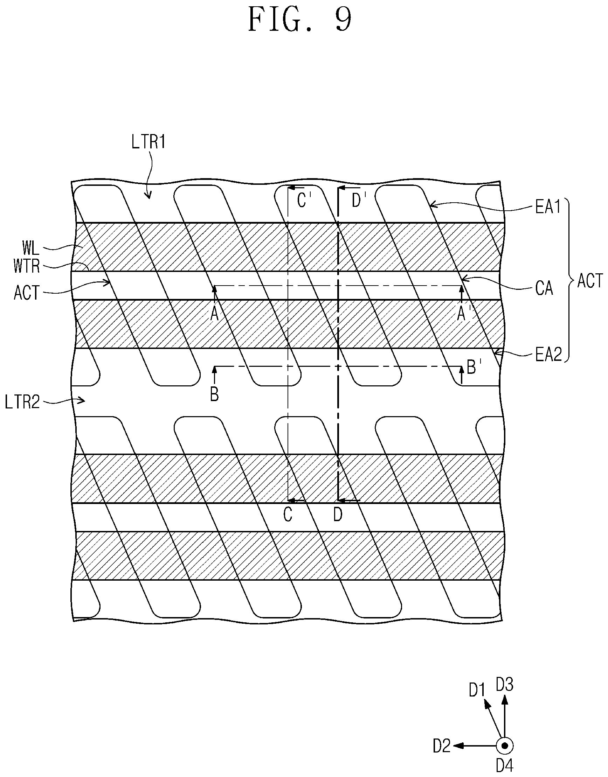

With reference to FIGS. 9 to 43D, the following will describe a method of fabricating a semiconductor device according to some example embodiments of the present inventive concepts. For brevity of description, an explanation of components repetitive to those discussed above will be omitted, and a difference thereof will be discussed in detail.

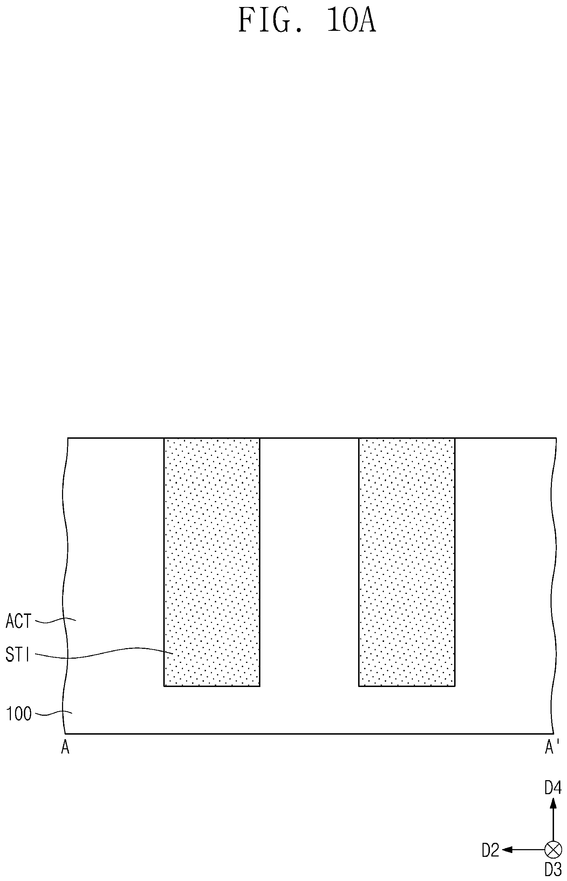

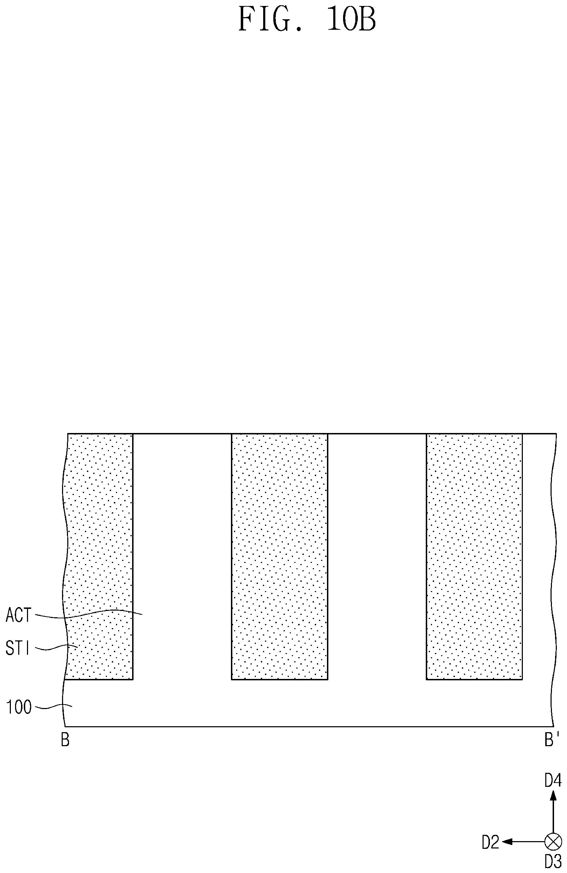

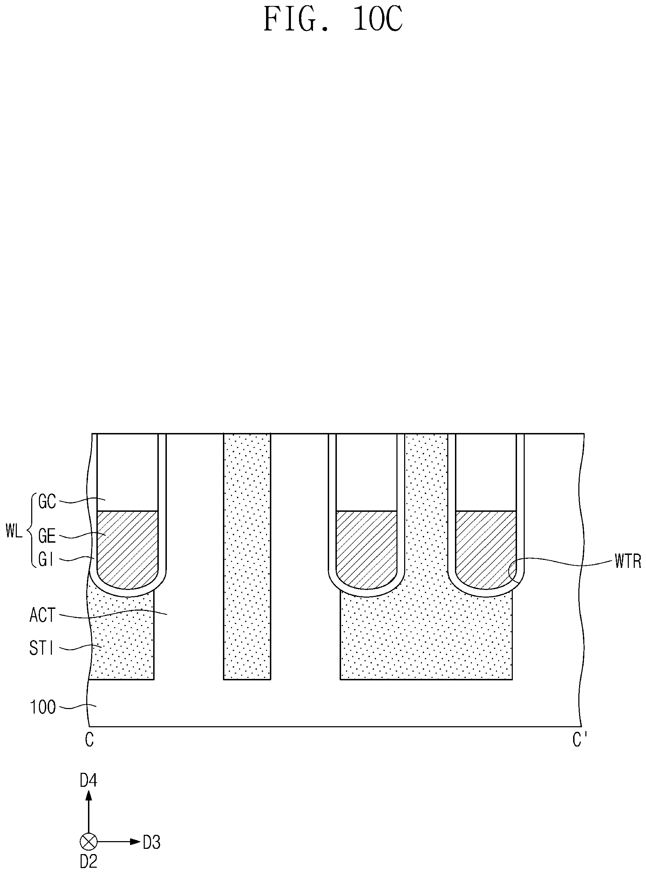

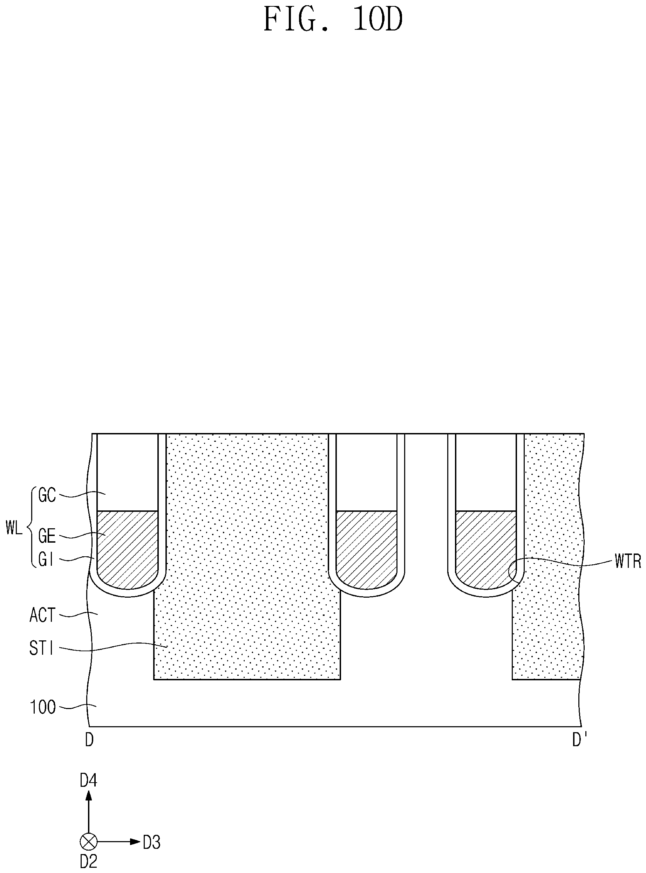

FIGS. 9, 10A to 10D, 11, 12A to 12D, 13, 14A to 14D, 15, 16A to 16D, 17 and 18A to 18D illustrate diagrams showing a method of fabricating a semiconductor device discussed with reference to FIGS. 1, 2 and 3A to 3D, according to an example embodiment. In detail, FIGS. 9, 11, 13, 15, and 17 illustrate plan views showing a method of fabricating a semiconductor device discussed with reference to FIGS. 1, 2 and 3A to 3D. FIGS. 10A, 12A, 14A, 16A, and 18A illustrate cross-sectional views taken along line A-A' of FIGS. 9, 11, 13, 15, and 17, respectively. FIGS. 10B, 12B, 14B, 16B, and 18B illustrate cross-sectional views taken along line B-B' of FIGS. 9, 11, 13, 15, and 17, respectively. FIGS. 10C, 12C, 14C, 16C, and 18C illustrate cross-sectional views taken along line C-C' of FIGS. 9, 11, 13, 15, and 17, respectively. FIGS. 10D, 12D, 14D, 16D, and 18D illustrate cross-sectional views taken along line D-D' of FIGS. 9, 11, 13, 15, and 17, respectively.

Referring to FIGS. 9 and 10A to 10D, a substrate 100 may be prepared. The substrate 100 may undergo a removal process to form active patterns ACT. A first line trench region LTR1 and a second line trench region LTR2 may be formed between the active patterns ACT.

The removal process may include using an exposure process to form mask patterns on the substrate 100, and using the mask patterns as an etching mask to etch the substrate 100. The exposure process and the etching process may be alternately and repeatedly performed several times. For example, first exposure and etching processes may be performed to form the first line trench regions LTR1 and line patterns that extend along a first direction D1. Afterwards, second exposure and etching processes may be performed on the line patterns. The second exposure and etching processes may form the second line trench regions LTR2 that extend along a second direction D2, and the second line trench regions LTR2 may separate each of the line patterns into the active patterns ACT that are linearly disposed along the first direction D1.

A device isolation pattern STI may fill the first and second line trench regions LTR1 and LTR2. The device isolation pattern STI may include performing a physical vapor deposition (PVD) process, a chemical vapor deposition (CVD) process, or an atomic layer deposition (ALD) process.

Thereafter, a word line WL may be formed to run across the active pattern ACT and the device isolation pattern STI. The formation of the word line WL may include forming a mask pattern on the active pattern ACT and the device isolation pattern STI, using the mask pattern to perform an anisotropic etching process to form a word-line trench region WTR, and filling the word-line trench region WTR with the word line WL.

The filling of the word line WL may include, for example, conformally depositing a gate dielectric pattern GI on an inner surface of the word-line trench region WTR, filling the word-line trench region WTR with a conductive layer, allowing the conductive layer to undergo an etch-back process and/or a polishing process to form a gate electrode GE, and forming on the gate electrode GE a gate capping pattern GC that fills an unoccupied portion of the word-line trench region WTR.

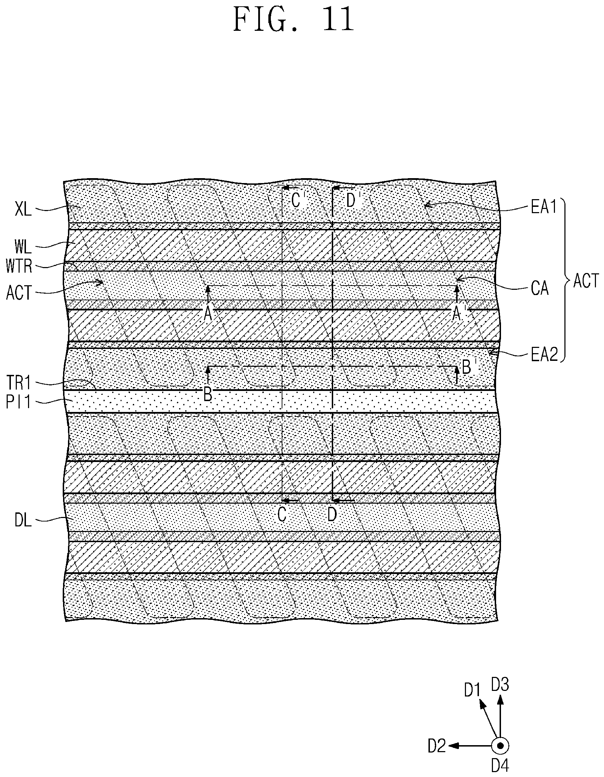

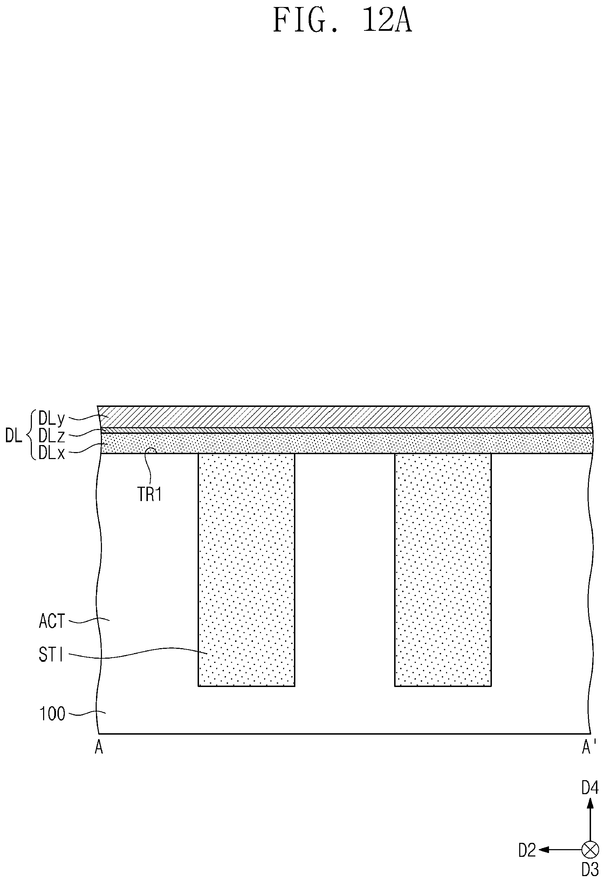

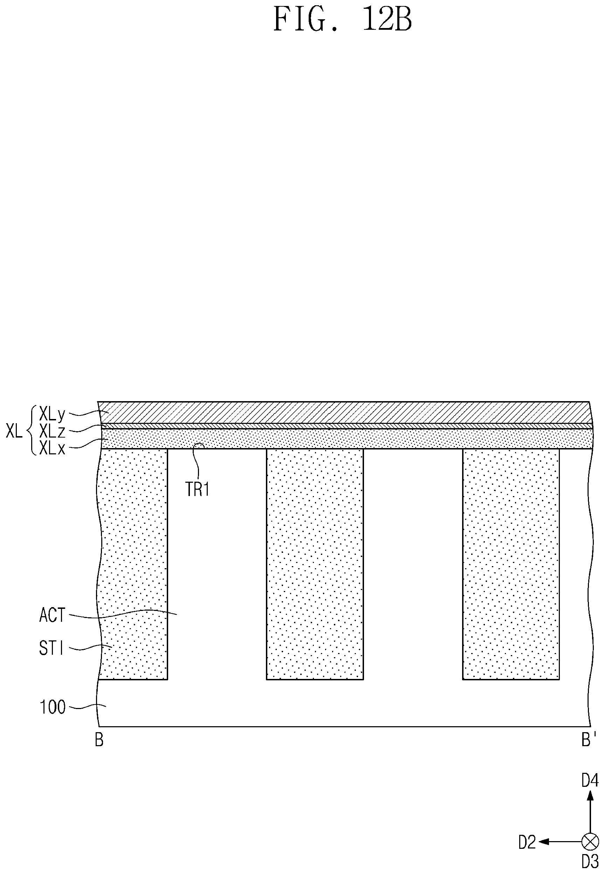

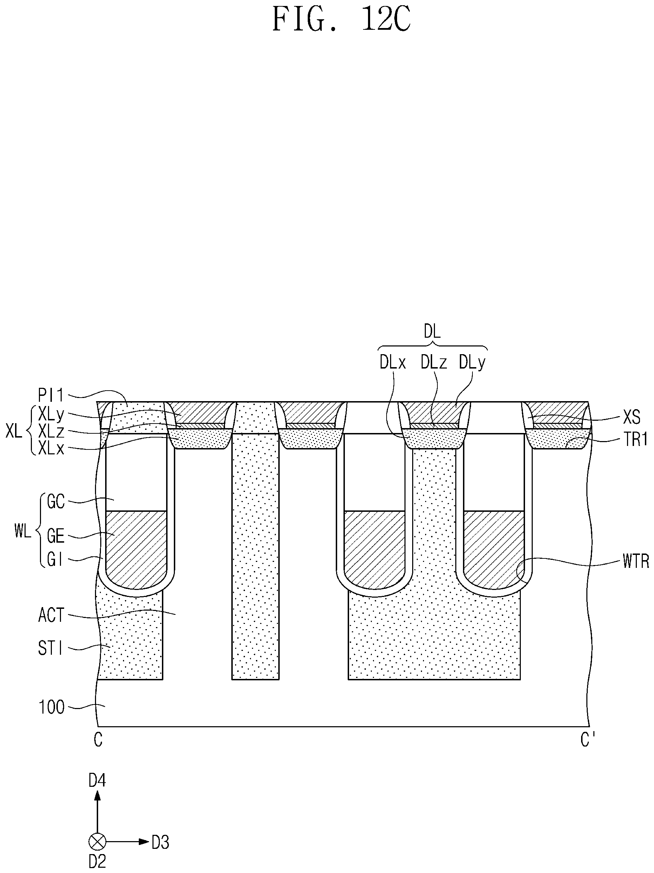

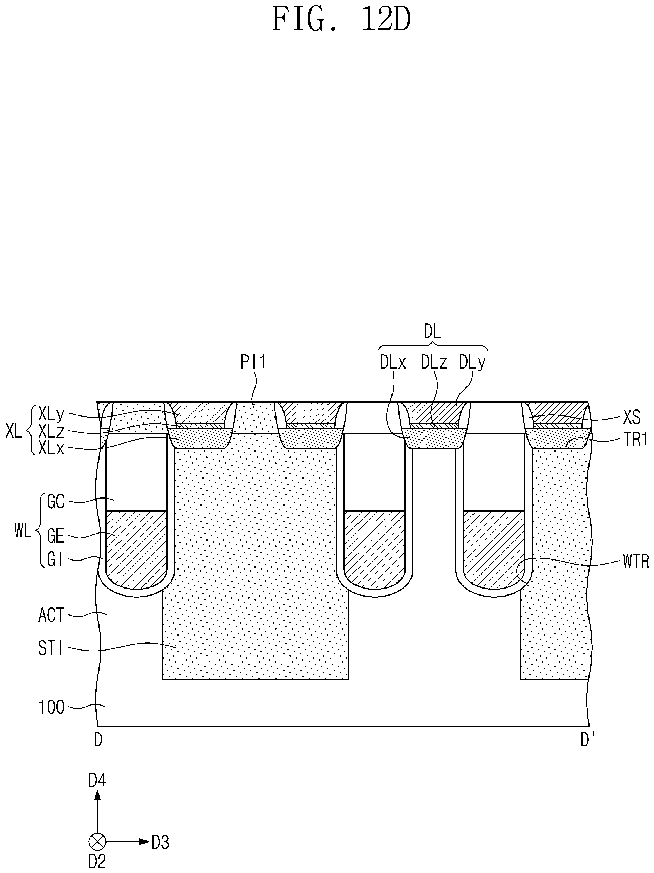

Referring to FIGS. 11 and 12A to 12D, a first pad dielectric pattern PI1 may be formed on the active pattern ACT and the device isolation pattern STI. The formation of the first pad dielectric pattern PI1 may include forming a first pad dielectric layer (not shown) on an entire surface of the substrate 100, and performing an anisotropic etching process to etch the first pad dielectric layer to form first pad dielectric patterns PI1 and first trench regions TR1. The first pad dielectric patterns PI1 and the first trench regions TR1 may extend along the second direction D2. The active pattern ACT may include a central part CA, a first edge part EA1, and a second edge part EA2 that are exposed by the first trench regions TR1.

A width measured in a third direction D3 of the first trench region TR1 may be changed in accordance with level. For example, the width measured in the third direction D3 of the first trench region TR1 may decrease as a level is lowered.

Pad lines XL and contact lines DL may be formed to fill the first trench regions TR1. The pad lines XL and the contact lines DL may extend along the second direction D2 in the first trench regions TR1. The pad lines XL may cover the exposed first and second edge parts EA1 and EA2 of the active patterns ACT. Each of the pad lines XL may include a lower pad line XLx, an upper pad line XLy on the lower pad line XLx, and an ohmic pad line XLz between the lower pad line XLx and the upper pad line XLy. The contact lines DL may cover the exposed central parts CA of the active patterns ACT. Each of the contact lines DL may include a lower contact line DLx, an upper contact line DLy on the lower contact line DLx, and an ohmic contact line DLz between the lower contact line DLx and the upper contact line DLy.

The pad lines XL may be formed by an engraving process. For example, the first pad dielectric layer may be etched to form the first pad dielectric pattern PI1 and the first trench regions TR1, and the first pad dielectric pattern PI1 may be used as a mold for forming the pad lines XL. As the first pad dielectric layer is etched to form the first trench regions TR1, a width measured in the third direction D3 of the first trench region TR1 may be changed in accordance with level. For example, the width measured in the third direction D3 of the first trench region TR1 may decrease as a level is lowered. Therefore, a width measured in the third direction D3 of the pad line XL may also decrease as a level is lowered. In the third direction D3, a width at a bottom surface of the lower pad line XLx may be less than that at a top surface of the lower pad line XLx. The contact lines DL may also be formed by an engraving process, and may have similar features to those of the pad lines XL.

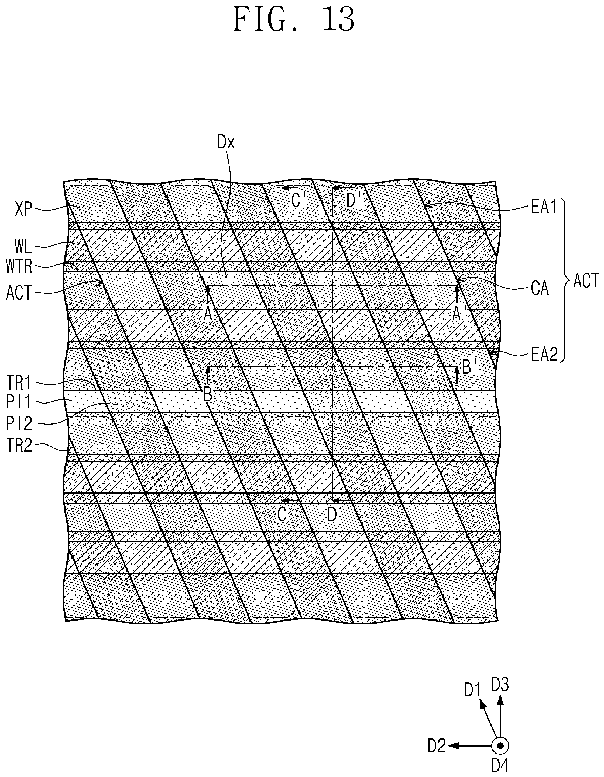

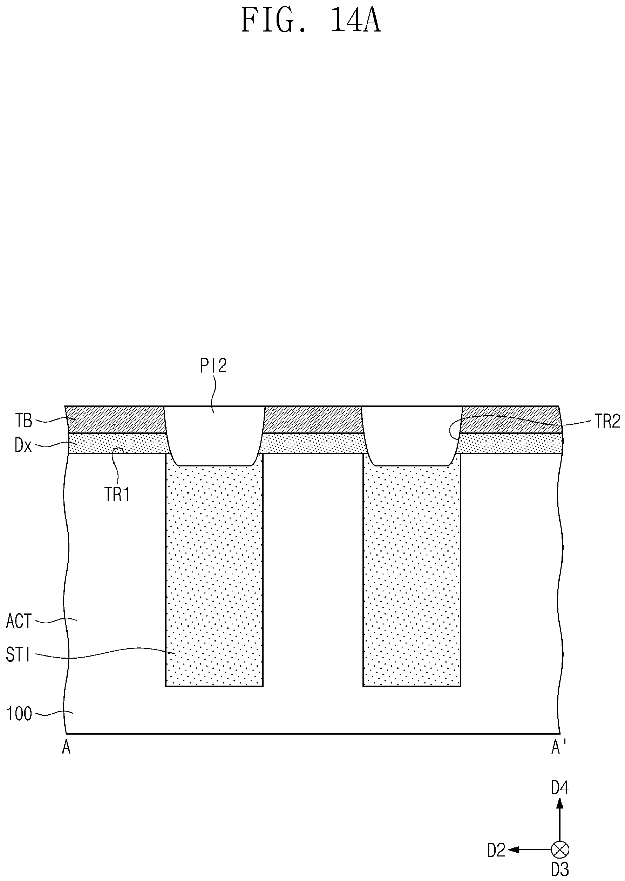

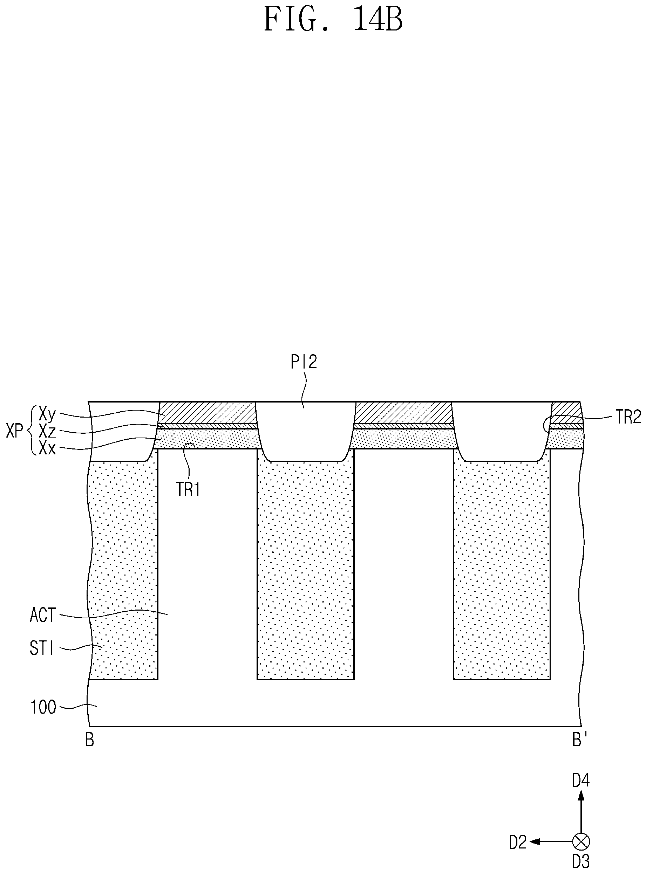

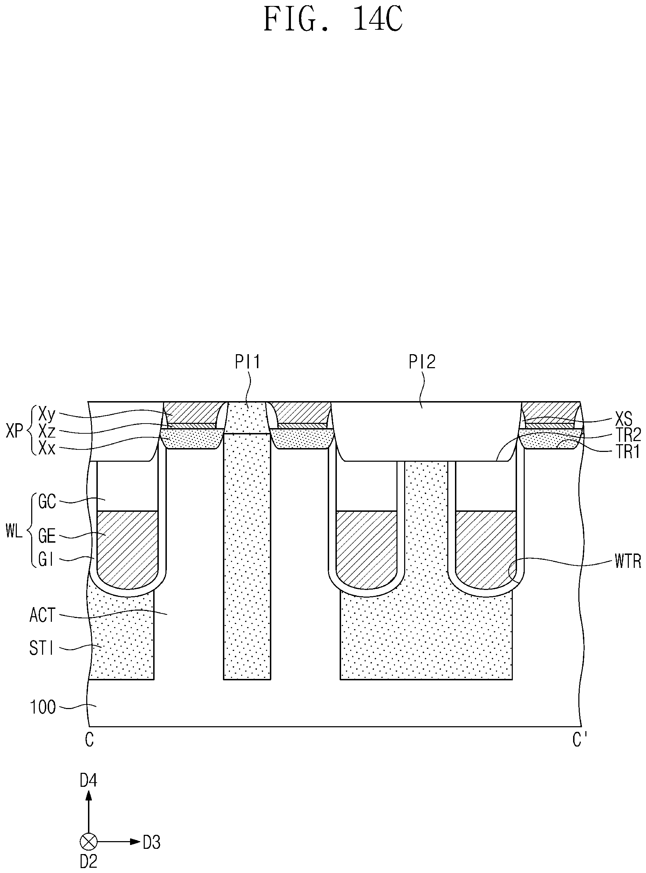

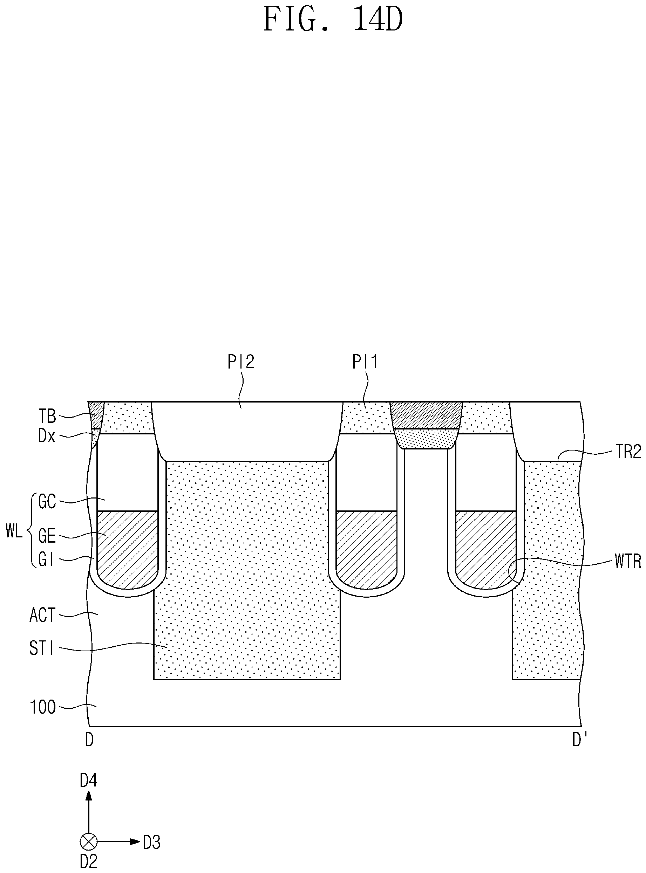

Referring to FIGS. 13 and 14A to 14D, there may be removed the upper contact line DLy and the ohmic contact line DLz of the contact line DL. The removal of the upper contact line DLy and the ohmic contact line DLz may include, for example, etching the upper contact line DLy and the ohmic contact line DLz. The lower contact line DLx of the contact line DL may remain even after the etching process.

A trench buried line (not shown) may be formed on the lower contact line DLx. The trench buried line may cover the lower contact line DLx. The trench buried line may be formed on a region where the upper contact line DLy and the ohmic contact line DLz are removed. The trench buried line may be formed in the first trench region TR1 on the central part CA of the active pattern ACT.

After that, the pad lines XL may be etched to form storage node pads XP. The etching of the pad lines XL may include forming second trench regions TR2 by which each of the pad lines XL on the first and second edge parts EA1 and EA2 is separated into a plurality of storage node pads XP. The second trench regions TR2 may extend along the first direction D1. The second trench regions TR2 may run along the first direction D1 across the first pad dielectric pattern PI1.

As the etching process is performed, a residue of the lower pad line XLx, a residue of the upper pad line XLy, and a residue of the ohmic pad line XLz of the pad lines XL on the first and second edge parts EA1 and EA2 may respectively constitute a lower pad Xx, an upper pad Xy, and an ohmic pad Xz of the storage node pad XP.

In the etching process of the pad lines XL, the trench buried line and the lower contact line DLx may be simultaneously etched to form trench buried patterns TB and lower contacts Dx. The etching process may separate the trench buried line into a plurality of trench buried patterns TB and the lower contact line DLx into a plurality of lower contacts Dx.

A second pad dielectric pattern PI2 may be formed to fill the second trench region TR2. The second pad dielectric pattern PI2 may extend along the first direction D1 in the second trench region TR2.

The storage node pads XP may be formed by an embossing process in which the pad lines XL are used. For example, the pad lines XL may be formed, and thereafter each of the pad lines XL may be etched to form the storage node pads XP. As the pad lines XL are etched to form the second trench regions TR2, a width measured in the second direction D2 of the second trench region TR2 may be changed in accordance with level. For example, the width measured in the second direction D2 of the second trench region TR2 may decrease as a level is lowered. Therefore, a width measured in the second direction D2 of the second pad dielectric pattern PI2 may also decrease as a level is lowered. In contrast, a width measured in the second direction D2 of the storage node pad XP may increase as a level is lowered.

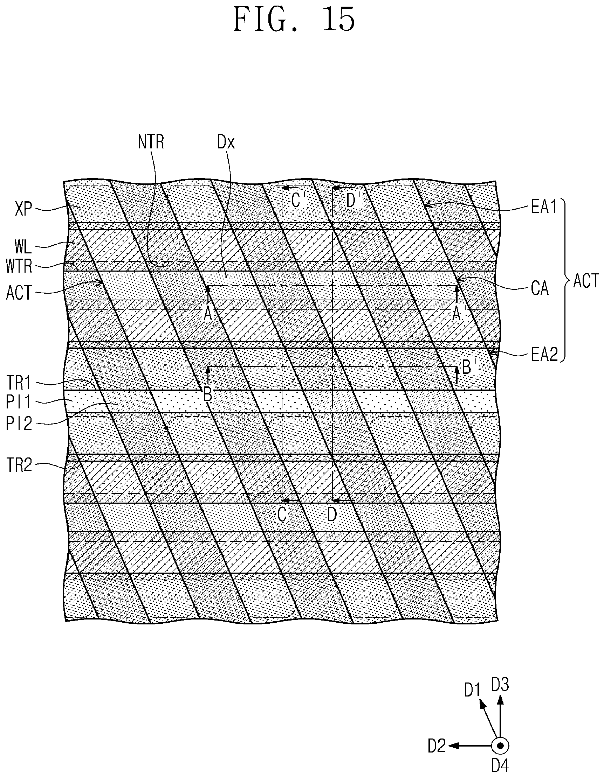

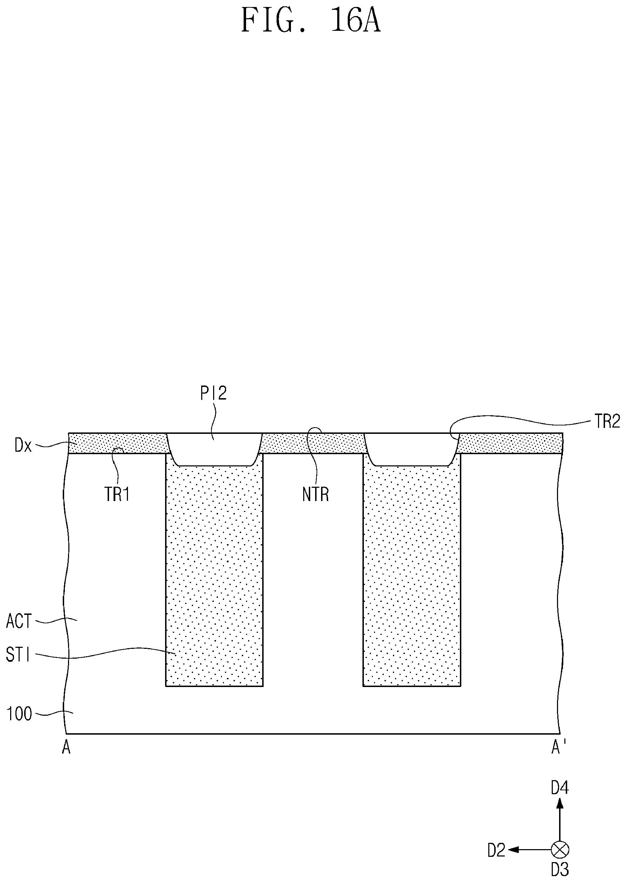

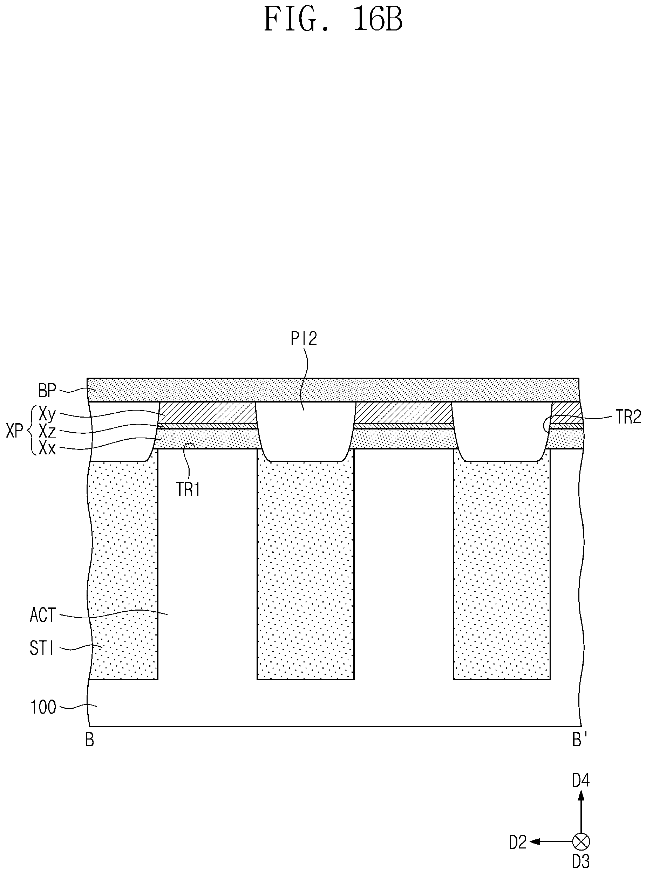

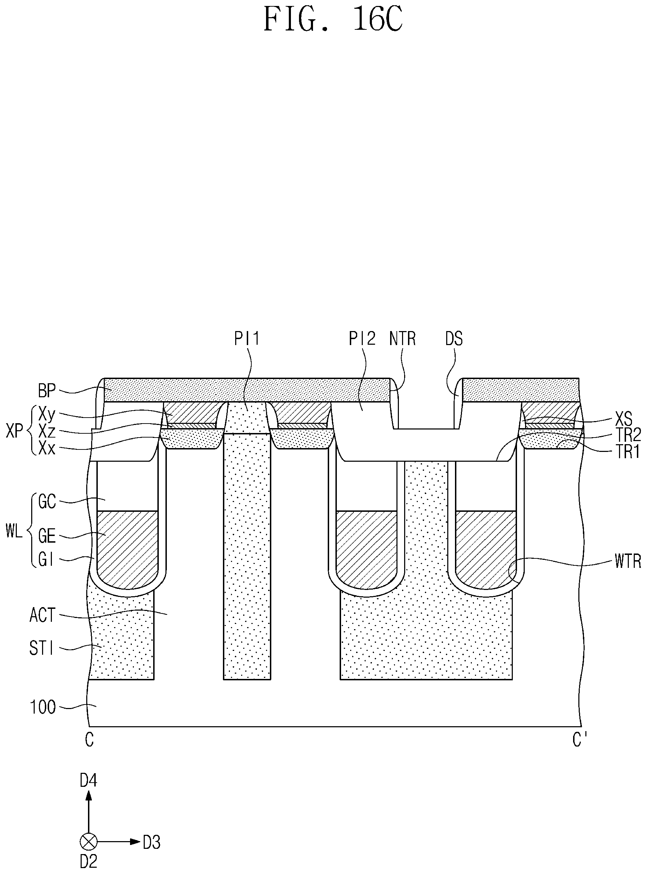

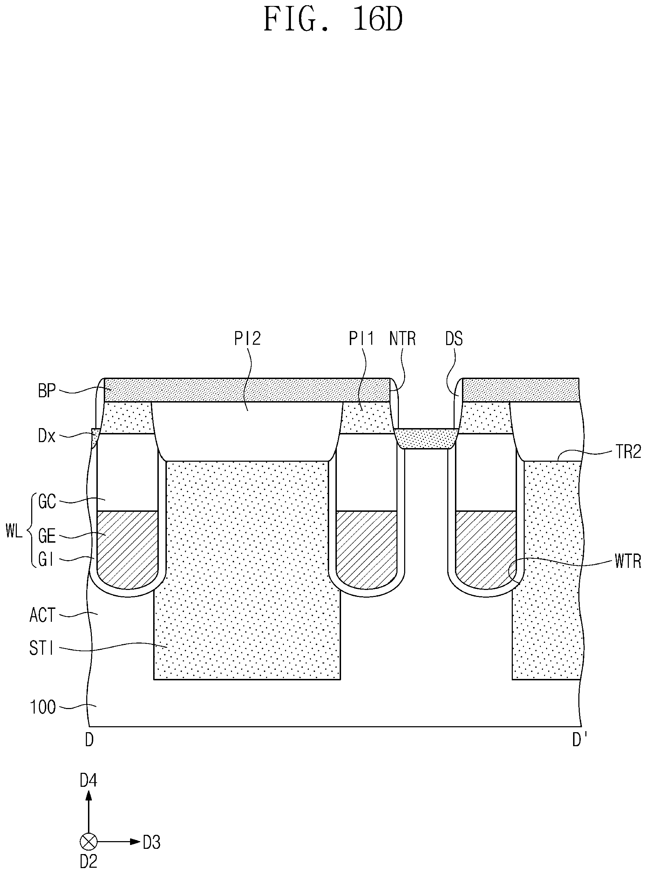

Referring to FIGS. 15 and 16A to 16D, a buffer pattern BP may be formed to cover an entire surface of the substrate 100. The buffer pattern BP may cover the storage node pads XP and the trench buried patterns TB. The buffer pattern BP may include two or more buffer patterns that are stacked, but the present inventive concepts are not limited thereto.

Thereafter, the buffer pattern BP and the trench buried pattern TB may be etched to form node trench regions NTR. The node trench regions NTR may extend along the second direction D2 and may be spaced apart from each other in the third direction D3. Each of the node trench regions NTR may be formed on the central parts CA of the active patterns ACT that are disposed side by side (e.g., arranged) along the second direction D2. The lower contact Dx may be exposed by the node trench regions NTR. For example, in the etching process, the second pad dielectric pattern PI2 may also be etched.

Afterwards, a bit-line node spacer DS may be formed on inner sidewalls of the node trench regions NTR. For example, a pair of bit-line node spacers DS may be formed to cover opposite lateral surfaces of one node trench region NTR.

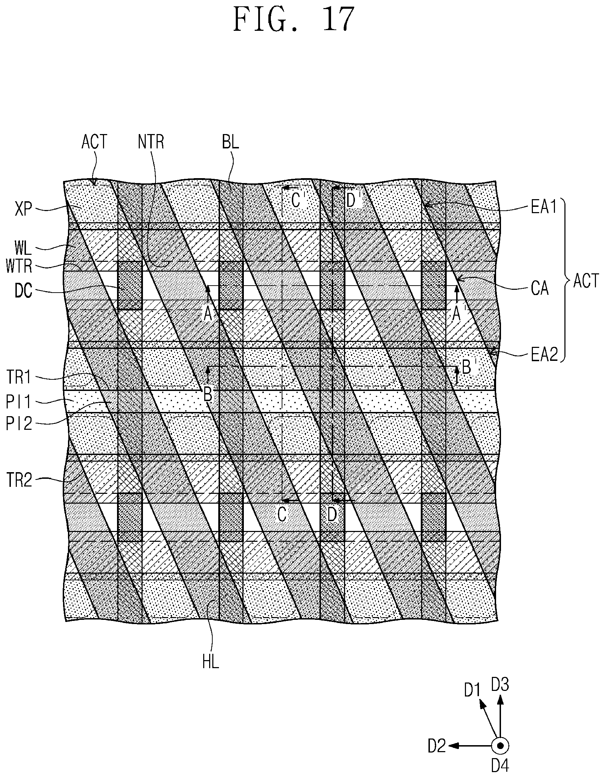

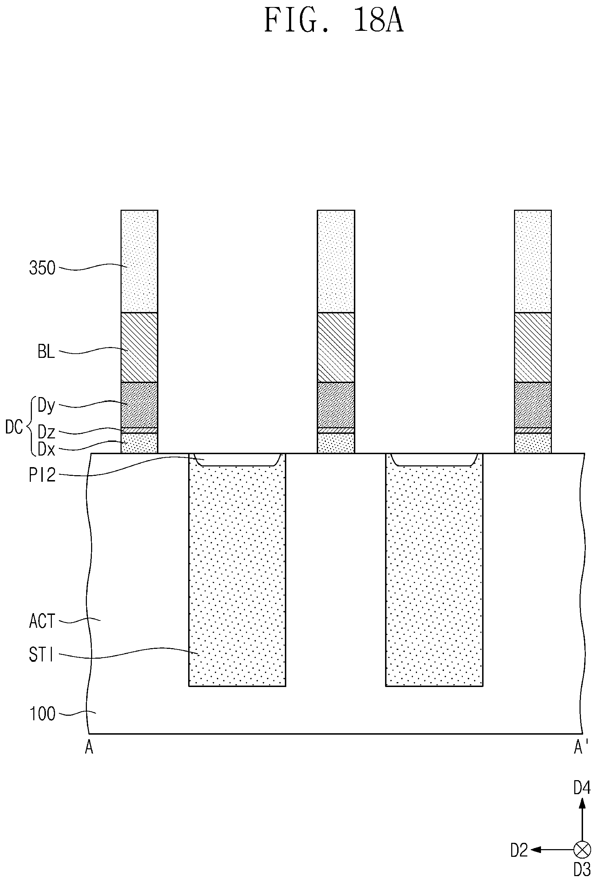

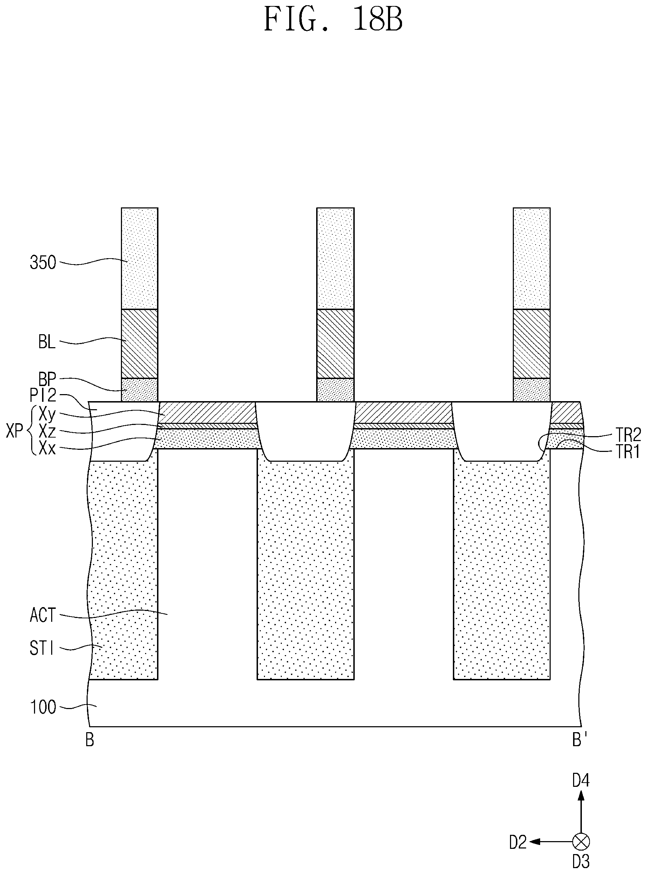

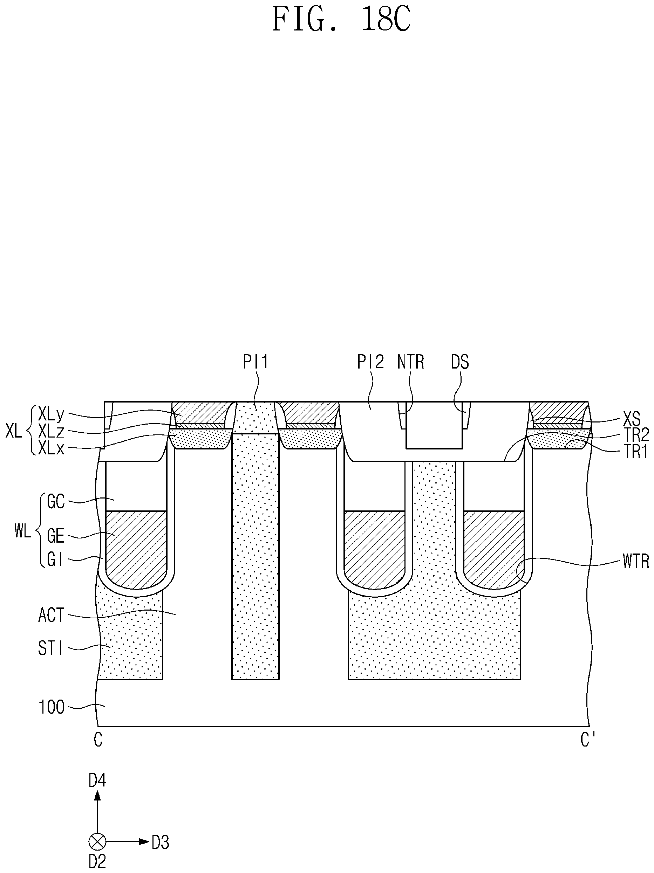

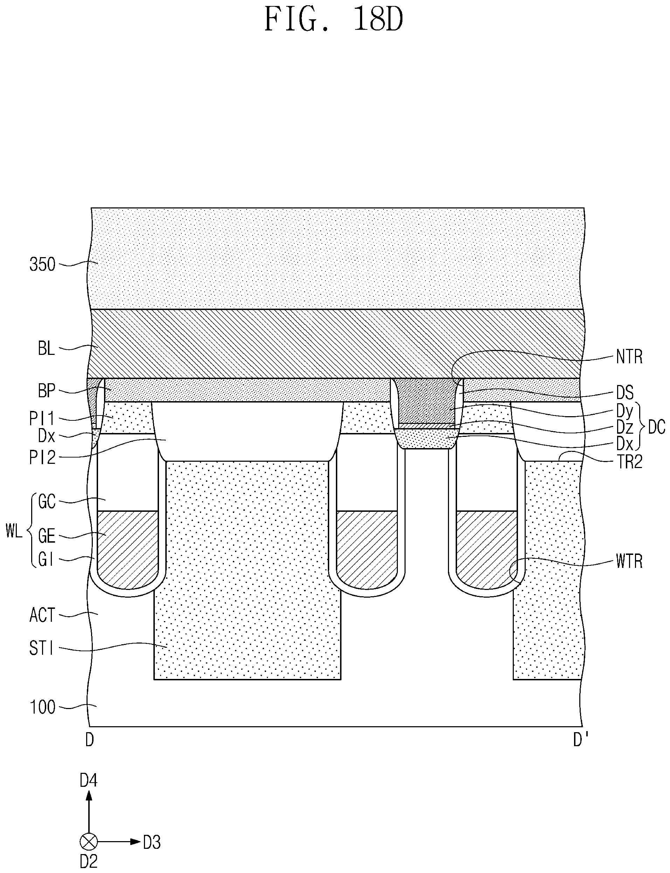

Referring to FIGS. 17 and 18A to 18D, an upper contact Dy may be formed to fill the node trench region NTR. Before or after the formation of the upper contact Dy, an ohmic contact Dz may be formed on the lower contact Dx. Thus, a bit-line node contact DC including the lower contact Dx, the upper contact Dy, and the ohmic contact Dz may be formed. A top surface of the upper contact Dy may be located at substantially the same level as a top surface of the buffer pattern BP.

A bit-line layer (not shown) and a bit-line capping layer (not shown) may be sequentially formed to cover the entire surface of the substrate 100. Afterwards, an etching process may be performed to form a bit-line capping pattern 350 and a bit line BL. In the etching process, the bit-line capping pattern 350 and the bit line BL may be formed from the bit-line capping layer and the bit-line layer, respectively.

The bit lines BL may extend along the third direction D3, while being spaced apart from each other in the second direction D2. In the etching process of the bit line BL, an upper portion of the buffer pattern BP and the bit-line node contact DC may be simultaneously etched. For example, on a region that does not vertically overlap the bit line BL, the upper portion of the buffer pattern BP and the bit-line node contact DC may be etched. For another example, below the bit line BL, the upper portion of the buffer pattern BP and the bit-line node contact DC may remain without being etched.

According to some example embodiments, in the etching process of the bit line BL, the upper contact Dy of the bit-line node contact DC may be over-etched more than the lower contact Dx of the bit-line node contact DC. According to some example embodiments of the present inventive concepts, the upper contact Dy of the bit-line node contact DC may include a metallic material, and thus the over-etching of the upper contact Dy may be minimized when the etching process is performed. Thus, a semiconductor device may have improved electrical properties and increased reliability.

Thereafter, a lower portion of the buffer pattern BP that remains on the region that does not vertically overlap the bit line BL may be removed, such that the buffer pattern BP may be separated into a plurality of buffer patterns BP formed below the bit line BL. In this procedure, a portion of the second pad dielectric pattern PI1 may further be removed, and an inner sidewall of the node trench region NTR may further be recessed.

Referring back to FIGS. 1, 2 and 3A to 3D, a bit-line spacer 360 may be formed to cover a lateral surface of the bit line BL and a lateral surface of the bit-line capping pattern 350. For visibility, FIG. 1 omits an illustration of the first and second pad dielectric patterns PI1 and PI2 as illustrated in FIG. 17, but unless otherwise explicitly stated, it should be understood that the first and second pad dielectric patterns PI1 and PI2 are also provided in FIG. 1. The formation of the bit-line spacer 360 may include sequentially forming a plurality of sub-spacers (not shown) that conformally cover the lateral surface of the bit line BL and the lateral surface of the bit-line capping pattern 350.

Storage node contacts BC and fence patterns FN may be formed between neighboring bit lines BL. The storage node contacts BC and the fence patterns FN may be arranged alternately along the first direction D1. Before the formation of the storage node contacts BC, an upper portion of each of the storage node pads XP may be removed to form a recess. Each of the storage node contacts BC may fill the recess. Each of the storage node contacts BC may be electrically connected through a corresponding storage node pad XP to a corresponding one of the first and second edge parts EA1 and EA2.

For example, before the formation of the storage node contacts BC, fence lines (not shown) may be formed to extend in the third direction D3 between neighboring bit lines BL. Thereafter, portions of the fence lines may be removed on the storage node pads XP, and the storage node contacts BC may be formed on regions where the portions of the fence lines are removed. The fence patterns FN may include non-removed portions of the fence lines.

For another example, before the formation of the storage node contacts BC, mold lines (not shown) may be formed to extend in the third direction D3 between neighboring bit lines BL. Afterwards, portions of the mold lines may be removed, and the fence patterns FN may be formed on regions where the portions of the mold lines are removed. After the formation of the fence patterns FN, remaining portions of the mold lines may be removed. The storage node contacts BC may be formed on regions where the remaining portions of the mold lines are removed.

Landing pads LP may be formed on the storage node contacts BC. The formation of the landing pads LP may include sequentially forming a landing pad layer (not shown) and mask patterns (not shown) that cover top surfaces of the storage node contacts BC, and using the mask patterns as an etching mask to perform an anisotropic etching process to divide the landing pad layer into a plurality of landing pads LP.

Thereafter, a filling pattern 440 may be formed on a region where the landing pad layer is removed. The filling pattern 440 may surround each of the landing pads LP. A data storage pattern DSP may be formed on each of the landing pads LP.

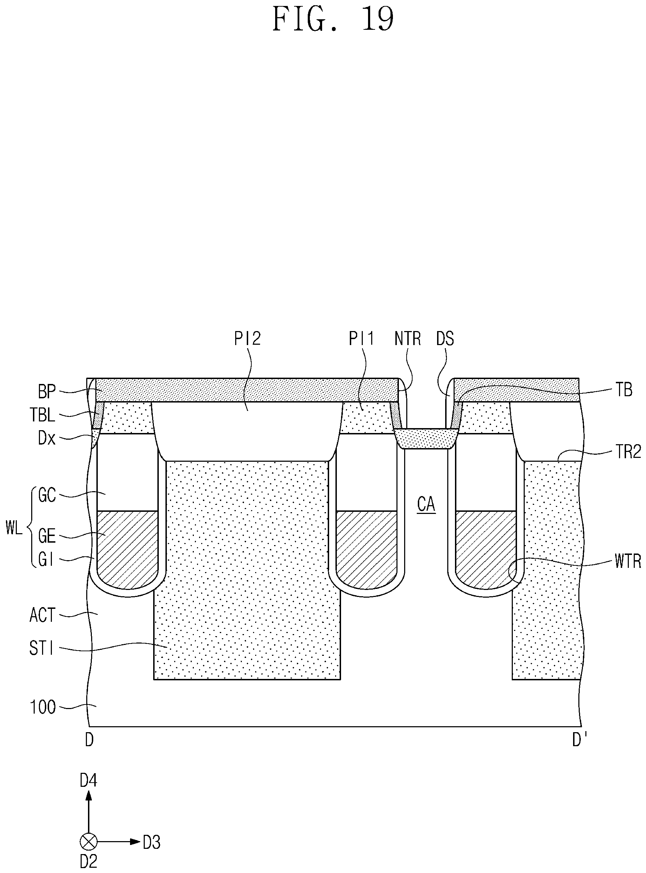

FIG. 19 illustrates a diagram showing a method of fabricating a semiconductor device discussed with reference to FIG. 4, according to an example embodiment. FIG. 19 shows a cross-sectional view taken along line D-D' of FIG. 15.

Referring to FIGS. 15 and 19, when the node trench region NTR is formed, a portion of the trench buried pattern TB may remain without being etched. The trench buried pattern TB may constitute an inner sidewall of the node trench region NTR. A lateral surface of the trench buried pattern TB may be aligned with that of the buffer pattern BP. The trench buried pattern TB may expose at least a portion of a top surface of the lower contact Dx. The trench buried pattern TB may be interposed between the buffer pattern BP and the lower contact Dx.

Afterwards, a bit-line node spacer DS may be formed on inner sidewalls of the node trench regions NTR. On the inner sidewalls of the node trench regions NTR, the bit-line node spacer DS may cover the trench buried pattern TB. The bit-line node spacer DS may isolate the trench buried pattern TB from the outside. For example, the trench buried pattern TB may be interposed between the bit-line node spacer DS and the first pad dielectric pattern PI1.

Referring back to FIG. 4, the bit-line node contact DC may be formed in the node trench region NTR. Thereafter, a semiconductor fabrication method discussed above may be used to fabricate a semiconductor device discussed with reference to FIG. 4.

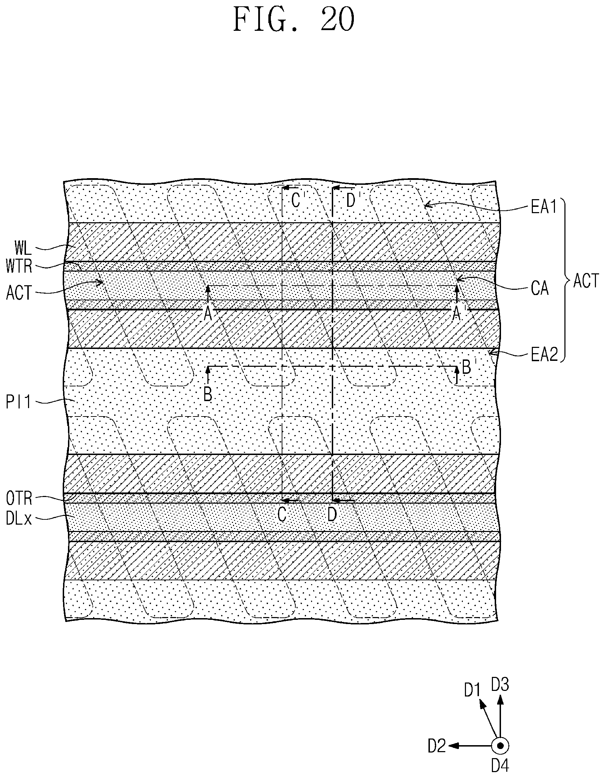

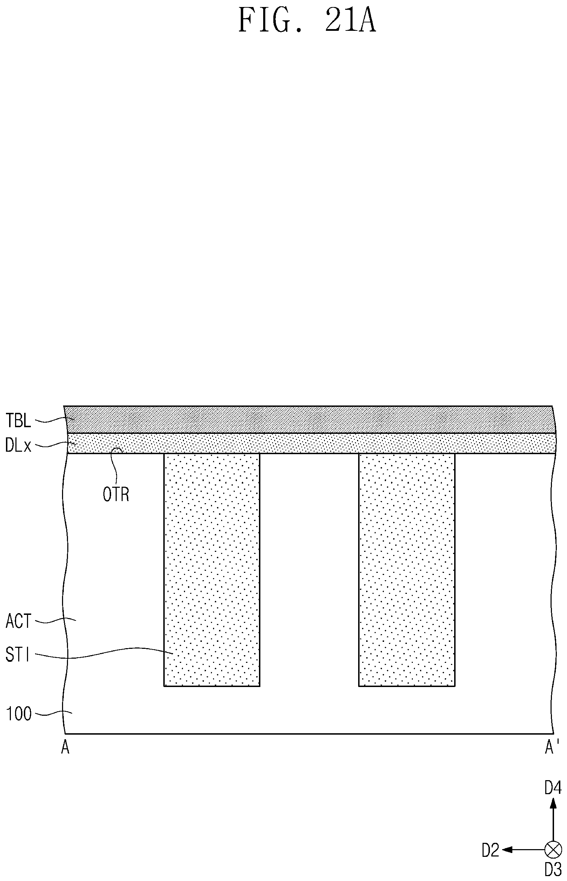

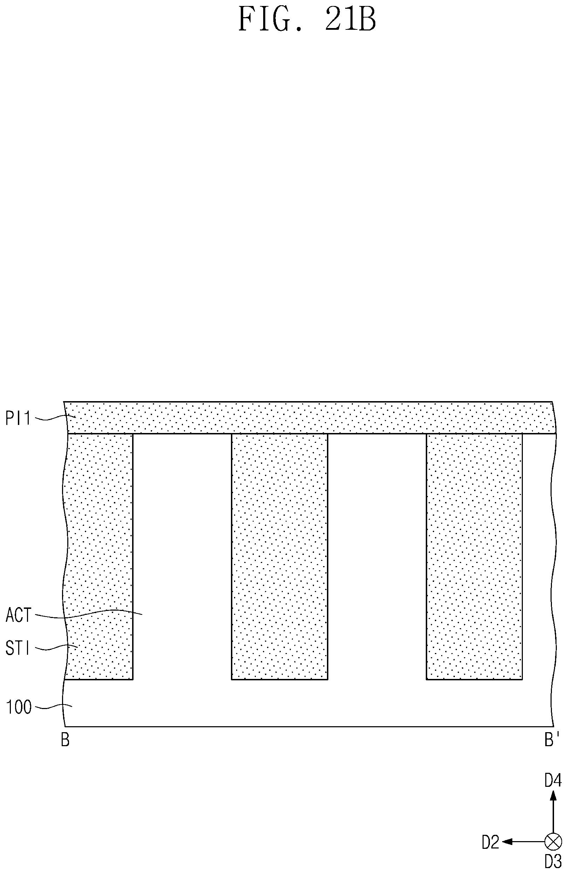

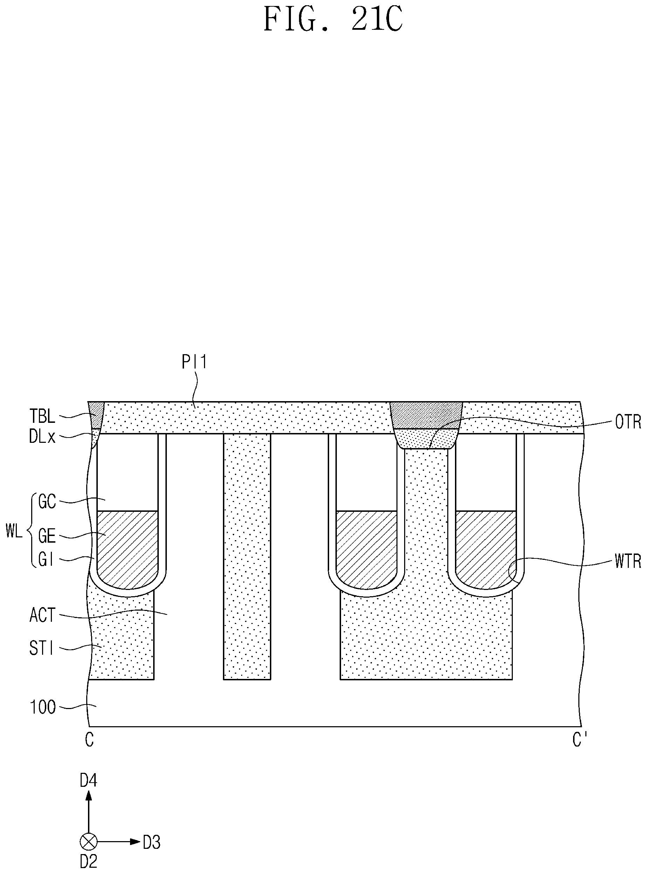

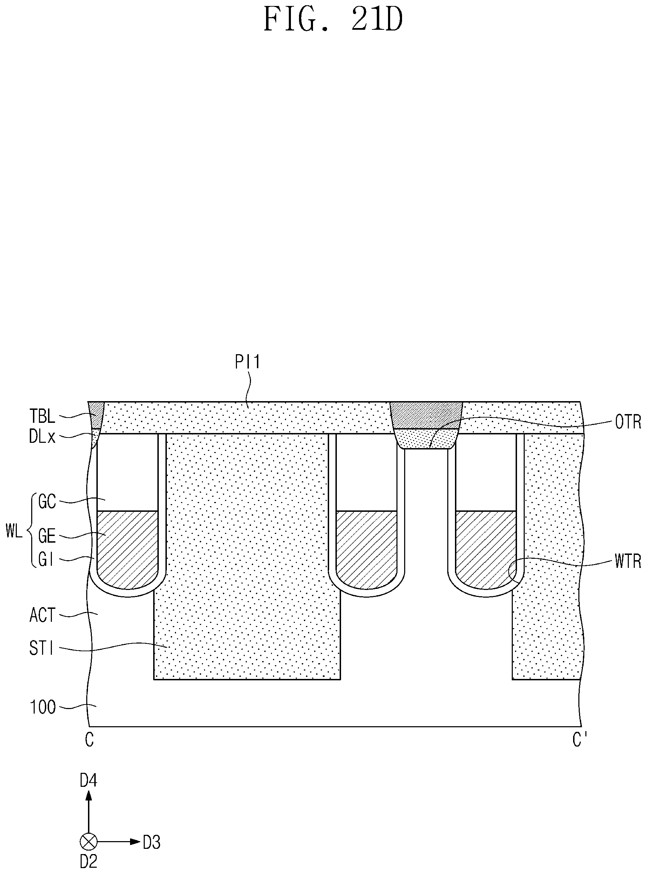

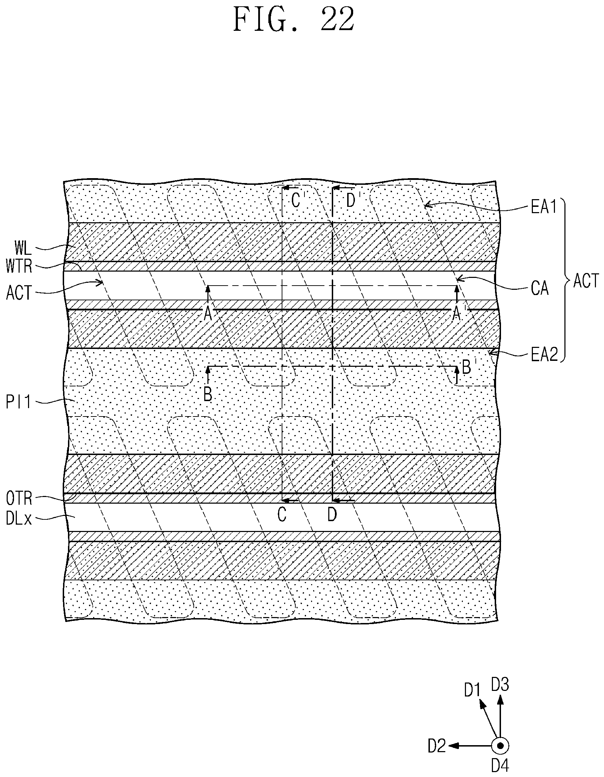

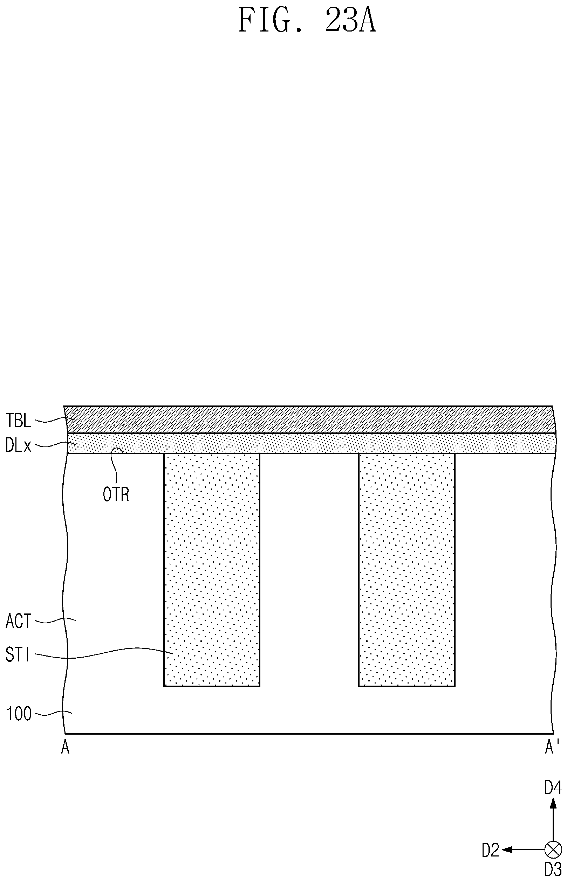

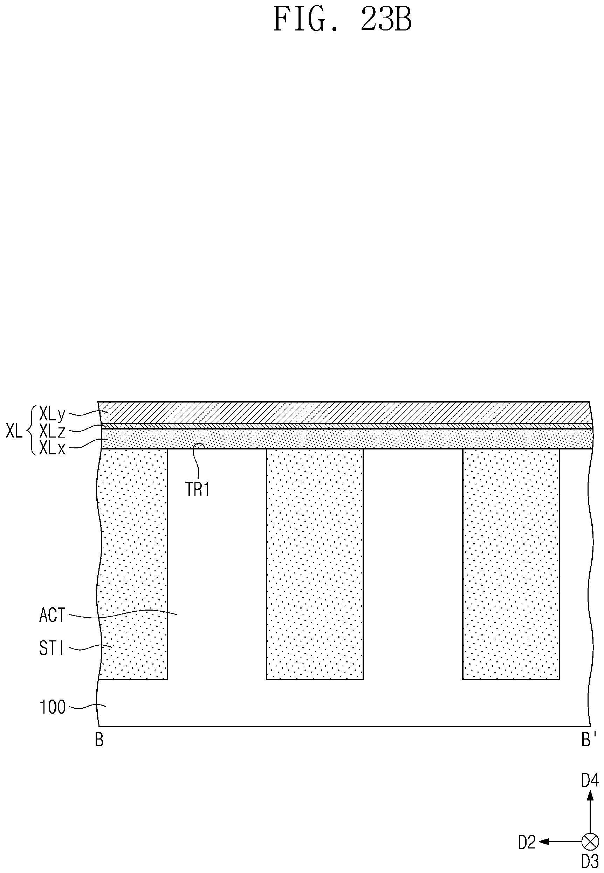

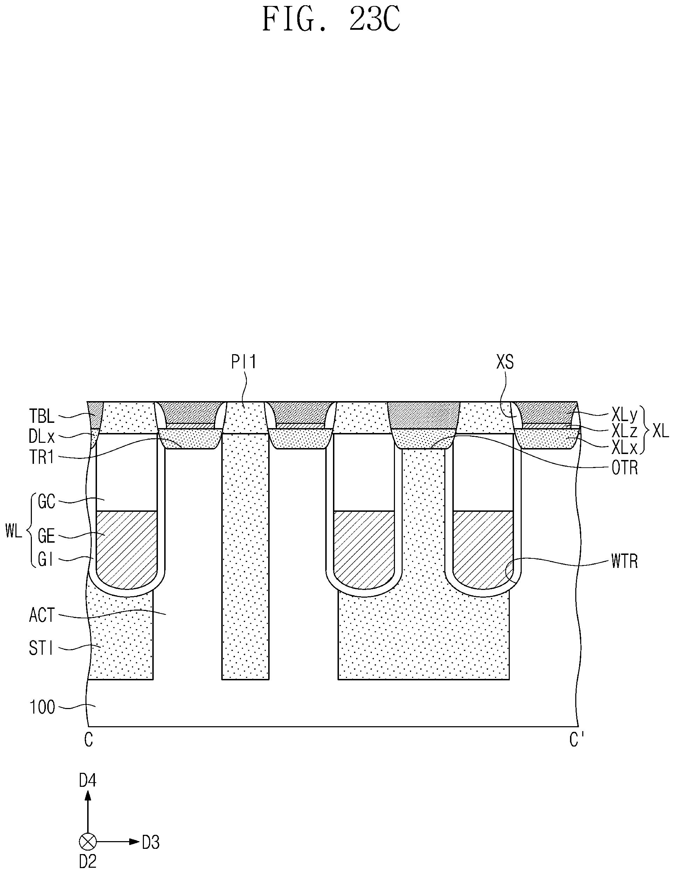

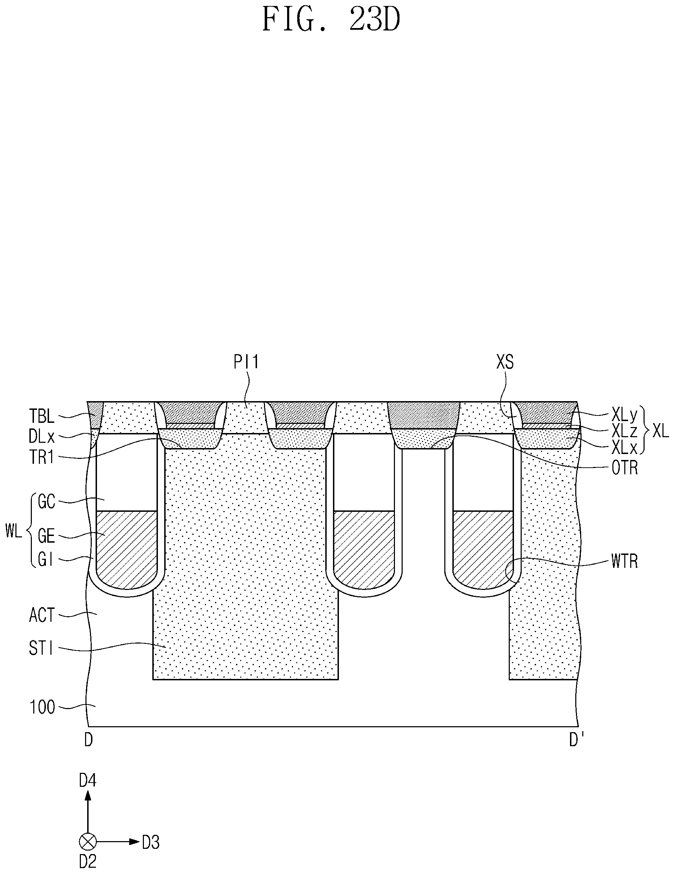

FIGS. 20, 21A to 21D, 22 and 23A to 23D illustrate diagrams showing a method of fabricating a semiconductor device discussed with reference to FIGS. 1, 2 and 3A to 3D, according to an example embodiment. For example, FIGS. 20 and 22 illustrate plan views showing a method of fabricating a semiconductor device discussed with reference to FIGS. 1, 2 and 3A to 3D. FIGS. 21A and 23A illustrate cross-sectional views taken along line A-A' of FIGS. 20 and 22, respectively. FIGS. 21B and 23B illustrate cross-sectional views taken along line B-B' of FIGS. 20 and 22, respectively. FIGS. 21C and 23C illustrate cross-sectional views taken along line C-C' of FIGS. 20 and 22, respectively. FIGS. 21D and 23D illustrate cross-sectional views taken along line D-D' of FIGS. 20 and 22, respectively.

Referring to FIGS. 20 and 21A to 21D, after the formation of the word line WL discussed with reference to FIGS. 9 to 10D, first pad dielectric patterns PI1 and open trench regions OTR may be formed on the active pattern ACT and the device isolation pattern STI. The formation of the first pad dielectric patterns PI1 may include forming a first pad dielectric layer (not shown) on an entire surface of the substrate 100, and performing an anisotropic etching process to etch the first pad dielectric layer to form the first pad dielectric patterns PI1 and the open trench regions OTR. The first pad dielectric patterns PI1 and the open trench regions OTR may extend along the second direction D2. The central part CA of the active pattern ACT may be exposed by the open trench region OTR. The first pad dielectric patterns PI1 may cover the first and second edge parts EA1 and EA2 of the active pattern ACT.

A lower contact line DLx may be formed in the open trench region OTR. The lower contact line DLx may fill a lower portion of the open trench region OTR. The lower contact line DLx may extend along the second direction D2. A trench buried line TBL may fill an upper portion of the open trench region OTR. The trench buried line TBL may extend along the second direction D2 on the lower contact line DLx.

Referring to FIGS. 22 and 23A to 23D, the first pad dielectric patterns PI1 may be etched to form first trench regions TR1. The first trench regions TR1 may extend along the second direction D2. The first trench regions TR1 may expose the first and second edge parts EA1 and EA2 of the active pattern ACT.

Pad lines XL may be formed to fill the first trench regions TR1. The pad lines XL may extend along the second direction D2 in the first trench regions TR1. The pad lines XL may cover the exposed first and second edge parts EA1 and EA2 of the active patterns ACT.

After that, a semiconductor fabrication method discussed above may be used to fabricate a semiconductor device discussed with reference to FIGS. 1 and 3A to 3D. In addition, when the trench buried pattern TB remains in fabricating the node trench region NTR is formed in a subsequent process, a semiconductor device of FIG. 4 may be fabricated.

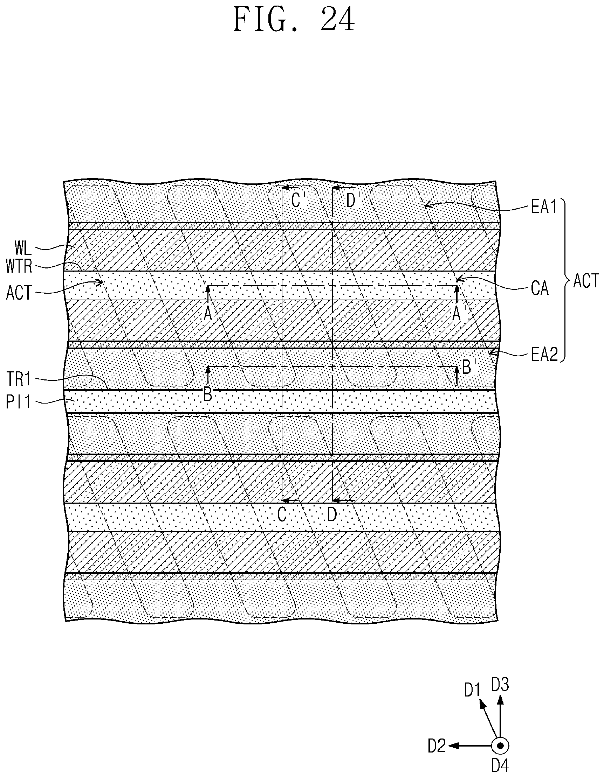

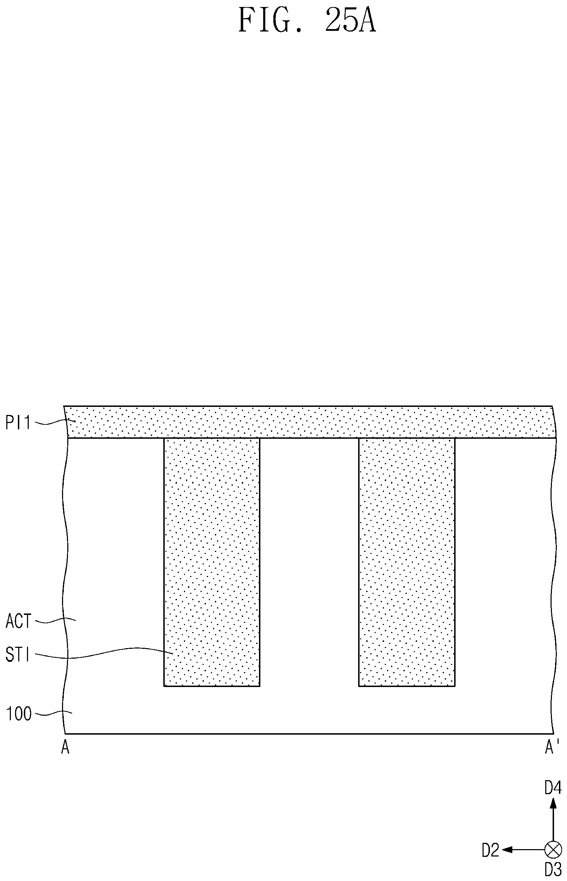

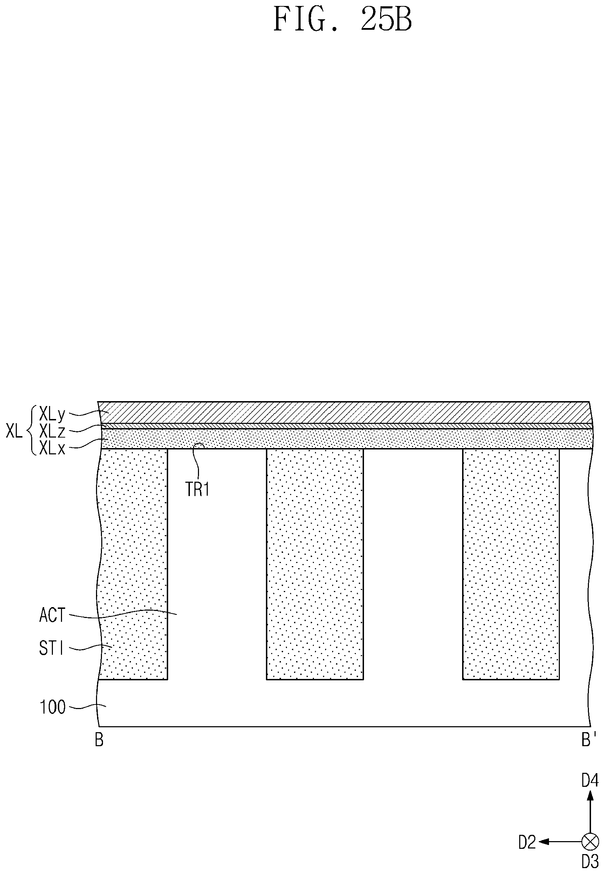

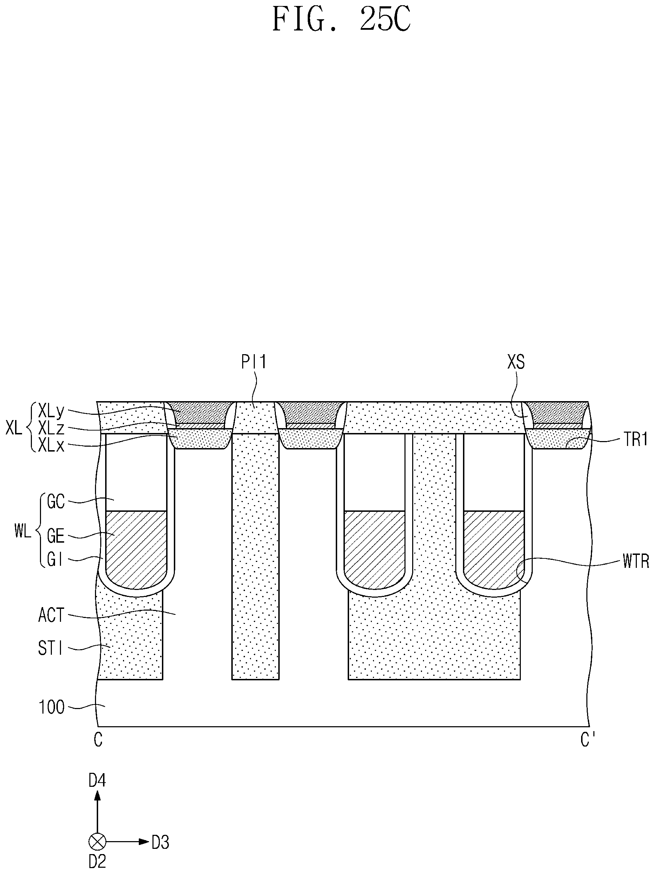

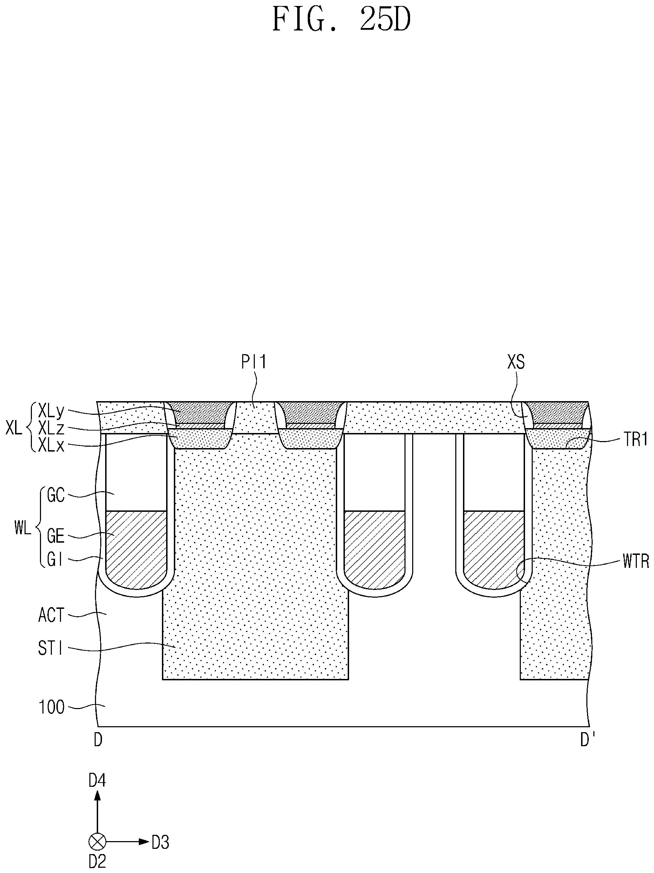

FIGS. 24 and 25A to 25D illustrate diagrams showing a method of fabricating a semiconductor device discussed with reference to FIGS. 1, 2 and 3A to 3D, according to an example embodiment. For example, FIG. 24 illustrates a plan view showing a method of fabricating a semiconductor device discussed with reference to FIGS. 1, 2 and 3A to 3D. FIGS. 25A, 25B, 25C, and 25D illustrate cross-sectional views taken along lines A-A', B-B', C-C', and D-D' of FIG. 24, respectively.

Referring to FIGS. 24 and 25A to 25D, after the formation of the word line WL discussed with reference to FIGS. 9 to 10D, first pad dielectric patterns PI1 and first trench regions TR1 may be formed on the active pattern ACT and the device isolation pattern STI. The first pad dielectric patterns PI1 and the first trench regions TR1 may extend along the second direction D2. The first pad dielectric patterns PI1 may cover the central part CA of the active pattern ACT. The first trench regions TR1 may expose the first and second edge parts EA1 and EA2 of the active pattern ACT.

Pad lines XL may be formed in the first trench regions TR1. The pad lines XL may extend along the second direction D2 in the first trench regions TR1. The pad lines XL may cover the exposed first and second edge parts EA1 and EA2 of the active patterns ACT.

Referring back to FIGS. 1, 2 and 3A to 3D, trench regions may be formed, and the central part CA of the active pattern ACT may be exposed. The trench regions may extend along the second direction D2. Node lines may be formed in the trench regions. Upper portions of the node lines may be removed, and a trench buried line may be formed.

After that, a semiconductor fabrication method discussed above may be used to fabricate a semiconductor device discussed with reference to FIGS. 1, 2 and 3A to 3D. In addition, when the trench buried pattern TB remains in the node trench region NTR, a semiconductor device of FIG. 4 may be fabricated.

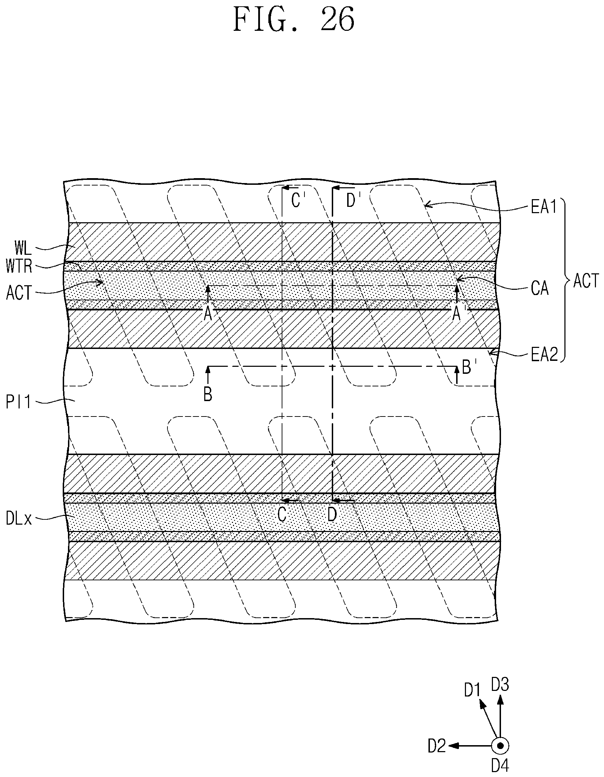

FIGS. 26, 27A to 27D, 28, 29A to 29D, 30, 31A to 31D, 32 and 33A to 33D illustrate diagrams showing a method of fabricating a semiconductor device discussed with reference to FIG. 5, according to an example embodiment.

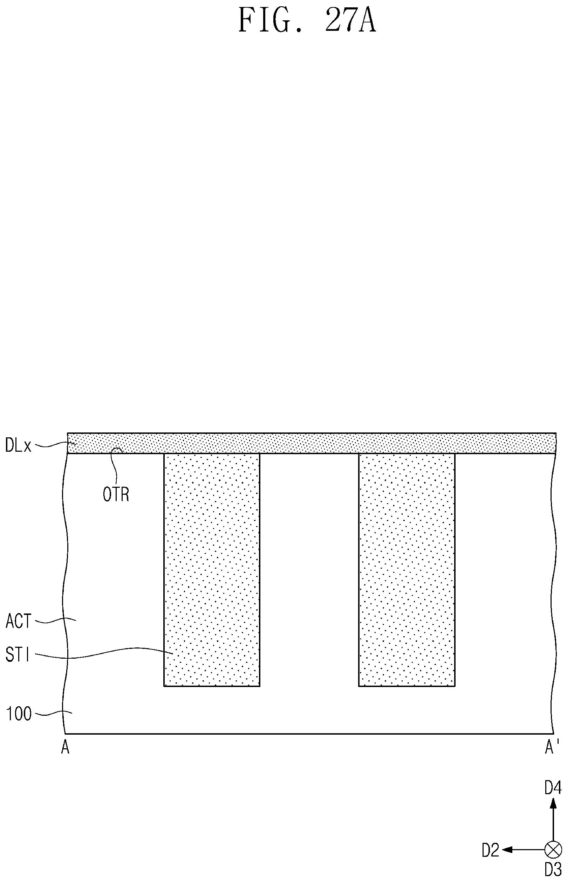

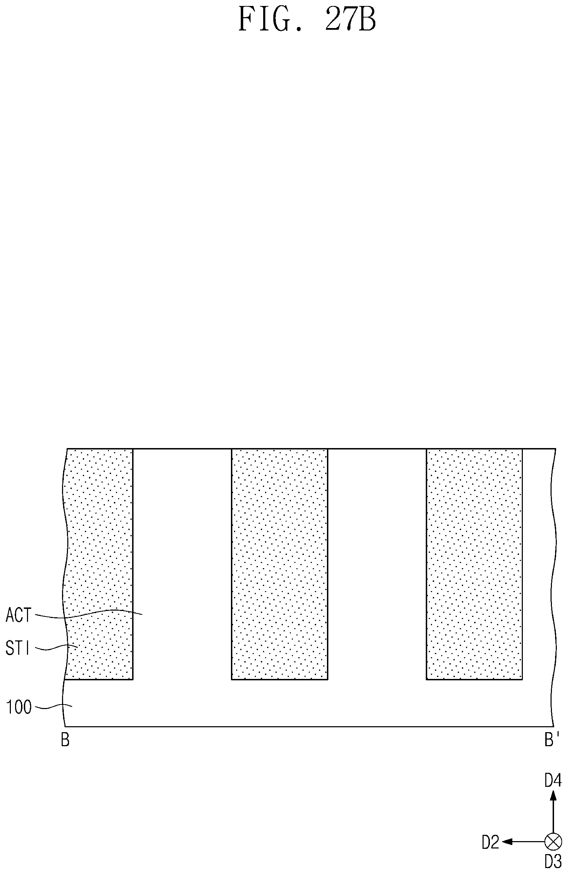

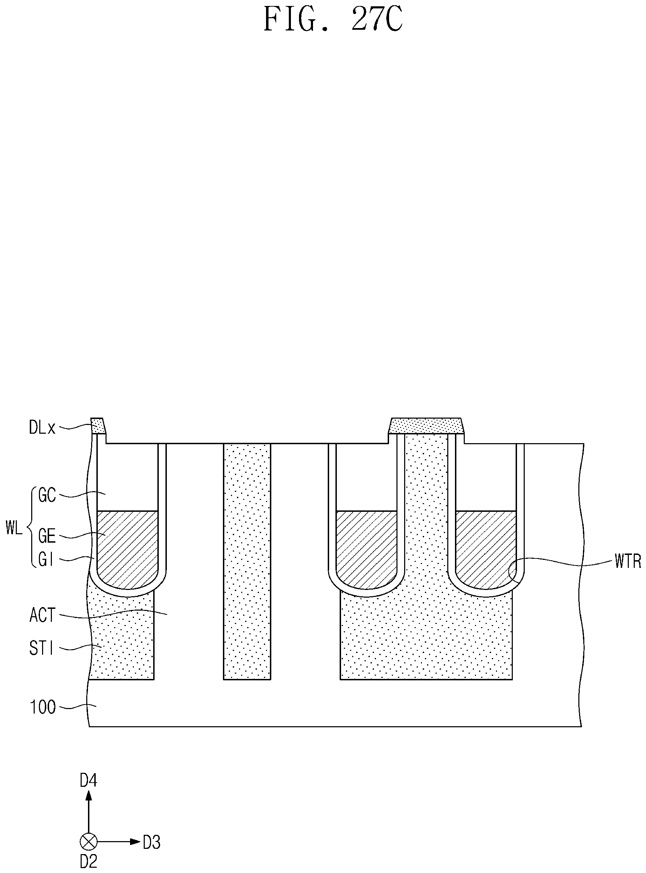

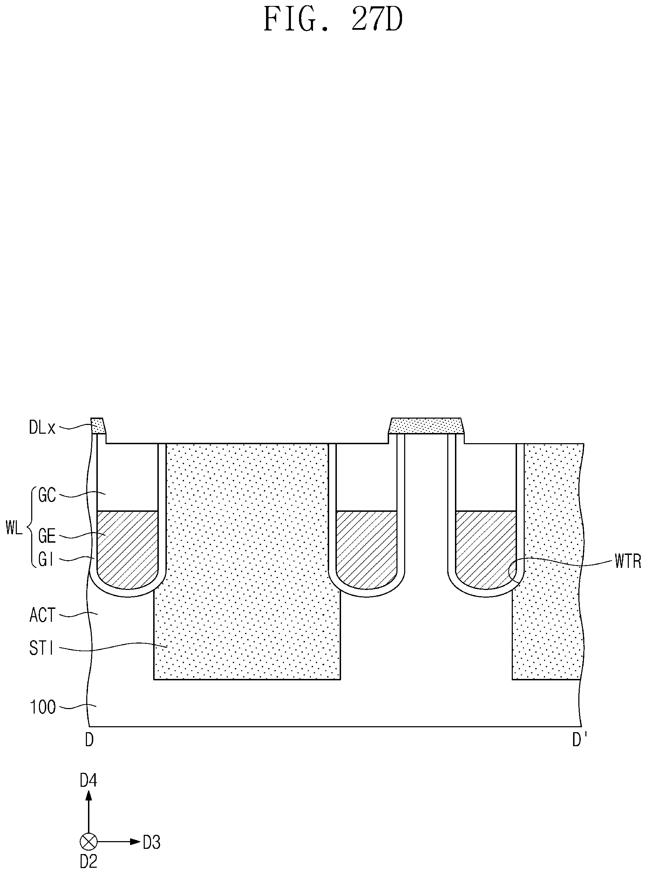

Referring to FIGS. 26 and 27A to 27D, after the formation of the word line WL discussed with reference to FIGS. 9 and 10A to 10D, a lower contact layer (not shown) may be formed on the active pattern ACT and the device isolation pattern STI. The lower contact layer may be formed on an entire surface of the substrate 100.

The lower contact layer may be etched to form lower contact lines DLx. The lower contact lines DLx may extend along the second direction D2 and may be spaced apart from each other in the third direction D3. Each of the lower contact lines DLx may be formed on the central parts CA of the active pattern ACT disposed side by side (or arranged) along the second direction D2. The lower contact lines DLx may cover the central parts CA of the active patterns ACT. The lower contact lines DLx may expose the first and second edge parts EA1 and EA2 of the active patterns ACT. For example, an etching process of the lower contact layer may recess an upper portion (e.g., upper portions of the first and second edge parts EA1 and EA2) of the active pattern ACT, an upper portion of the device isolation pattern STI, and an upper portion of the word line WL.

As the lower contact line DLx is formed by an embossing process in which the lower contact layer is used, a width in the third direction D3 of the lower contact line DLx may be changed in accordance with level. For example, a width in the third direction D3 of the lower contact line DLx may increase as a level is lowered. In the third direction D3, a width at a bottom surface of the lower contact line DLx may be greater than that at a top surface of the lower contact line DLx.

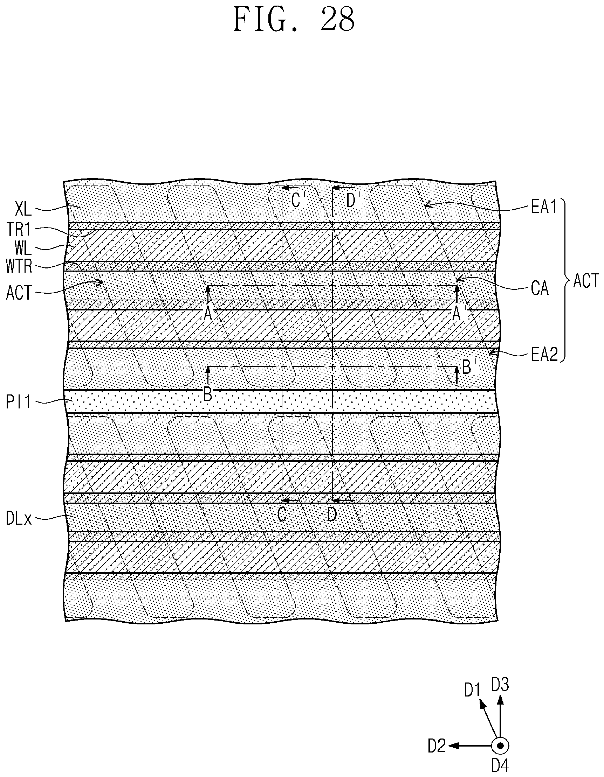

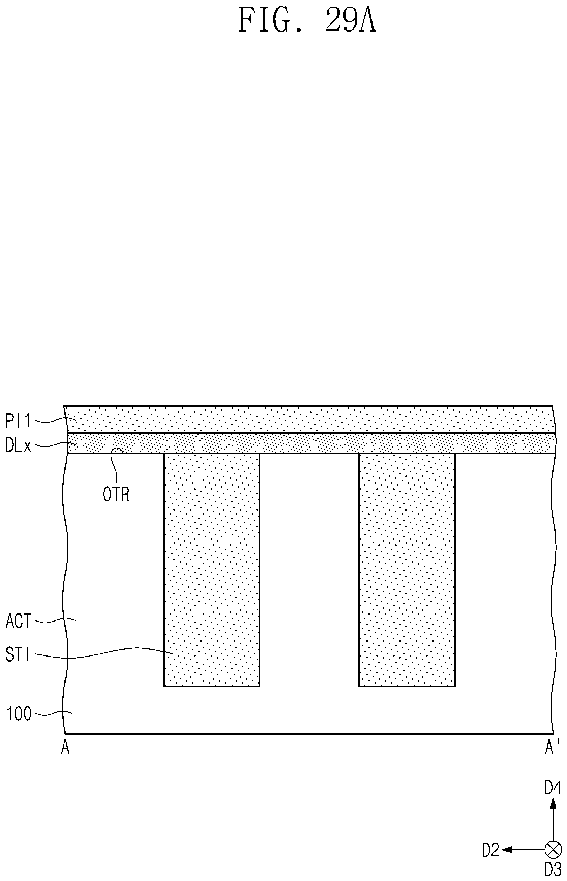

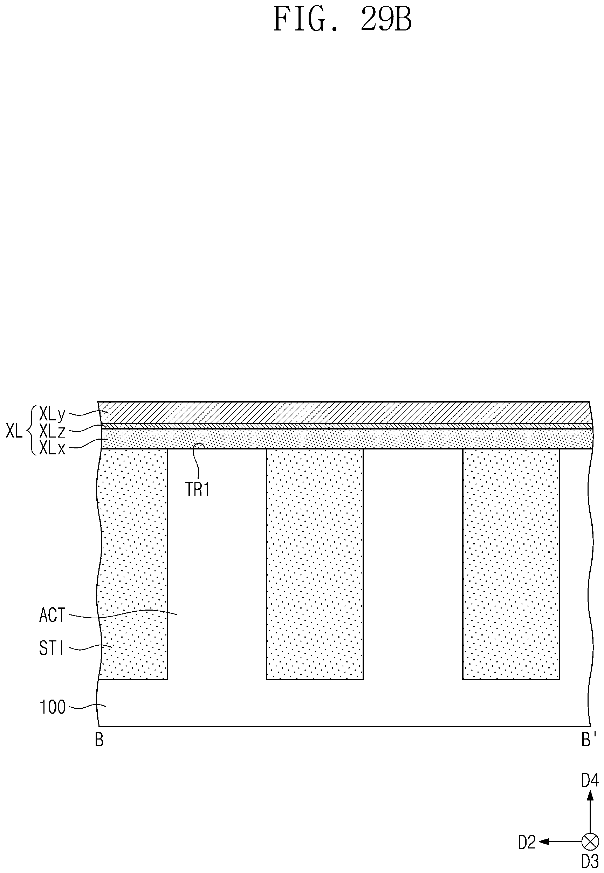

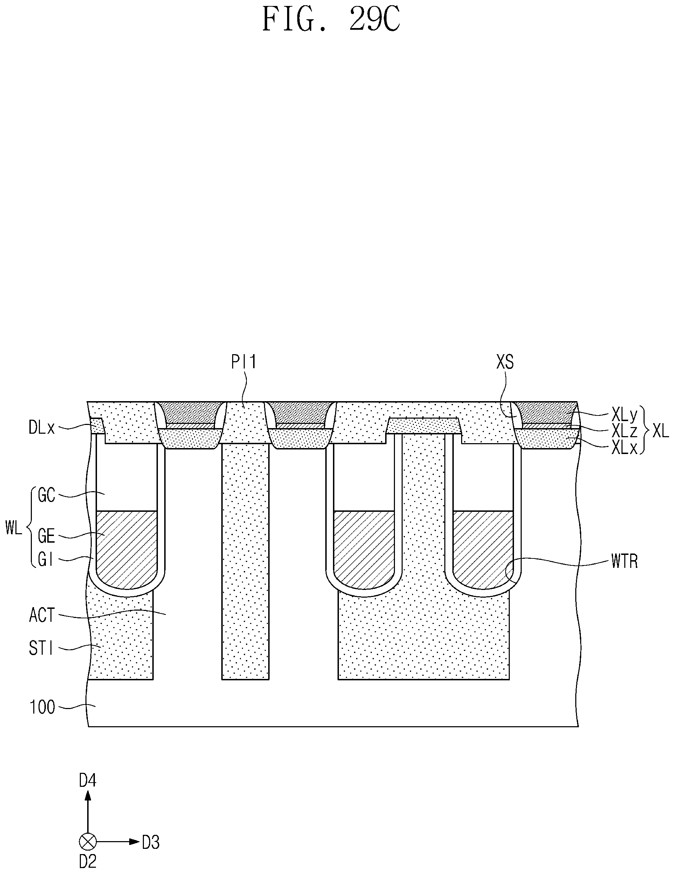

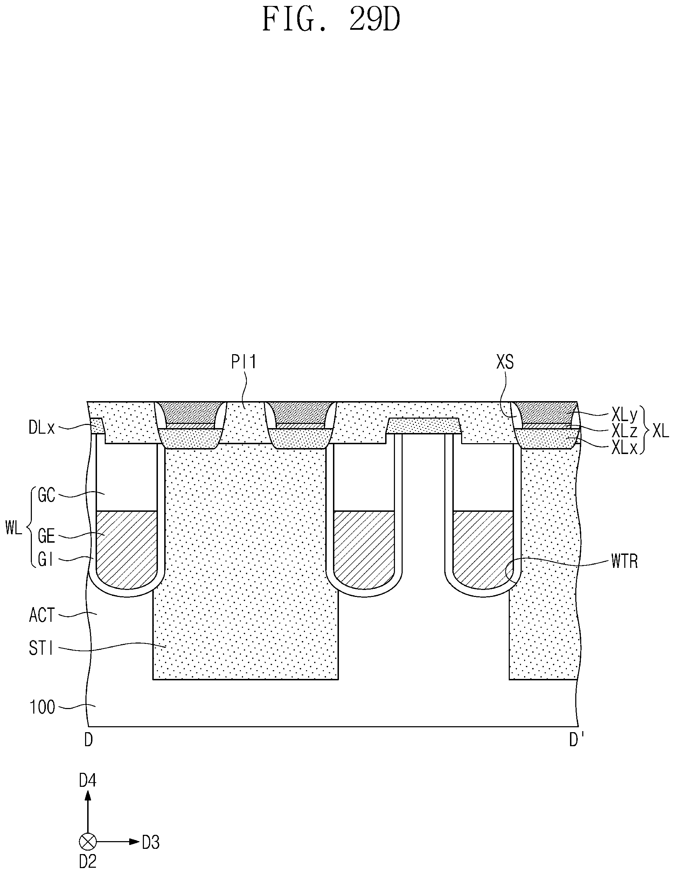

Referring to FIGS. 28 and 29A to 29D, a first pad dielectric pattern PI1 may be formed on an entire surface of the substrate 100. The first pad dielectric pattern PI1 may cover the lower contact line DLx. The first pad dielectric pattern PI1 may fill a recess formed on an upper portion of the active pattern ACT.

The first pad dielectric pattern PI1 may be etched, and first trench regions TR1 may be formed. The first trench regions TR1 may have their bottom surfaces located at a lower level than that of a bottom surface of the lower contact line DLx. The first trench regions TR1 may expose the first and second edge parts EA1 and EA2 of the active patterns ACT. Pad lines XL may be formed in the first trench regions TR1. The pad lines XL may cover the exposed first and second edge parts EA1 and EA2 of the active patterns ACT.

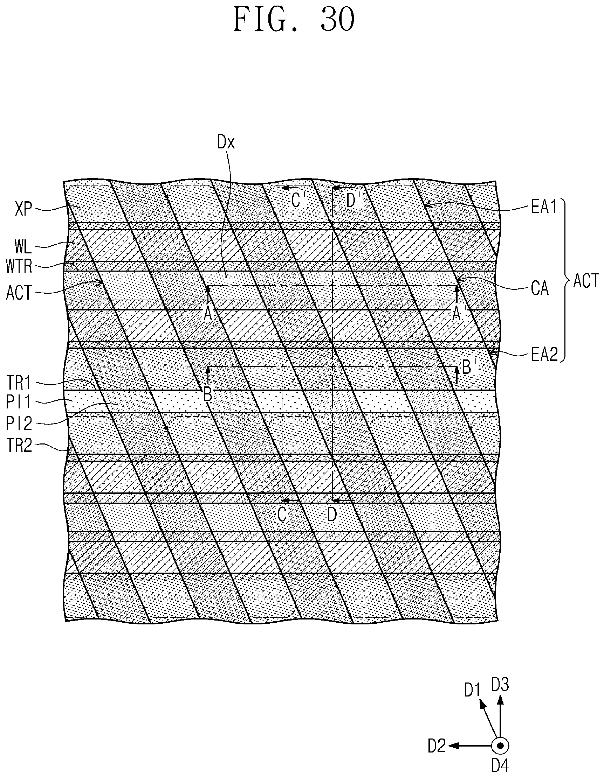

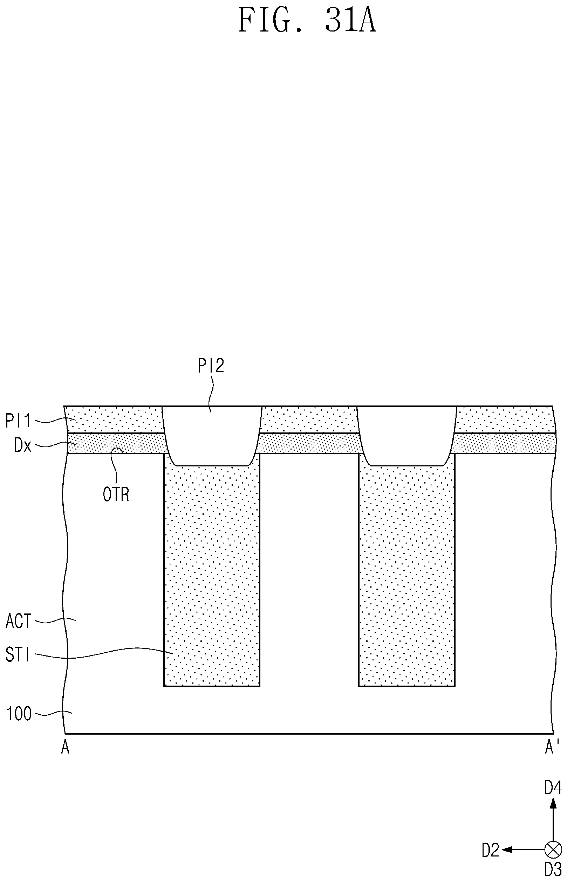

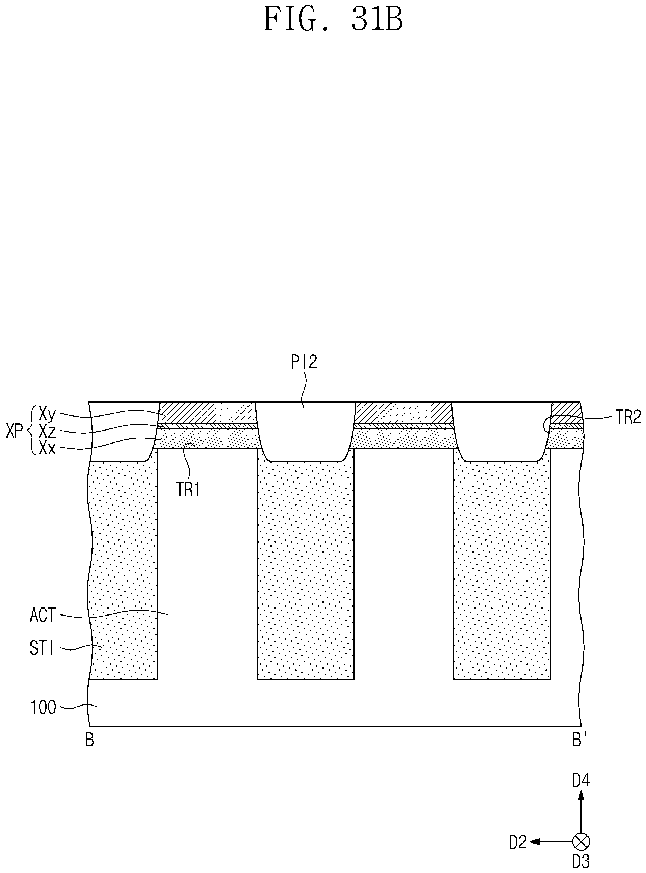

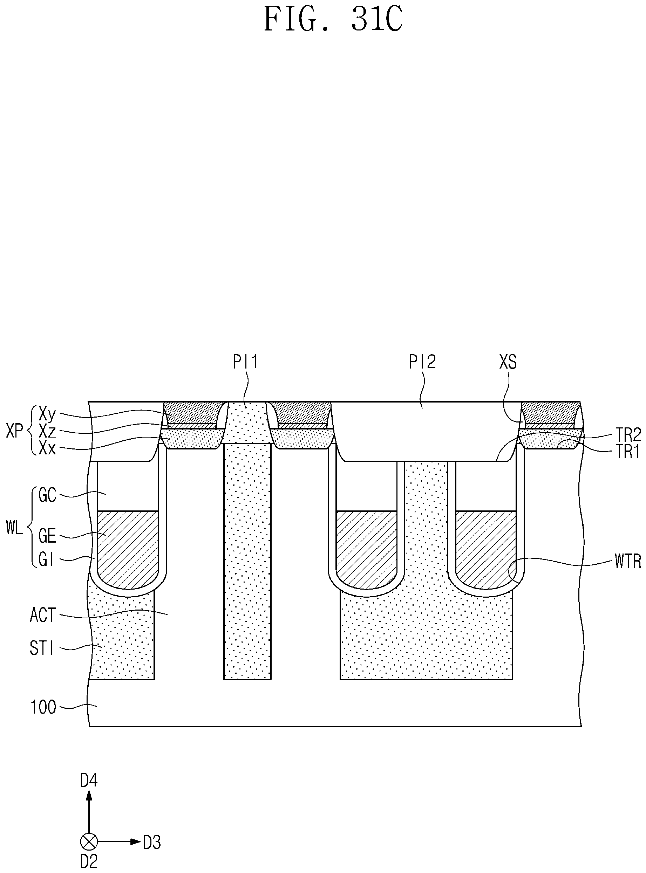

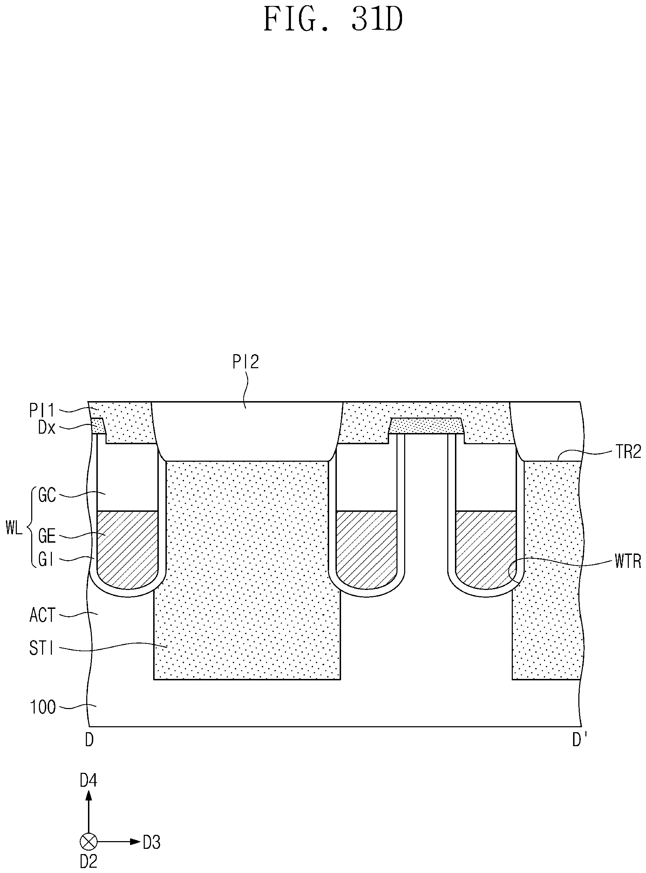

Referring to FIGS. 30 and 31A to 31D, second trench regions TR2 may be formed, and second pad dielectric patterns PI2 may be formed in the second trench regions TR2. As the second trench regions TR2 are formed, each of the pad lines XL may be separated into storage node pads XP, and each of the lower contact lines DLx may be separated into lower contacts Dx.

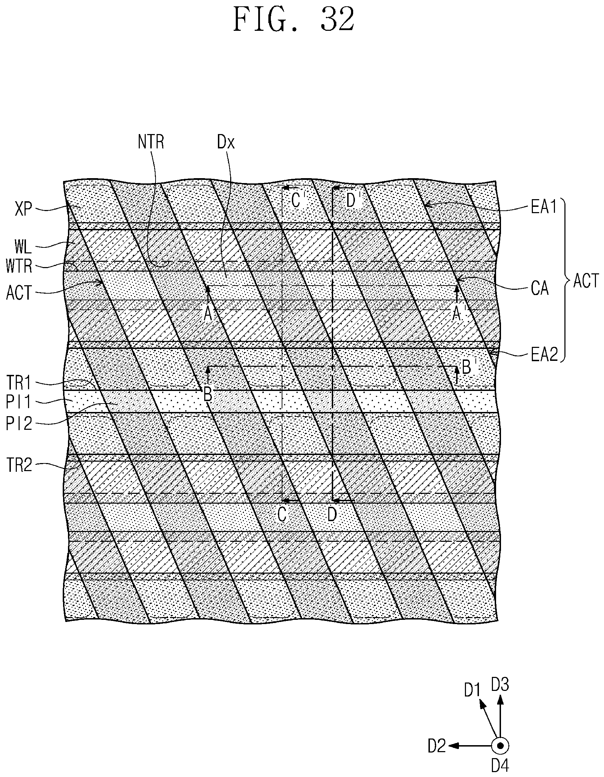

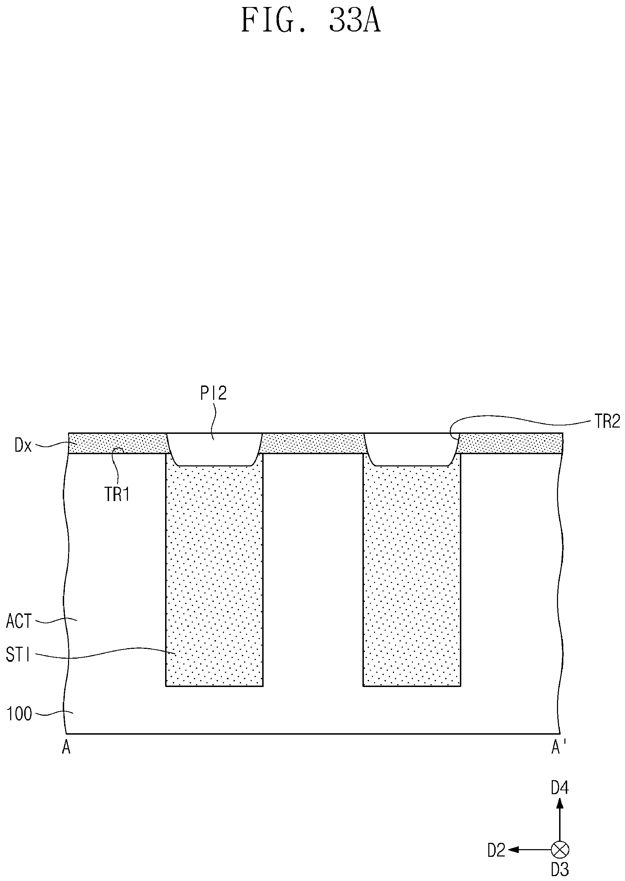

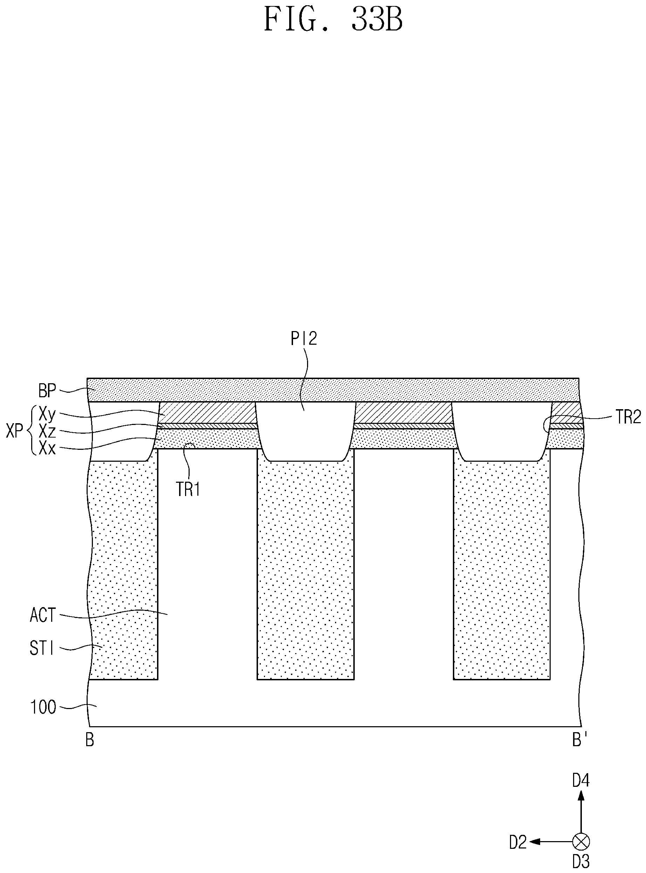

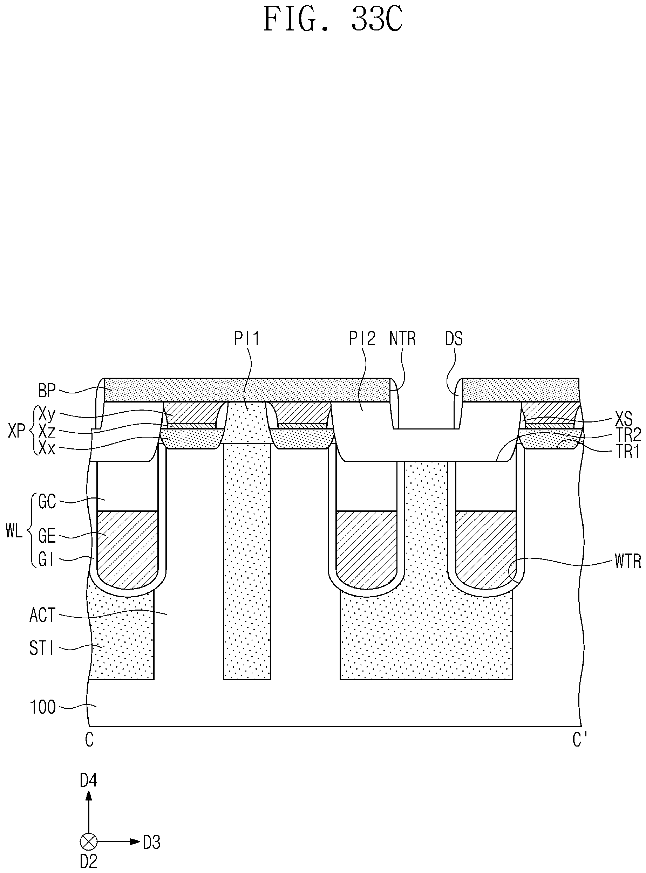

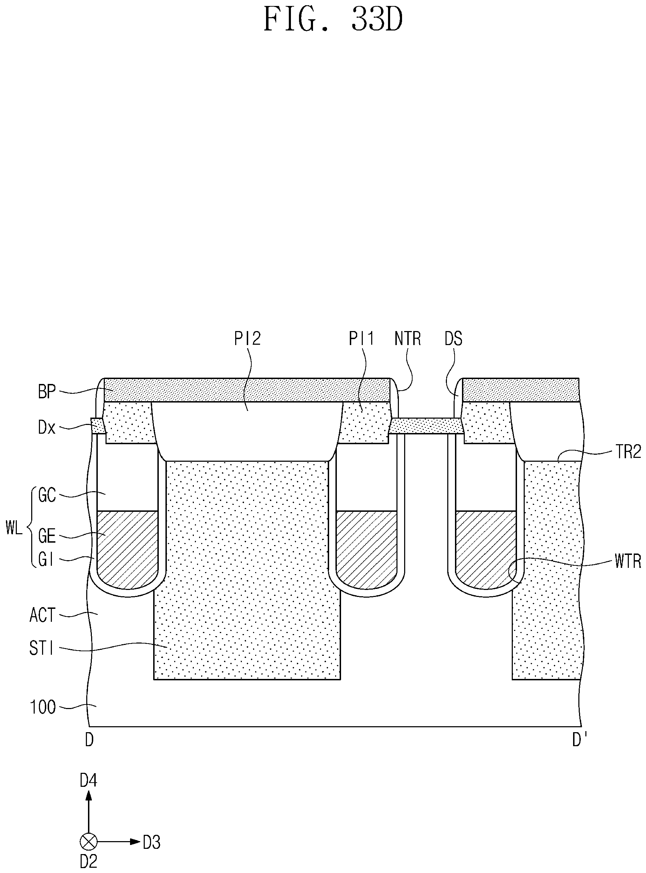

Referring to FIGS. 32 and 33A to 33D, a buffer pattern BP may be formed to cover an entire surface of the substrate 100. For example, the buffer pattern BP may cover the storage node pads XP and the first and second pad dielectric patterns PI1 and PI2.

Afterwards, node trench regions NTR may be formed. The formation of the node trench regions NTR may include removing the first pad dielectric pattern PI1 on the lower contacts Dx. Thus, top surfaces of the lower contacts Dx may be exposed. A bit-line node spacer DS may be formed on inner sidewalls of the node trench regions NTR.

Thereafter, a semiconductor fabrication method discussed above may be used to fabricate a semiconductor device discussed with reference to FIG. 5.

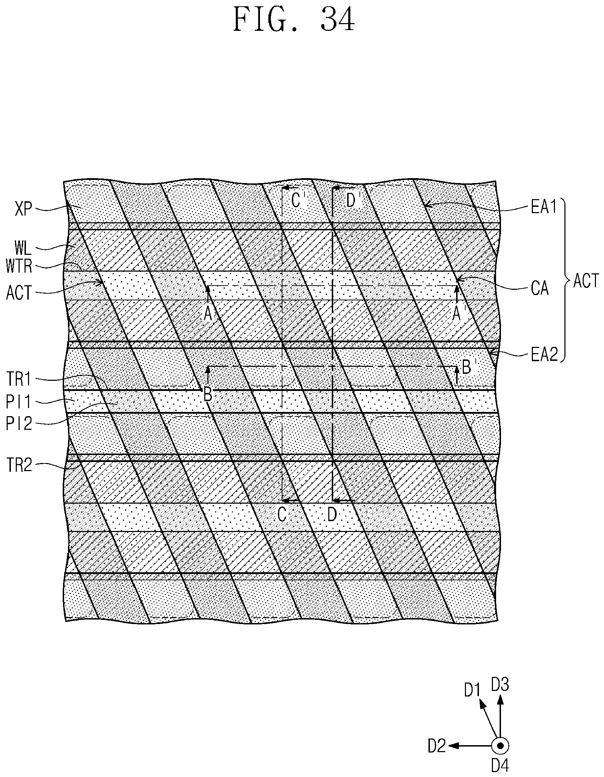

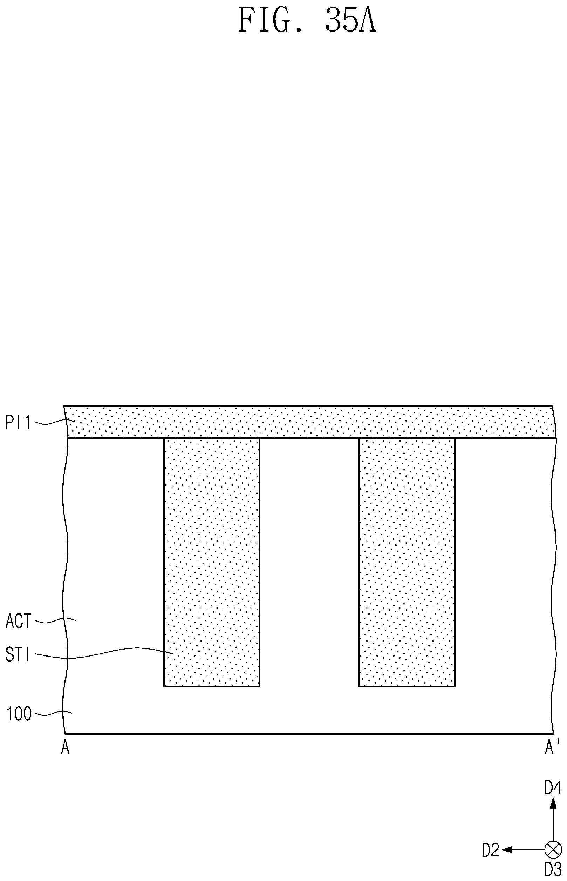

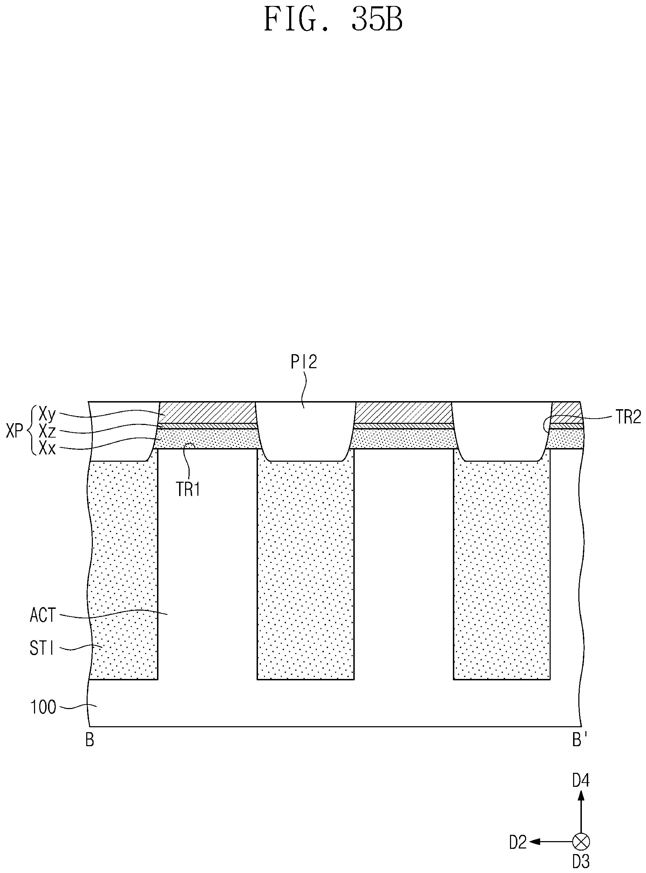

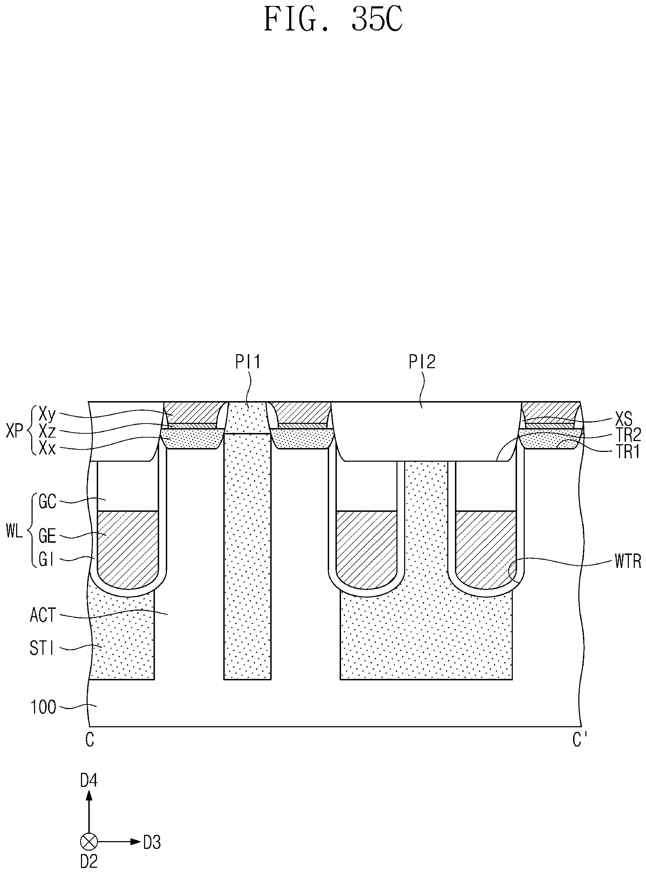

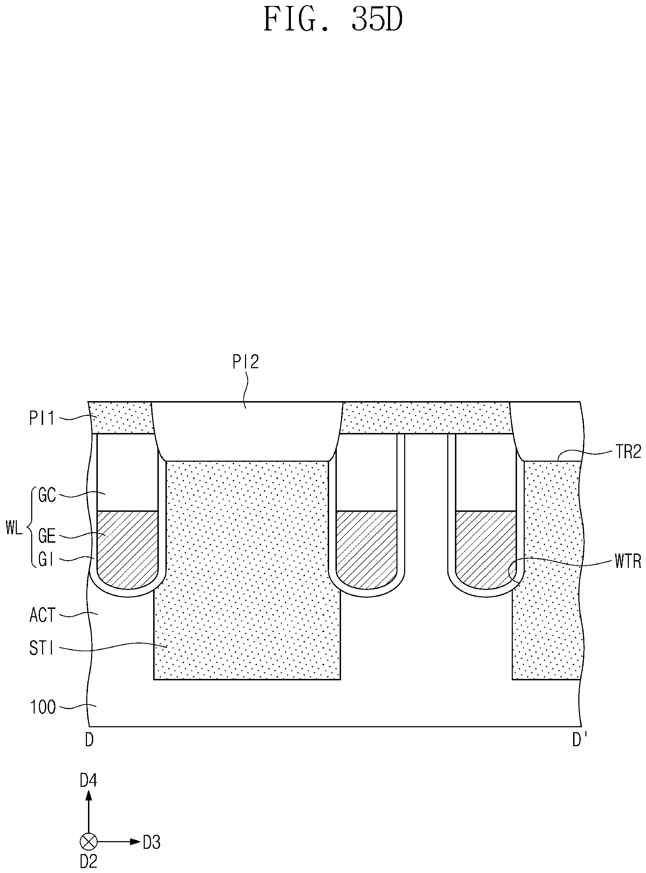

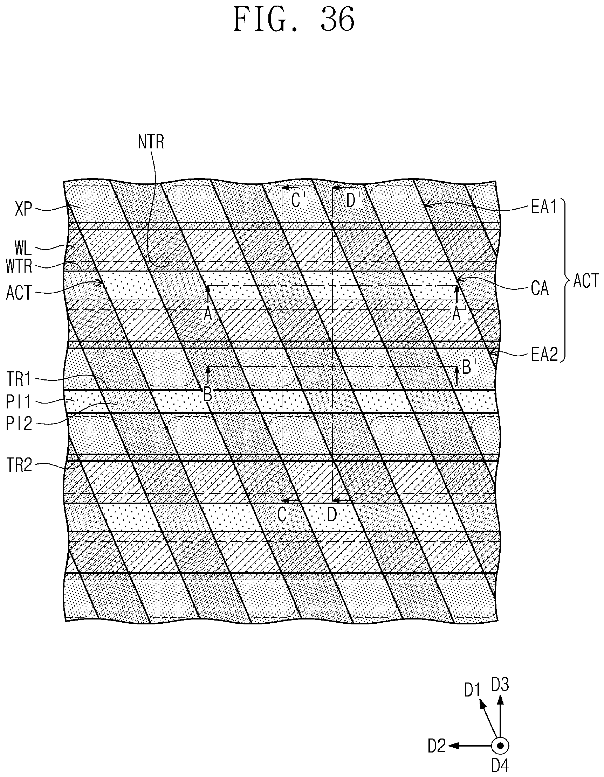

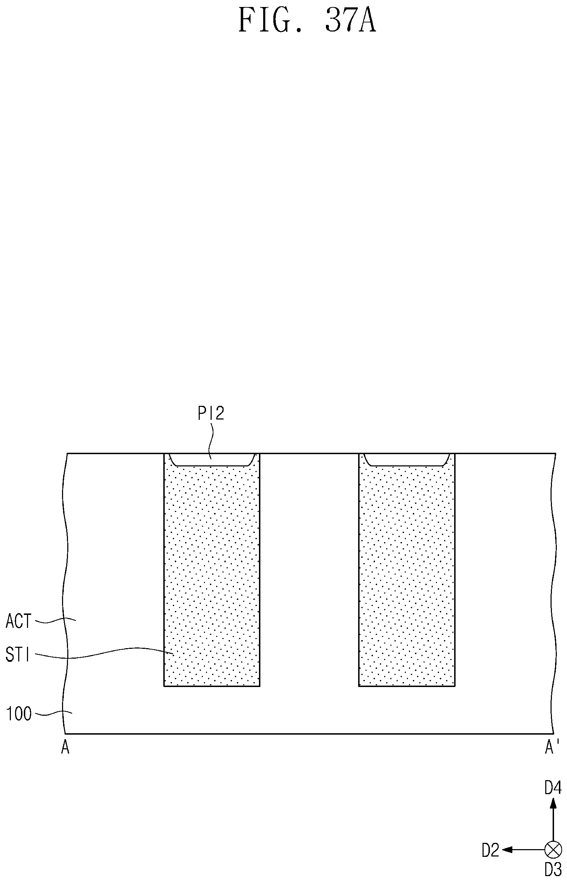

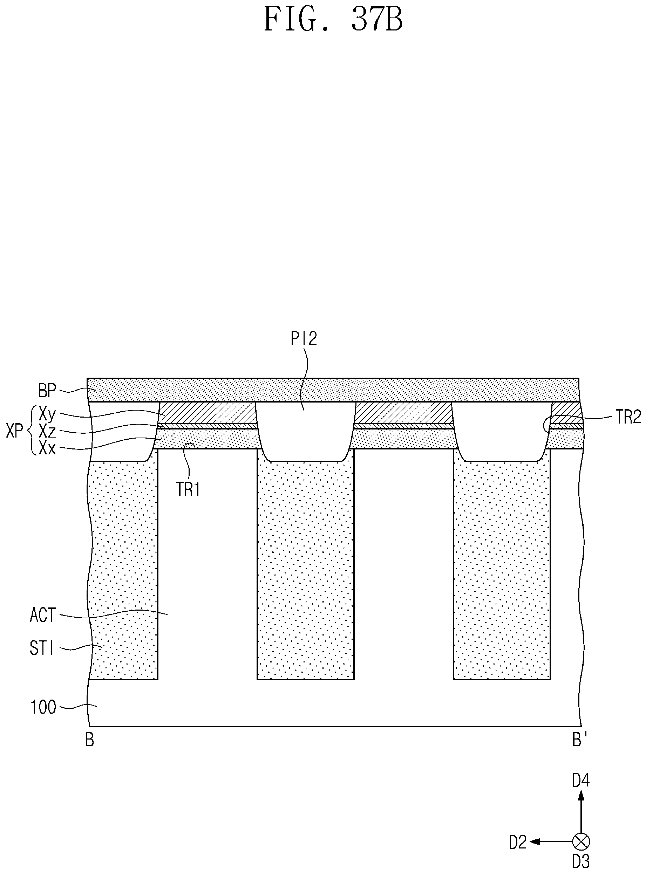

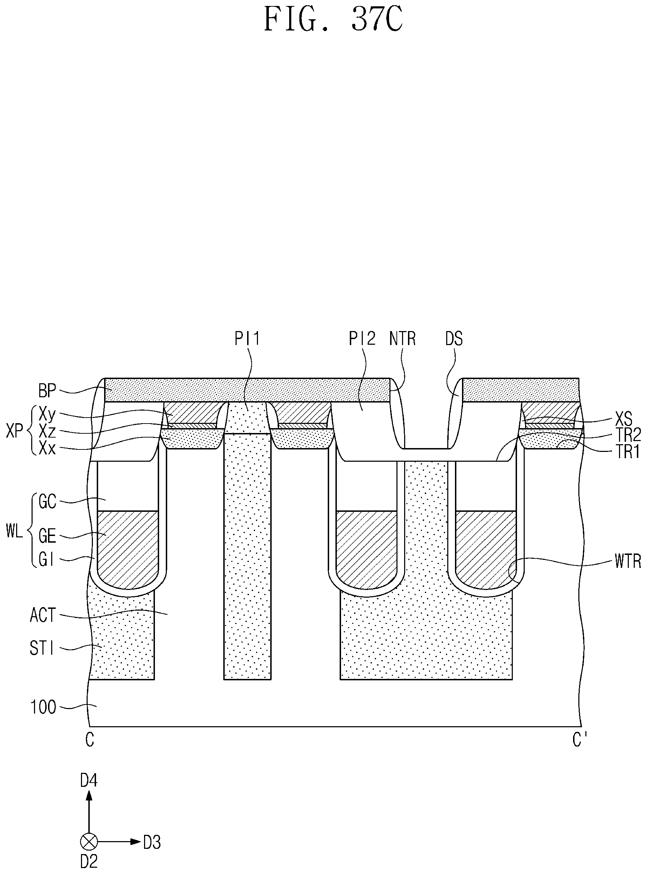

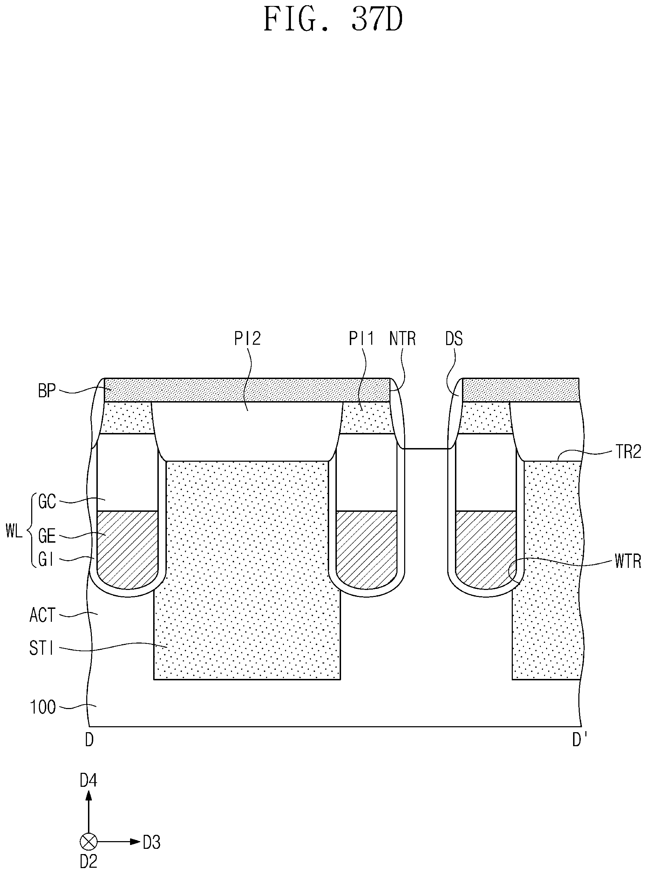

FIGS. 34, 35A to 35D, 36 and 37A to 37D illustrate diagrams showing a method of fabricating a semiconductor device discussed with reference to FIGS. 6A and 6B, according to an example embodiment. For example, FIGS. 34 and 36 illustrate plan views showing a method of fabricating a semiconductor device discussed with reference to FIGS. 6A and 6B. FIGS. 35A and 37A illustrate cross-sectional views taken along line A-A' of FIGS. 34 and 36, respectively. FIGS. 35B and 37B illustrate cross-sectional views taken along line B-B' of FIGS. 34 and 36, respectively. FIGS. 35C and 37C illustrate cross-sectional views taken along line C-C' of FIGS. 34 and 36, respectively. FIGS. 35D and 37D illustrate cross-sectional views taken along line D-D' of FIGS. 34 and 36, respectively.

Referring to FIGS. 34 and 35A to 35D, after the formation of the pad lines XL discussed with reference to FIGS. 24 and 25A to 25D, second trench regions TR2 may be formed. Second pad dielectric patterns PI2 may be formed in the second trench regions TR2. In this step, each of the pad lines XL may be separated into a plurality of storage node pads XP.

Referring to FIGS. 36 and 37A to 37D, a buffer pattern BP may be formed on an entire surface of the substrate 100. For example, the buffer pattern BP may cover the storage node pads XP and the first and second pad dielectric patterns PI1 and PI2.

Afterwards, node trench regions NTR may be formed. The formation of the node trench regions NTR may include removing the first pad dielectric pattern PI1 on the central part CA of the active pattern ACT. Thus, the central part CA of the active pattern ACT may be exposed.

A bit-line node spacer DS may be formed on inner sidewalls of the node trench regions NTR. For example, the bit-line node spacer DS may cover a lateral surface of the buffer pattern BP and may extend onto a lateral surface of the first pad dielectric pattern PI1. For another example, the bit-line node spacer DS may further extend onto a lateral surface of an upper portion of the word line WL. The bit-line node spacer DS may not cover but expose at least a portion of the central part CA of the active pattern ACT.

Referring back to FIGS. 6A and 6B, a bit-line node contact DC may be formed between the bit-line node spacers DS. For example, a lower contact Dx of the bit-line node spacer DS may formed between the bit-line node spacers DS.

Afterwards, a semiconductor fabrication method discussed above may be used to fabricate a semiconductor device discussed with reference to FIGS. 6A and 6B.

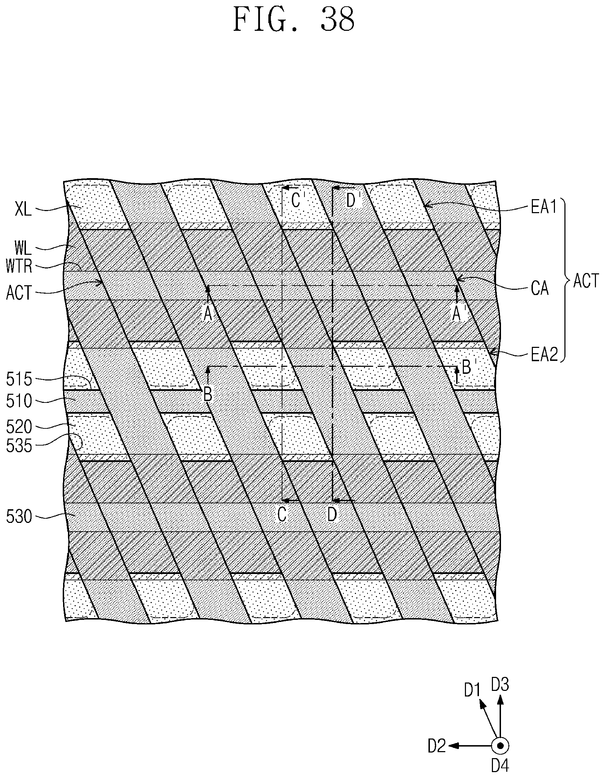

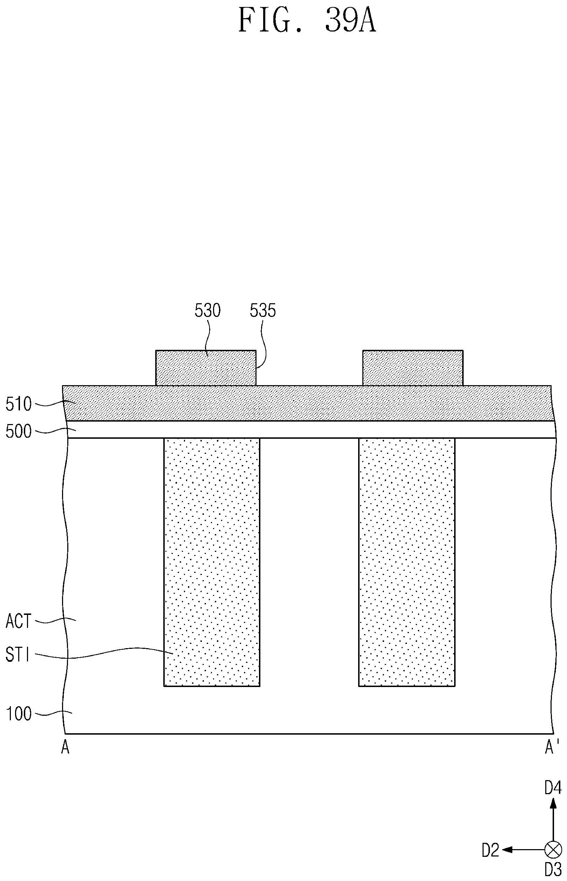

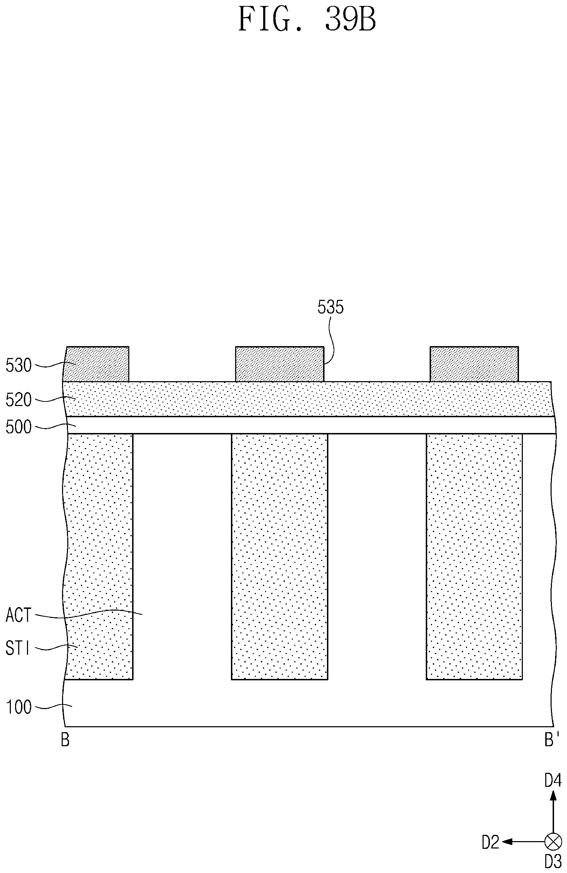

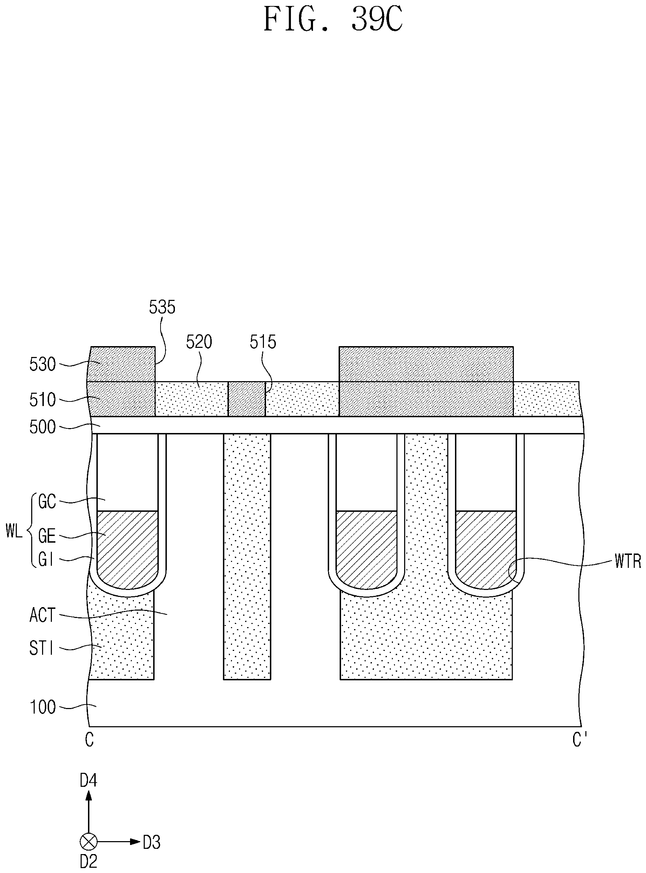

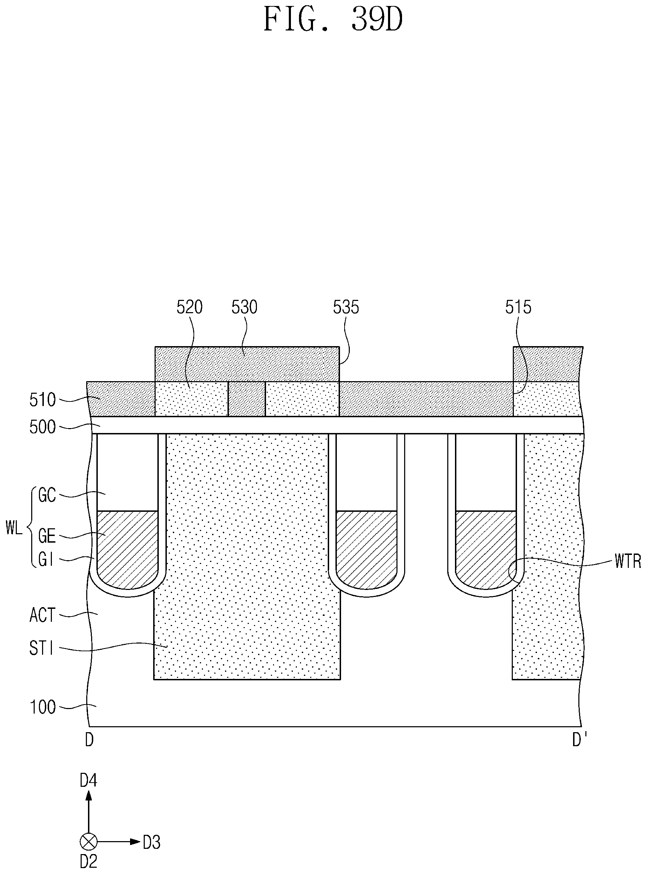

FIGS. 38, 39A to 39D, 40, 41A to 41D, 42 and 43A to 43D illustrate diagrams showing a method of fabricating a semiconductor device discussed with reference to FIGS. 7A to 7D or FIGS. 8A and 8B, according to an example embodiment. For example, FIGS. 38, 40, and 42 illustrate plan views showing a method of fabricating a semiconductor device discussed with reference to FIGS. 7A to 7D or 8A and 8B. FIGS. 39A, 41A, and 43A illustrate cross-sectional views corresponding to line A-A' of FIGS. 38, 40, and 42, respectively. FIGS. 39B, 41B, and 43B illustrate cross-sectional views corresponding to line B-B' of FIGS. 38, 40, and 42, respectively. FIGS. 39C, 41C, and 43C illustrate cross-sectional views corresponding to line C-C' of FIGS. 38, 40, and 42, respectively.

Referring to FIGS. 38 and 39A to 39D, after the formation of the word line WL discussed with reference to FIGS. 9 and 10A to 10D, a sacrificial layer 500 may be formed on an entire surface of the substrate 100. The sacrificial layer 500 may be a single layer formed of a single material or a composite layer including two or more materials. For example, the sacrificial layer 500 may include at least one of silicon nitride and silicon oxide.

First mask patterns 510 may be formed on the sacrificial layer 500. The formation of the first mask patterns 510 may include forming a first mask layer (not shown) on the sacrificial layer 500, and performing an anisotropic etching process to divide the first mask layer into the first mask patterns 510. The first mask patterns 510 may extend along the second direction D2 and may be spaced apart from each other in the third direction D3. The first mask patterns 510 may cover the central parts CA of the active patterns ACT.

The etching process of the first mask layer may form first mask trench regions 515 between the first mask patterns 510. The first mask trench regions 515 may extend along the second direction D2, and may separate the first mask patterns 510 from each other in the third direction D3. The first mask trench regions 515 may be formed on the first and second edge parts EA1 and EA2 of the active patterns ACT. For example, a portion of the sacrificial layer 500 may be exposed by the first mask trench regions 515.

Mask filling patterns 520 may be formed in the first mask trench regions 515. The mask filling patterns 520 may fill the first mask trench regions 515. The mask filling patterns 520 may extend along the second direction D2 and may be spaced apart from each other in the third direction D3. The mask filling patterns 520 may be formed on the first and second edge parts EA1 and EA2 of the active patterns ACT. For example, the mask filling patterns 520 may cover the exposed portion of the sacrificial layer 500. The mask filling patterns 520 may have their top surfaces that are located at substantially the same as that of top surfaces of the first mask patterns 510 and are coplanar with those of the first mask patterns 510.

Second mask patterns 530 may be formed on the first mask patterns 510 and the mask filling patterns 520. The formation of the second mask patterns 530 may include forming a second mask layer (not shown) on the entire surface of the substrate 100, and performing an anisotropic etching process to divide the second mask layer into the second mask patterns 530. The second mask patterns 530 may extend along the first direction D1.

The etching process of the second mask layer may form second mask trench regions 535 between the second mask patterns 530. The second mask trench regions 535 may extend along the first direction D1. The second mask trench regions 535 may be formed on the active patterns ACT. The second mask trench regions 535 may expose portions of the first mask patterns 510 and portions of the mask filling patterns 520.

The mask filling pattern 520 may include a material having an etch selectivity with respect to the first and second mask patterns 510 and 530. The first and second mask patterns 510 and 530 may include the same material, but the present inventive concepts are not limited thereto. For example, the first and second mask patterns 510 and 530 may include silicon oxide, and the mask filling pattern 520 may include polysilicon having an etch selectivity with respect to silicon oxide. The present inventive concepts are not however limited thereto.

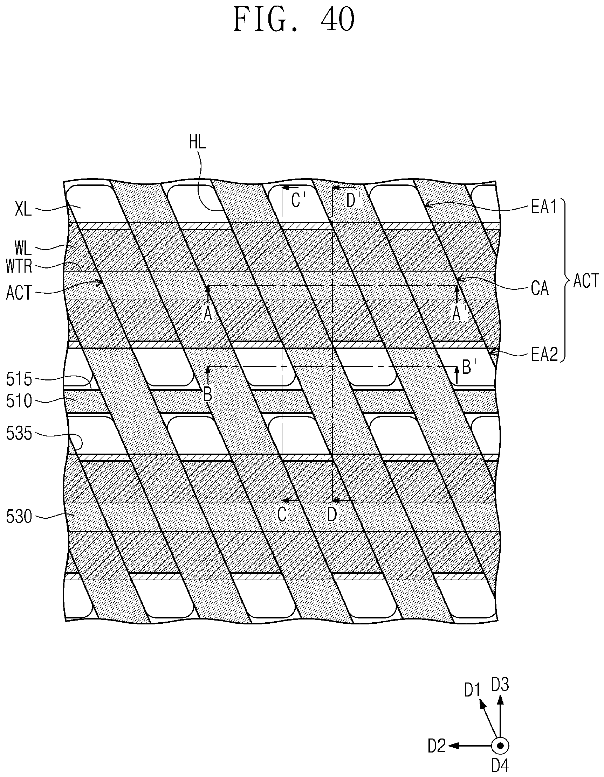

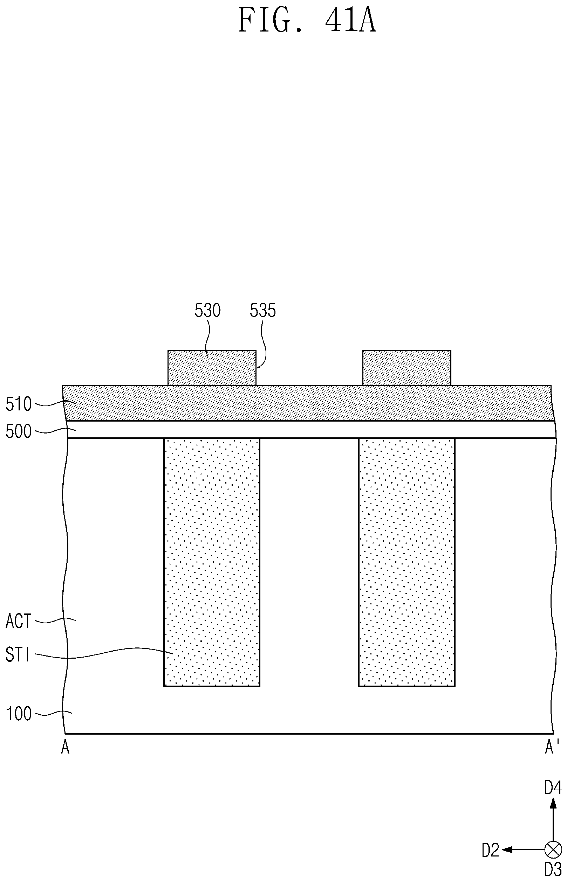

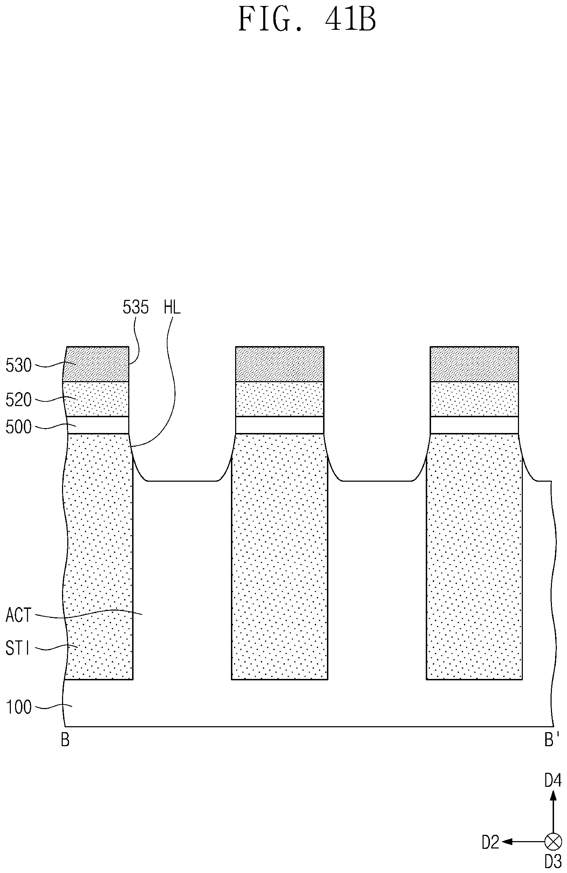

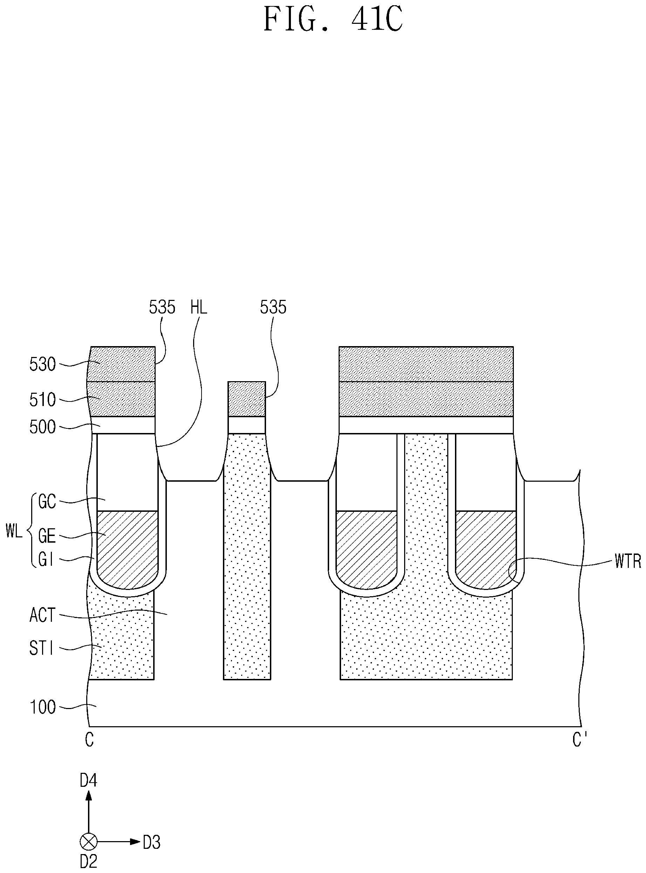

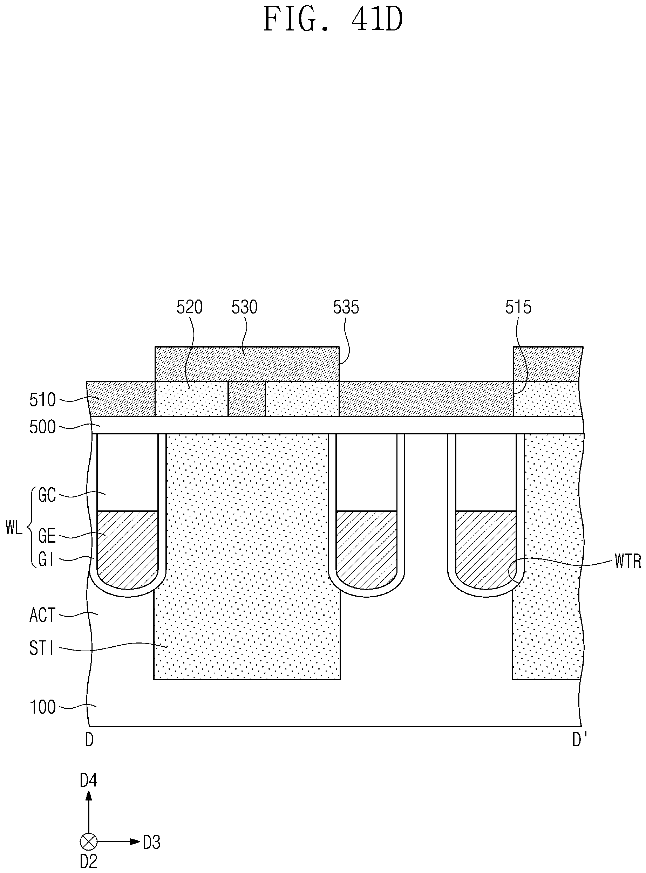

Referring to FIGS. 40 and 41A to 41D, the first and second mask patterns 510 and 530 may be used as an etching mask to perform an anisotropic etching process on the mask filling pattern 520. The etching process may remove a portion of the mask filling pattern 520 exposed by the second mask trench regions 535. The active patterns ACT may further be removed below the removed portion of the mask filling pattern 520. For example, the first and second edge parts EA1 and EA2 of the active patterns ACT may further be removed below the removed portion of the mask filling pattern 520. Thus, holes HL may be formed on the first and second edge parts EA1 and EA2 of the active patterns ACT. The holes HL may be formed spaced apart from each other in the first and second directions D1 and D2. The holes HL may expose the first and second edge parts EA1 and EA2 of the active patterns ACT. In some example embodiments, no removal may be performed on another portion of the mask filling pattern 520 below the second mask patterns 530.

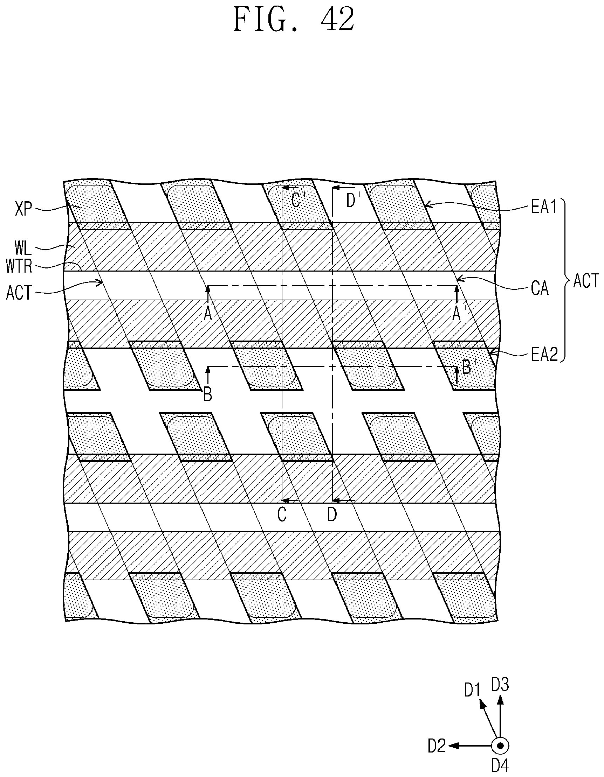

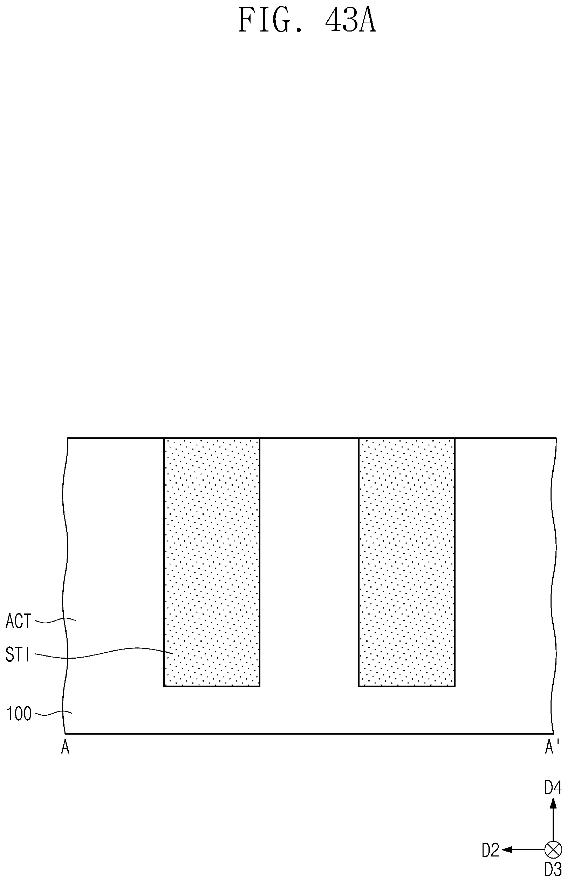

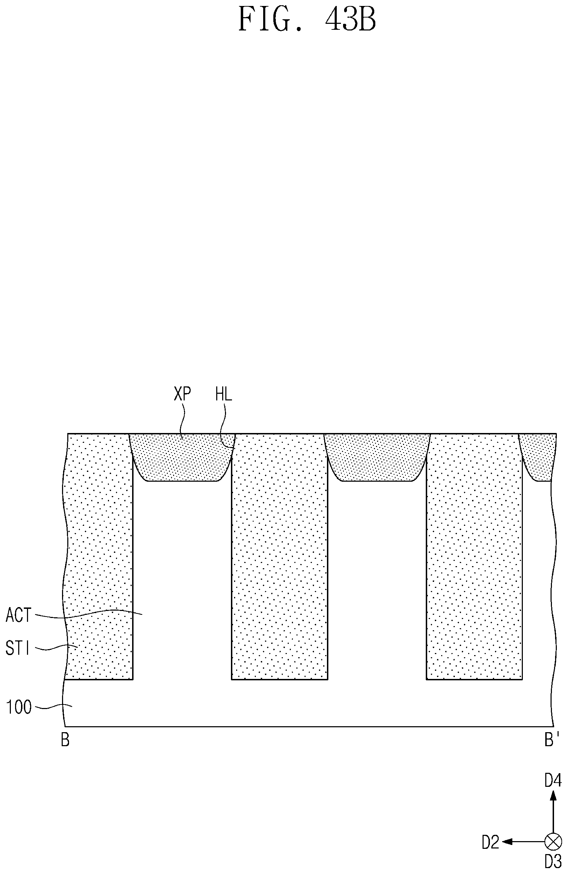

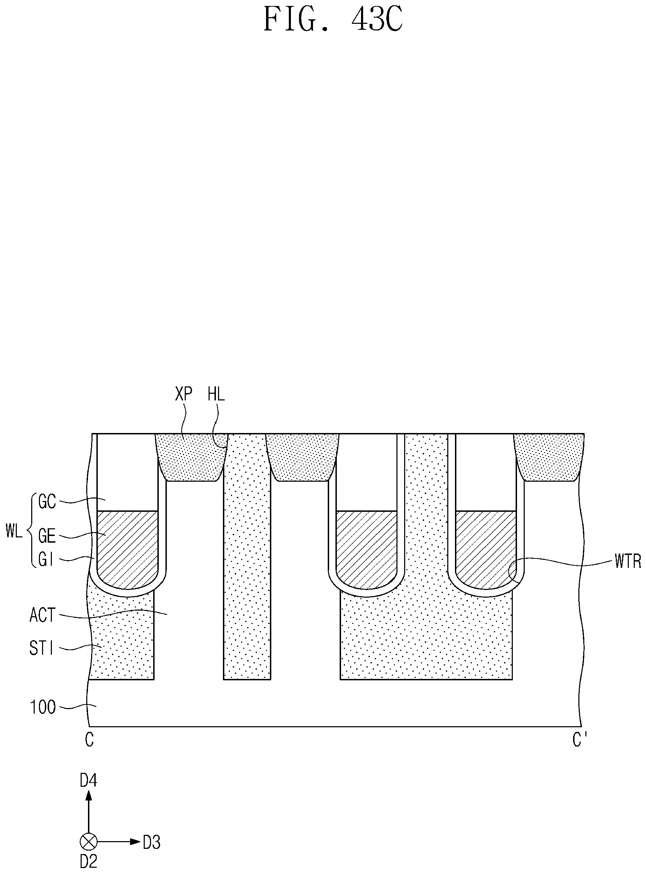

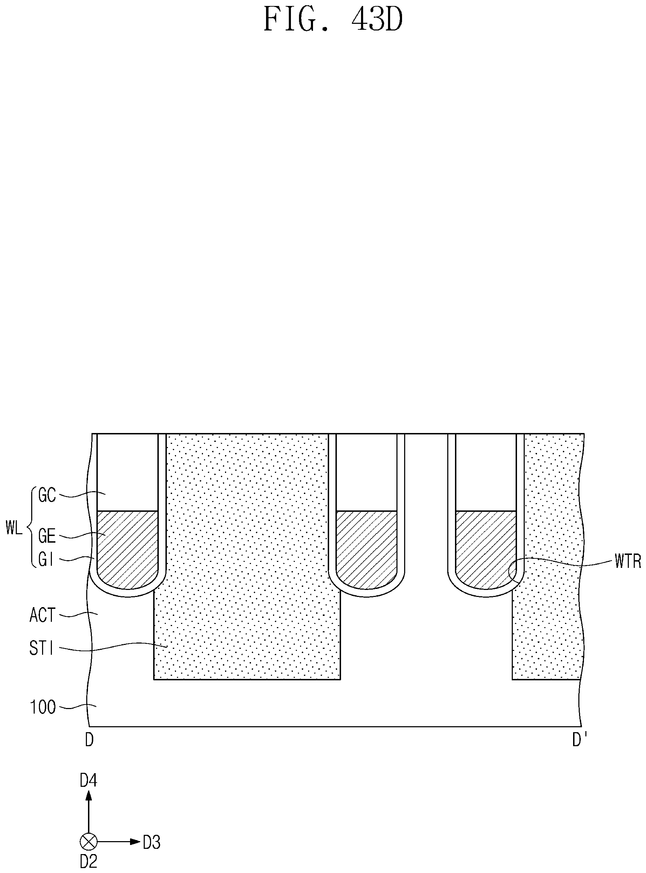

Referring to FIGS. 42 and 43A to 43D, storage node pads XP may be formed in the holes HL. The formation of the storage node pads XP may include forming on the entire surface of the substrate 100 a storage node pad layer (not shown) to fill the holes HL, and allowing an upper portion of the storage node pad layer to undergo a removal process to form a plurality of storage node pads XP that are separated from each other. For example, a polishing process may remove the upper portion of the storage node pad layer. The removal process may also remove the first and second mask patterns 510 and 530, a residue of the mask filling patterns 520, and the sacrificial layer 500. This, however, is an example, and a person skilled in the art should understand that various modified methods may be used to form the storage node pads XP in the holes HL.

The storage node pads XP may be formed of a single material. For example, the storage node pads XP may include silicon (e.g., impurity doped polysilicon). In this case, a semiconductor fabrication method discussed above may be used to fabricate a semiconductor device discussed with reference to FIGS. 7A to 7D.

In some example embodiments, the storage node pads XP each may be a composite layer including two or more materials. The storage node pads XP may include, for example, at least one of silicon (e.g., impurity doped polysilicon) and metallic materials (e.g., Ti, Mo, W, Cu, Al, Ta, Ru, or Ir). The formation of the storage node pads XP including two or more materials may include forming lower pads Xx in the holes HL, and then forming upper pads Xy and ohmic pads Xz on the lower pads Xx. The present inventive concepts, however, are not limited thereto. In this case, a semiconductor fabrication method discussed above may be used to fabricate a semiconductor device discussed with reference to FIGS. 8A and 8B.

According to some example embodiments of the present inventive concepts, a semiconductor device may have a simplified arrangement of components therein. Accordingly, it may be possible to reduce difficulty of patterning for forming the semiconductor device and thus to easily fabricate the semiconductor device. In addition, components may be relatively simply disposed to increase integration of the semiconductor device.

In addition, storage node pad may be used to improve a contact resistance between a storage node contact including a metallic material and an edge part of an active pattern including silicon. Moreover, an upper contact of a bit-line node contact may include a metallic material, and thus an over-etching of the bit-line node contact may be minimized. In conclusion, a semiconductor device may have improved electrical properties and increased reliability.

The aforementioned description provides some example embodiments for explaining the present inventive concepts. Therefore, the present inventive concepts are not limited to the example embodiments described above, and it will be understood by one of ordinary skill in the art that variations in form and detail may be made therein without departing from the essential features of the present inventive concepts.

## Claims

1. A semiconductor device, comprising:
a first active pattern (ACT1) and a second active pattern (ACT2) each extending along a first direction (D1), the first active pattern (ACT1) and the second active pattern (ACT2) arranged along a second direction (D2) intersecting the first direction (D1), each of the first and second active patterns (ACT1, ACT2) including a central part (CA), a first edge part (EA1), and a second edge part (EA2), the first and second edge parts (EA1, EA2) being spaced apart from each other across the central part (CA);
a storage node pad (XP) on the first edge part (EA1) of the first active pattern (ACT1); and
a bit-line node contact (DC) on the central part (CA) of the first active pattern (ACT 1),
wherein a top surface (Da) of the bit-line node contact (DC) is at a higher level than a top surface (Xa) of the storage node pad (XP).

2. The semiconductor device of claim 1, wherein a bottom surface of the bit-line node contact (DC) is at a same level or at a higher level than a bottom surface of the storage node pad (XP).

3. The semiconductor device of claim 1 or 2, wherein the storage node pad (XP) includes polysilicon.

4. The semiconductor device of any preceding claim, wherein the storage node pad (XP) includes a metallic material.

5. The semiconductor device of any preceding claim, wherein the bit-line node contact (DC) includes a metallic material.

6. The semiconductor device of any preceding claim, further comprising:
a bit-line node spacer (DS) covering a lateral surface of the bit-line node contact (DC).

7. The semiconductor device of claim 6, wherein
the bit-line node contact (DC) includes a lower contact (Dx) and an upper contact (Dy), the lower contact (Dx) and the upper contact (Dy) including different materials from each other, and
the bit-line node spacer (DS) covers a lateral surface of the upper contact (Dy) and extends onto a lateral surface of the lower contact (Dx).

8. The semiconductor device of claim 6, further comprising:
a trench buried pattern (TB) covering a lateral surface of the bit-line node spacer (DS).

9. The semiconductor device of claim 8, wherein
the bit-line node contact (DC) includes a lower contact (Dx) and an upper contact (Dy), the lower contact (Dx) and the upper contact (Dy) including different materials from each other,
the semiconductor device further comprises a buffer pattern (BP) on a lateral surface of the bit-line node spacer (DS) at the same level as an upper portion of the upper contact (Dy), and
the trench buried pattern (TB) is between the buffer pattern (BP) and the lower contact (Dx).

10. The semiconductor device of any one of claims 1 to 6, wherein
the bit-line node contact (DC) includes a lower contact (Dx) and an upper contact (Dy), the lower contact (Dx) and the upper contact (Dy) including different materials from each other, and
in a third direction (D3) intersecting the first and second directions (D1, D2), a width (W1) at a bottom surface of the lower contact (Dx) is greater than a width (W2) at a top surface of the lower contact (Dx).

11. The semiconductor device of any preceding claim, wherein
the storage node pad (XP) is a first storage node pad (XP1),
the semiconductor device further includes,
a second storage node pad (XP2) on the first edge part (EA1) of the second active pattern (ACT2),
a device isolation pattern (STI) surrounding the first and second active patterns (ACT1, ACT2), and
a pad dielectric pattern (PI2) on the device isolation pattern (STI),
the first storage node pad (XP1) and the second storage node pad (XP2) neighbor each other in the second direction (D2), and
the first storage node pad (XP1) and the second storage node pad (XP2) are spaced apart from each other with the pad dielectric pattern (PI2) interposed therebetween.

12. The semiconductor device of any preceding claim, wherein
the storage node pad (XP) is a first storage node pad (XP1),
the semiconductor device further includes,
a second storage node pad (XP2) on the first edge part (EA1) of the second active pattern (ACT2), and
a device isolation pattern (STI) surrounding the first and second active patterns (ACT1, ACT2),
the first storage node pad (XP1) and the second storage node pad (XP2) neighbor each other in the second direction (D2), and
the first storage node pad (XP1) and the second storage node pad (XP2) are spaced apart from each other with the device isolation pattern (STI) interposed therebetween.
